# EUROPEAN PATENT APPLICATION

(11) **EP 4 542 305 A1**
(43) Date of publication of application: **23.04.2025**
(21) Application number: 24206599.3
(22) Date of filing: 15.10.2024
(51) Int. Cl.: G03F 7/09, C08G 65/00

(54) **COMPOSITION FOR FORMING ORGANIC FILM, METHOD FOR FORMING ORGANIC FILM, PATTERNING PROCESS, AND POLYMER**

(30) Priority: 19.10.2023 JP 2023180610
(71) Applicant: SHIN-ETSU CHEMICAL CO., LTD., Tokyo 1000005 (JP)
(72) Inventor: KORI, Daisuke, Niigata (JP); YAMAMOTO, Yasuyuki, Niigata (JP)
(74) Representative: Sonnenhauser, Thomas Martin

(57) **Abstract**

The present invention is a composition for forming an organic film, containing: (A) a material for forming an organic film; (B) a polymer having a repeating unit represented by the following general formula (1); and (C) a solvent, where W₁ represents a saturated or unsaturated divalent organic group having 2 to 50 carbon atoms and having one or more fluorine-containing structures represented by the following formulae (2), and W₂ represents a saturated or unsaturated divalent organic group having 2 to 50 carbon atoms. This can provide: a composition for forming an organic film which is excellent in film-formability on a substrate and filling property, suppresses humps in an EBR process, and has an excellent process margin when used for an organic film for a multilayer resist process; a method for forming an organic film, using the composition; a patterning process; and a polymer to be contained in the composition for forming an organic film.

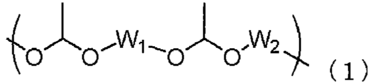

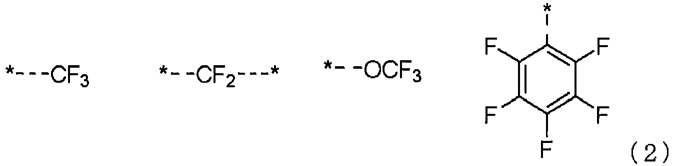

## Description

### TECHNICAL FIELD

The present invention relates to: a composition for forming an organic film with which it is possible to form an organic film for a multilayer resist for fine processing in manufacturing a semiconductor device etc. or an organic film for planarization in manufacturing a semiconductor device etc.; a method for forming an organic film by using the composition; and a patterning process using the composition.

### BACKGROUND ART

Recently, along with advancements toward higher integration and higher processing speed of semiconductor devices, a finer pattern rule has been required. In this situation, various techniques have been developed in regard to how patterning process can be performed more finely and precisely depending on light sources used in lithography with light exposure, which is a commonly-employed technique at present.

As the light source for lithography employed in resist pattern formation, light exposure using a g-line (436 nm) or an i-line (365 nm) of a mercury lamp is widely adopted for portions where the degree of integration is low. Meanwhile, for portions where the degree of integration is high and finer patterning is required, lithography using a KrF excimer laser (248 nm) or an ArF excimer laser (193 nm) with shorter wavelengths has also been practically used. Moreover, for the most-advanced generation requiring further finer patterning, lithography with extreme ultraviolet ray (EUV, 13.5 nm) is about to be put to practical use.

It is well known that in a monolayer resist method, which is employed as a typical resist patterning process, as the thinning of resist patterns progresses as described above, the ratio of a pattern height to a pattern line width (aspect ratio) is increased, and pattern collapse occurs due to the surface tension of a developer during development. It is known that, in this situation, a multilayer resist method, in which a pattern is formed by laminating films having different dry etching properties, is excellent in forming a pattern with a high aspect ratio on a stepped substrate. There have been developed: a two-layer resist method in which a photoresist layer (resist upper layer film) made of a silicon-containing photosensitive polymer is combined with a resist underlayer film made of an organic polymer containing carbon, hydrogen, and oxygen as main constituent elements, for example, a novolak polymer (Patent Document 1); and a three-layer resist method in which a photoresist layer made of an organic photosensitive polymer used in a monolayer resist method is combined with a resist middle layer film made of a silicon-based polymer or a silicon-based CVD film, and a resist underlayer film made of an organic polymer (Patent Document 2).

In the three-layer resist method, for example, an organic film made of a novolak or the like is formed uniformly as a resist underlayer film on a substrate to be processed; a silicon-containing resist middle layer film is formed thereon as a resist middle layer film; and an ordinary organic photoresist film is formed thereon as a resist upper layer film. In dry etching using a fluorine-based gas plasma, an organic resist upper layer film has favorable etching selectivity to a silicon-containing resist middle layer film, and therefore, a resist pattern is transferred to the silicon-containing resist middle layer film by dry etching using a fluorine-based gas plasma. According to this method, the pattern can be transferred to the silicon-containing resist middle layer film even when using a resist composition that causes difficulties in forming a pattern having a sufficient film thickness for directly processing the substrate to be processed or when using a resist composition that does not have sufficient dry etching resistance for processing the substrate. In addition, by subsequently transferring the pattern by dry etching with an oxygen-based gas plasma, it is possible to obtain a pattern in a novolak film (resist underlayer film) having sufficient dry etching resistance for processing.

Many techniques are already known (e.g. Patent Document 3) regarding organic films (organic underlayer films) like the organic film described above. However, in association with recent progress in miniaturization, the need for excellent filling property in addition to dry etching property is rising. There is a demand for an organic film material that enables uniform film formation even on an underlying substrate to be processed having a complex form or any material, and that has a filling property that allows a required pattern to be filled without gaps.

When a semiconductor substrate or the like is manufactured, the above-described organic film is formed using a coater/developer that can perform treatments such as spin-coating process, EBR (Edge Bead Removal) process, and baking process. An EBR process is a process of removing, after forming a film on a substrate (wafer) by spin-coating, the film on the edge of the substrate with a remover for the purpose of preventing the contamination of a substrate-conveying arm of the coater/developer. A mixed solution of propylene glycol monomethyl ether acetate and propylene glycol monomethyl ether (30 mass%:70 mass%) is one of removers used in EBR processes, and is widely used in EBR processes of resist upper layer films and resist underlayer films (silicon-containing resist middle layer films and organic films).

Due to the effect of a remover in an EBR process, a state where a peripheral portion of an organic film has a thick film thickness (a hump) occurs in some cases. In the above-described dry etching step at the time of substrate processing, a hump causes defects, and therefore, an organic film in which a hump is suppressed is desired.

Furthermore, after forming the spin-coating film, the organic film is baked to form a cured film in order to use in a multilayer resist process. This is because it is necessary to achieve an insoluble and infusible organic film for applying a silicon-containing resist middle layer film thereon. On the surface of an organic film formed by baking, a hydrophobic surface caused by a surfactant contained in the composition for forming an organic film is formed, and induces coating abnormality of the silicon-containing resist middle layer film in some cases. To improve the coating property of the silicon-containing resist middle layer film and widen the process margin, the contact angle of the surface of the organic film is required to be controlled.

### CITATION LIST

### PATENT LITERATURE

Patent Document 1: JP H6-118651 A
Patent Document 2: JP 4355943 B2
Patent Document 3: JP 2004-205685 A

### SUMMARY OF INVENTION

### TECHNICAL PROBLEM

The present invention has been made in view of the above-described circumstances. An object of the present invention is to provide: a composition for forming an organic film which is excellent in film-formability (in-plane uniformity) on a substrate (wafer) and filling property, suppresses humps in an EBR process, and has an excellent process margin when used for an organic film for a multilayer resist process; a method for forming an organic film, using the composition; a patterning process; and a polymer to be contained in the composition for forming an organic film.

### SOLUTION TO PROBLEM

To achieve the object, the present invention provides a composition for forming an organic film, comprising: (A) a material for forming an organic film; (B) a polymer having a repeating unit represented by the following general formula (1); and (C) a solvent, 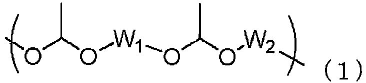 wherein W₁ represents a saturated or unsaturated divalent organic group having 2 to 50 carbon atoms, the divalent organic group containing one or more structures containing fluorine represented by the following formulae (2), and W₂ represents a saturated or unsaturated divalent organic group having 2 to 50 carbon atoms, 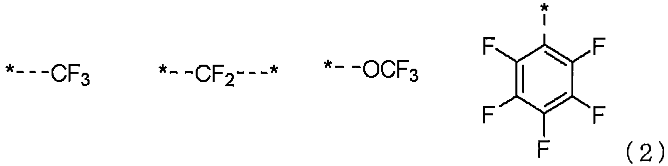 wherein "*" represents an attachment point in the organic group represented by the W₁, and the W₁ optionally contains two or more of the structures represented by the formulae (2) or two or more of one of the structures.

Such a composition for forming an organic film makes it possible to form an organic film which is excellent in in-plane uniformity and filling property and in which the formation of humps due to the effect of a remover in an EBR process is suppressed. In addition, since an acetal structure is contained in the repeating unit, when an organic film is formed and used, hydrophobic components unevenly distributed on the organic film surface are removed by thermal decomposition by the baking at the time of cured-film formation, and therefore, the composition for forming an organic film has excellent coatability with a silicon-containing middle layer film.

In the present invention, the W₁ in the general formula (1) is preferably a divalent organic group represented by the following general formula (3), 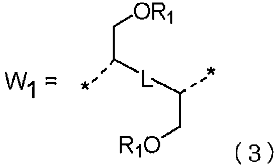 wherein "*" represents an attachment point to the oxygen atom; L represents a saturated or unsaturated divalent organic group having 1 to 30 carbon atoms; and R₁ represents a substituent having one or more of the structures represented by the formulae (2).

A composition for forming an organic film containing such a polymer can be provided with improved film-formability at the time of application since the composition has an appropriate fluorine content, and moreover, the thermal decomposition temperature of the polymer can be controlled to be in an appropriate range, and decomposition products can be removed from the film and does not become a residue on the cured film surface or in the film after baking the organic film.

Furthermore, in the present invention, it is more preferable that the R₁ in the general formula (3) is a group represented by one of the following general formulae (4), 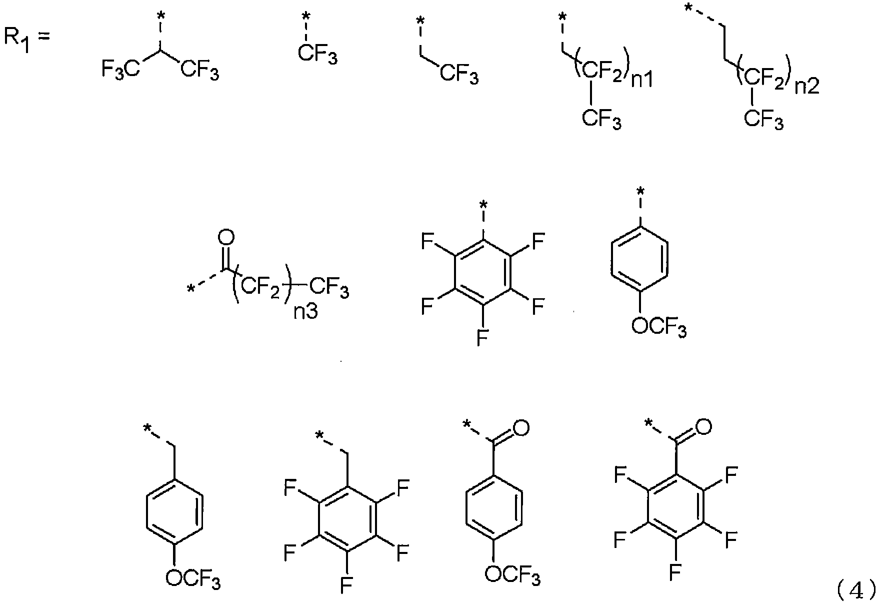 wherein "*" represents an attachment point to the oxygen atom; and "n1", "n2", and "n3" each represent an integer of 1 to 10.

A composition for forming an organic film containing such a polymer can have improved film-formability on application by having an appropriate fluorine content.

Furthermore, the W₂ in the general formula (1) can be represented by one of the following general formulae (5), 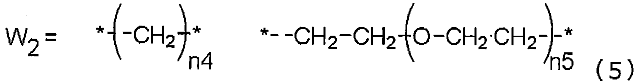 wherein "*" represents an attachment point to the oxygen atom; and "n4" and "n5" each represent an integer of 1 to 10.

In a composition for forming an organic film containing such a polymer, there is no risk of decomposition products generated at the time of baking degrading the in-plane uniformity of the film, and there is also no risk of insoluble matter being formed by a reaction between decomposition products and so forth. Therefore, there are no risks of process margin being narrowed when an organic film is formed or of equipment contamination or inconvenience etc. arising.

Furthermore, the polymer (B) preferably has a weight-average molecular weight of 1000 to 30000.

When the weight-average molecular weight is in such a range, it is possible to form an organic film excellent in film-formability and filling property.

Furthermore, the polymer (B) is preferably contained in an amount of 0.01 parts by mass to 5 parts by mass based on 100 parts by mass of the material (A) for forming an organic film contained.

A composition for forming an organic film containing the polymer in such an amount is preferable, since the in-plane uniformity of a formed organic film is better.

In addition, the present invention provides a method for forming an organic film to be used in a manufacturing process of a semiconductor device, the method comprising: spin-coating a substrate to be processed with the above-described composition for forming an organic film to form a coating film; and forming an organic film by heating the coating film at a temperature of 100°C or higher and 600°C or lower for 10 to 600 seconds to cure the coating film.

The inventive composition for forming an organic film is particularly useful for filling a pattern having a complicated shape on a substrate to be processed by spin-coating, forming an organic film having excellent in-plane uniformity, and removing the organic film on the edge while suppressing humps in an EBR process.

The present invention also provides a patterning process comprising:
forming an organic film on a body to be processed by using the above-described composition for forming an organic film;
forming a silicon-containing resist middle layer film on the organic film by using a silicon-containing resist middle layer film material;
forming a resist upper layer film on the silicon-containing resist middle layer film by using a resist upper layer film material comprising a photoresist composition;
forming a circuit pattern in the resist upper layer film;
transferring the pattern to the silicon-containing resist middle layer film by etching while using the resist upper layer film having the formed circuit pattern as a mask;
transferring the pattern to the organic film by etching while using the silicon-containing resist middle layer film having the transferred pattern as a mask; and
further transferring the pattern to the body to be processed by etching while using the organic film having the transferred pattern as a mask.

The present invention also provides a patterning process comprising:
forming an organic film on a body to be processed by using the above-described composition for forming an organic film;
forming a silicon-containing resist middle layer film on the organic film by using a silicon-containing resist middle layer film material;
forming an organic antireflective film or an adhesive film on the silicon-containing resist middle layer film;
forming a resist upper layer film on the organic antireflective film or the adhesive film by using a resist upper layer film material comprising a photoresist composition;
forming a circuit pattern in the resist upper layer film;
transferring the pattern to the organic antireflective film or the adhesive film and the silicon-containing resist middle layer film by etching while using the resist upper layer film having the formed circuit pattern as a mask;
transferring the pattern to the organic film by etching while using the silicon-containing resist middle layer film having the transferred pattern as a mask; and
further transferring the pattern to the body to be processed by etching while using the organic film having the transferred pattern as a mask.

The present invention also provides a patterning process comprising:
forming an organic film on a body to be processed by using the above-described composition for forming an organic film;
forming an inorganic hard mask selected from a silicon oxide film, a silicon nitride film, and a silicon oxynitride film on the organic film;
forming a resist upper layer film on the inorganic hard mask by using a resist upper layer film material comprising a photoresist composition;
forming a circuit pattern in the resist upper layer film;
transferring the pattern to the inorganic hard mask by etching while using the resist upper layer film having the formed circuit pattern as a mask;
transferring the pattern to the organic film by etching while using the inorganic hard mask having the transferred pattern as a mask; and
further transferring the pattern to the body to be processed by etching while using the organic film having the transferred pattern as a mask.

The present invention also provides a patterning process comprising:
forming an organic film on a body to be processed by using the above-described composition for forming an organic film;
forming an inorganic hard mask selected from a silicon oxide film, a silicon nitride film, and a silicon oxynitride film on the organic film;
forming an organic antireflective film or an adhesive film on the inorganic hard mask;
forming a resist upper layer film on the organic antireflective film or the adhesive film by using a resist upper layer film material comprising a photoresist composition;
forming a circuit pattern in the resist upper layer film;
transferring the pattern to the organic antireflective film or the adhesive film and the inorganic hard mask by etching while using the resist upper layer film having the formed circuit pattern as a mask;
transferring the pattern to the organic film by etching while using the inorganic hard mask having the transferred pattern as a mask; and
further transferring the pattern to the body to be processed by etching while using the organic film having the transferred pattern as a mask.

As described, the inventive composition for forming an organic film can be used suitably in various patterning processes such as a three-layer resist process using a silicon-containing resist middle layer film or an inorganic hard mask and a four-layer resist process additionally using an organic antireflective film or an adhesive film. According to such patterning processes of the present invention, it is possible to transfer and form a circuit pattern of a resist upper layer film in a body to be processed with high accuracy.

Furthermore, the inorganic hard mask is preferably formed by a CVD method or an ALD method.

In the inventive patterning process, the inorganic hard mask can be formed by such methods, for example.

Furthermore, the circuit pattern is preferably formed by a lithography using light having a wavelength of 10 nm or more and 300 nm or less, a direct writing with electron beam, nanoimprinting, or a combination thereof.

Furthermore, the circuit pattern is preferably developed with an alkaline development or an organic solvent.

In the inventive patterning process, such means of forming and developing the circuit pattern can be used suitably.

Furthermore, the body to be processed is preferably a semiconductor device substrate or the semiconductor device substrate coated with any of a metal film, a metal carbide film, a metal oxide film, a metal nitride film, a metal oxycarbide film, and a metal oxynitride film.

In this case, the metal constituting the body to be processed is preferably silicon, titanium, tungsten, hafnium, zirconium, chromium, germanium, copper, silver, gold, aluminum, indium, gallium, arsenic, palladium, iron, tantalum, iridium, molybdenum, or an alloy thereof.

According to the inventive patterning process, such a body to be processed can be processed to form a pattern.

Furthermore, the present invention provides a polymer having a repeating unit represented by the following general formula (1), 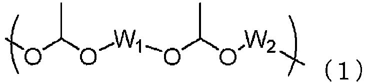 wherein W₁ represents a saturated or unsaturated divalent organic group having 2 to 50 carbon atoms, the divalent organic group containing one or more structures containing fluorine represented by the following formulae (2); and W₂ represents a saturated or unsaturated divalent organic group having 2 to 50 carbon atoms, 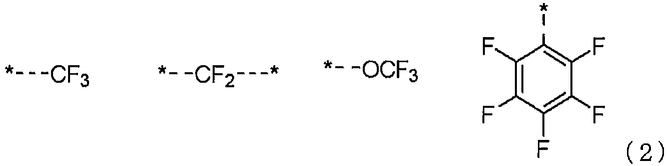 wherein "*" represents an attachment point in the organic group represented by the W₁, and the W₁ optionally contains two or more of the structures represented by the formulae (2) or two or more of one of the structures.

Such a polymer has a combination of particular fluorine substituents, and therefore, is suitable for forming an organic film which is excellent in in-plane uniformity and filling property and in which the formation of humps due to the effect of a remover in an EBR process is suppressed. Furthermore, since the polymer has an acetal structure in the repeating unit, when the inventive polymer is contained in a composition for forming an organic film and used for forming an organic film, hydrophobic components unevenly distributed on the organic film surface are removed by thermal decomposition by the baking at the time of cured-film formation, and therefore, it is possible to form an organic film having excellent coatability with a silicon-containing middle layer film and having a favorable surface.

In this case, the W₁ in the general formula (1) is preferably a divalent organic group represented by the following formula (3), 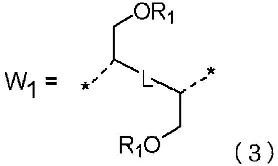 wherein "*" represents an attachment point to the oxygen atom; L represents a saturated or unsaturated divalent organic group having 1 to 30 carbon atoms; and R₁ represents a substituent having one or more of the structures represented by the formulae (2).

The repeating unit of such a polymer has a structure in which a secondary alcohol has been acetalized, and therefore, the thermal decomposition temperature of the polymer can be in the range of the baking temperature for curing the film to form an organic film, and the repeating unit can be decomposed completely. Therefore, when an organic film is formed using the composition for forming an organic film, there is no risk of a decomposed product remaining as a residue on the surface of the cured film and also inside the film after the baking.

In this case, the R₁ in the general formula (3) is preferably a group represented by one of the following general formulae (4), 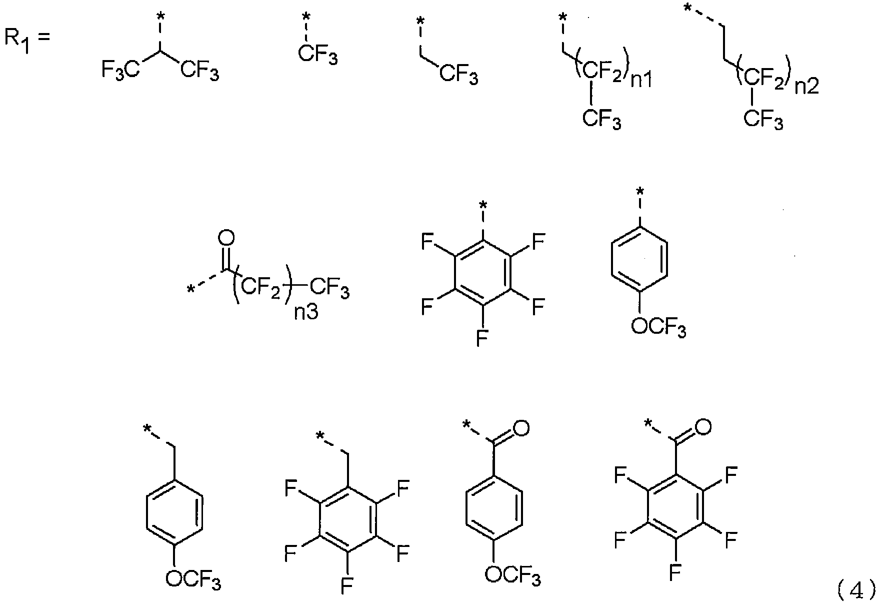 wherein "*" represents an attachment point to the oxygen atom; and "n1", "n2", and "n3" each represent an integer of 1 to 10.

When a structure having an appropriate fluorine substituent as described above is introduced to the polymer, it is possible to improve the film-formability when the composition for forming an organic film is applied.

The W₂ in the general formula (1) is preferably represented by one of the following formulae (5), 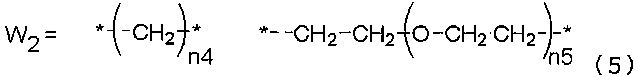 wherein "*" represents an attachment point to the oxygen atom; and "n4" and "n5" each represent an integer of 1 to 10.

When such a partial structure is introduced, there are no risks of generated decomposition products degrading the in-plane uniformity of the film or of insoluble matter being formed due to a reaction between decomposition products etc.

The polymer preferably has a weight-average molecular weight of 1000 to 30000.

When the weight-average molecular weight is in such a range, it is possible to form an organic film excellent in film-formability and filling property. The weight-average molecular weight can be obtained by the method described later.

### ADVANTAGEOUS EFFECTS OF INVENTION

As described above, according to the present invention, it is possible to provide a composition for forming an organic film having excellent film-formability (in-plane uniformity) on a substrate (wafer) and filling property, having excellent film-formability on an organic film when an organic film is formed from the composition, and suppressing humps at the time of an EBR process. The inventive composition for forming an organic film has excellent film-formability, an excellent filling property, and an excellent property of suppressing humps that are generated during an EBR process, and therefore, is extremely useful as: an organic film material used in multilayer resist processes, such as a two-layer resist process, a three-layer resist process using a silicon-containing resist middle layer film or an inorganic hard mask, or a four-layer resist process using a silicon-containing resist middle layer film or inorganic hard mask and an organic antireflective film or adhesive film; or a material for forming an organic film for manufacturing a semiconductor device. Moreover, according to the inventive method for forming an organic film, it is possible to form an organic film in which humps are suppressed, and therefore, a semiconductor device and so forth can be manufactured efficiently. In addition, the inventive polymer has a thermally decomposable acetal structure and also has a particular fluorine substituent, and therefore, exhibits the above-described properties, so that the polymer is useful for a composition for forming an organic film.

### BRIEF DESCRIPTION OF DRAWINGS

FIG. 1 is an example of a graph on measuring the height of a hump by using a stylus profiler in the case of a composition for forming an organic film where humps have been suppressed.
FIG. 2 is an example of a graph on measuring the height of a hump by using a stylus profiler in the case of a composition for forming an organic film where humps have not been suppressed.
FIG. 3 is an explanatory diagram of an example of the inventive patterning process according to a three-layer resist process.
FIG. 4 is an explanatory diagram of a filling property evaluation method in the Examples.

### DESCRIPTION OF EMBODIMENTS

As described above, there has been required the development of a composition for forming an organic film having excellent film-formability (in-plane uniformity) on a substrate (wafer) and filling property and in which humps are suppressed during an EBR process.

Usually, when an organic film is to be formed, a resin for forming an organic film and additives are dissolved in an organic solvent to form a composition, the composition is applied with a coater/developer onto a substrate on which a structure, a circuit, etc. is formed, the composition is spread by the substrate rotating, the composition on the edge is removed in an EBR process, and then the composition is baked to form an organic film.

It is thought that if the flowability of the composition is insufficient, gaps are generated when a hole or trench having a very high aspect ratio is filled, and in addition, a hump is generated in the periphery of the organic film if the resin for forming an organic film or the additives have poor solubility in the remover used in the EBR process.

The present inventors have studied earnestly further and found out that when a thermally decomposable polymer having a particular repeating unit is contained in a composition for forming an organic film, the composition has excellent film-formability and high filling property and allows excellent hump suppression during an EBR process. Thus, the present invention has been completed.

That is, the present invention is a composition for forming an organic film, comprising: (A) a material for forming an organic film; (B) a polymer having a repeating unit represented by the following general formula (1); and (C) a solvent, 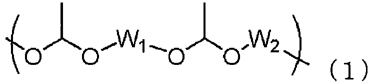 wherein W₁ represents a saturated or unsaturated divalent organic group having 2 to 50 carbon atoms, the divalent organic group containing one or more structures containing fluorine represented by the following formulae (2), and W₂ represents a saturated or unsaturated divalent organic group having 2 to 50 carbon atoms, 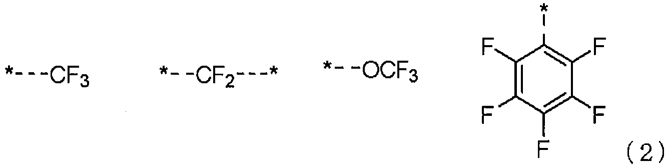 wherein "*" represents an attachment point in the organic group represented by the W₁, and the W₁ optionally contains two or more of the structures represented by the formulae (2) or two or more of one of the structures.

Hereinafter, the present invention will be described in detail, but the present invention is not limited thereto.

### [Composition for Forming Organic Film]

The inventive composition for forming an organic film contains: (A) a material for forming an organic film; (B) a polymer having a repeating unit represented by the following general formula (1); and (C) a solvent.

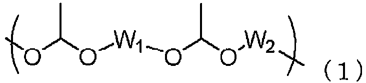

In the formula, W₁ represents a saturated or unsaturated divalent organic group having 2 to 50 carbon atoms, the divalent organic group containing one or more structures containing fluorine represented by the following formulae (2), and W₂ represents a saturated or unsaturated divalent organic group having 2 to 50 carbon atoms.

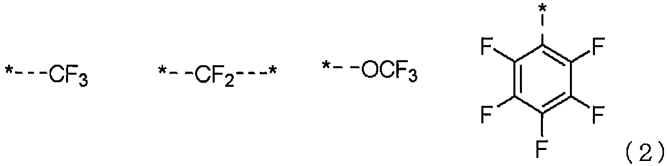

In the formulae, "*" represents a point at which the fluorine-containing structure is bonded in the divalent organic group W₁ (an attachment point in the organic group represented by the W₁), and the W₁ optionally contains two or more of the same or different structures selected from the group of structures represented by the formulae (2).

Note that in the inventive composition for forming an organic film, the polymer (B), the material (A) for forming an organic film, and the solvent (C) may each be of one kind or a combination of two or more kinds.

In the following, out of the constitutional components of the above-described composition for forming an organic film, the polymer, which is a characteristic feature of the present invention, will be described first, and then the material for forming an organic film, the solvent, and other components will be described.

### [Polymer]

The polymer (B) of the present invention has a repeating unit represented by the general formula (1). This polymer is useful for forming an organic film.

The inventive polymer (polymer for forming an organic film) is a polymer containing an acetal structure in the repeating unit. An acetal structure incorporated in a polymer is decomposed by heat etc. If a decomposed product generated on this occasion remains in the film or on the film surface, the decomposed product affects etching resistance, the coating property of a silicon-containing middle layer film formed on the organic film, etc. when the film is used as an organic film. Accordingly, the W₁ and W₂, which are the main structures of the repeating unit of the inventive polymer, have been designed appropriately to design a polymer that has an appropriate structure and decomposition temperature and does not remain on the film surface or in the film because of thermal decomposition. In addition, by introducing an appropriate substituent or linking group containing fluorine to the main skeleton of the polymer, it has become possible to provide a function as a surfactant that has an ability to reduce surface tension and brings about excellent uniform coatability (leveling property) of an organic film. Therefore, when the inventive polymer is used as a surfactant, the polymer can be used not only for organic films but for coating materials for photolithography in general. Specific examples include photosensitive resist materials, materials for forming a top coat to be formed on a resist film, etc. As described, the inventive polymer has a characteristic that it is thermally decomposable, and can function as a surfactant.

The W₁ in the general formula (1) is preferably represented by the following general formula (3).

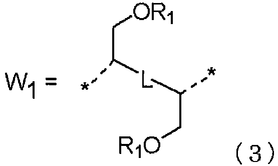

In the formula, "*" represents an attachment point to the oxygen atom; L represents a saturated or unsaturated divalent organic group having 1 to 30 carbon atoms; and R₁ represents a substituent having one or more of the structures represented by the formulae (2).

By introducing the above-described W₁ to the main chain structure, an acetal structure derived from a secondary alcohol is achieved, and thus, the polymer can be designed to have an appropriate thermal decomposition temperature. Therefore, when the composition for forming an organic film is cured by heat treatment after film formation for use as an organic film, the polymer is thermally decomposed and does not remain in the film (in the system).

The L represents a linking group and is not particularly limited as long as it is a saturated or unsaturated divalent organic group having 1 to 30 carbon atoms, and examples include linear, branched, or cyclic alkylene groups having 1 to 30 carbon atoms, linear, branched, or cyclic alkylidene groups having 2 to 30 carbon atoms, cycloalkylene groups having 5 to 15 carbon atoms, cycloalkylidene groups having 5 to 15 carbon atoms, arylene groups having 6 to 30 carbon atoms, arylalkylene groups having 7 to 15 carbon atoms, arylalkylidene groups having 7 to 15 carbon atoms, fluorenediyl groups, etc. These groups may be combined in the range of 1 to 30 carbon atoms. The L may also have in its structure a halogen atom such as fluorine and chlorine, an ether bond, a carbonyl group, an ester group, an amide group, or an amino group, and may also form a heterocyclic structure via an amide group, an ester group, etc.

Furthermore, in view of the availability of raw materials, ease in synthesis, etc. the ends of the linking group L can be, for example, methylene groups rather than oxygen atoms (ether bonds), and examples of the L include linear alkylene groups represented by (CH₂)ₐ, glyme chains represented by CH₂(OCH₂CH₂)_{b}(OCH₂), whose ends are methylene groups, and divalent groups represented by CH₂(CF₂)_{c}CH₂, whose ends are methylene groups and in which the moiety in between is a linear perfluoroalkylene group (here, "a" represents an integer of 1 to 12, "b" represents an integer of 1 to 5, and "c" represents an integer of 1 to 10).

More specific examples include an ethylene group, a propylene group, a butylene group, a trimethylene group, a tetramethylene group, a pentamethylene group, a hexamethylene group, a heptamethylene group, an octamethylene group, a decamethylene group, a dodecamethylene group, an eicosamethylene group, a triacontamethylene group, a cyclopentanediyl group, a cyclohexanediyl group, a dimethylcyclohexanediyl group, a 2-butene-1,4-diyl group, a 2,4-hexadiene-1,6-diyl group, a 3-oxapentane-1,5-diyl group, a 3,6-dioxaoctane-1,8-diyl group, a 3,6,9-trioxaundecane-1,11-diyl group, a phenylene group, a xylyl group, a naphthalenediyl group, a dimethylnaphthalenediyl group, an adamantanediyl group, etc.

One of these groups may constitute the L, or multiple kinds may constitute the L in mixture.

Examples of the above-described W₁ include the following. R₁ represents a substituent having one or more of the structures represented by the formulae (2), and "*" represents an attachment point to the oxygen atom.

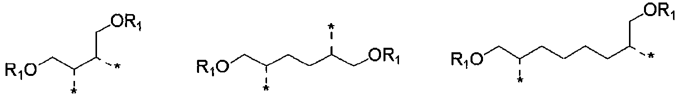

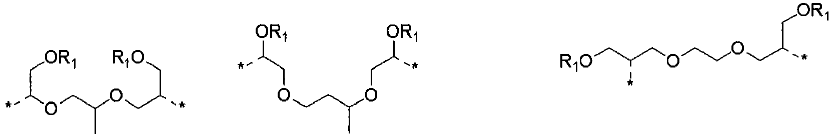

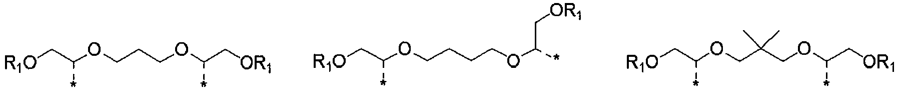

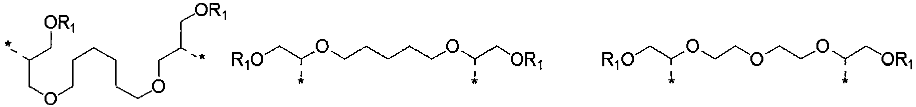

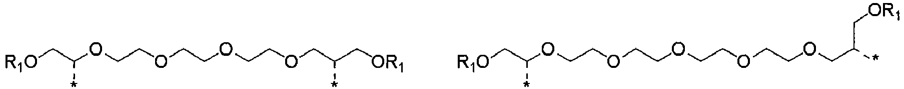

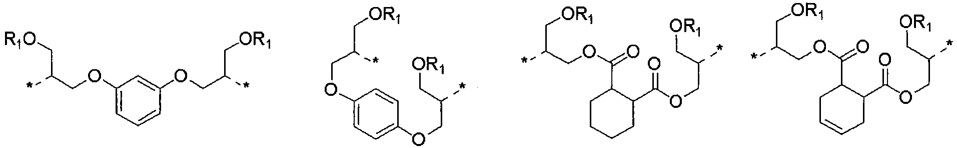

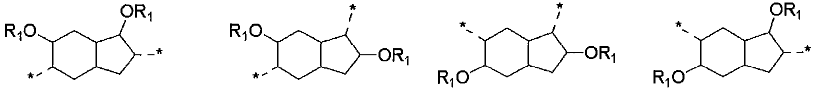

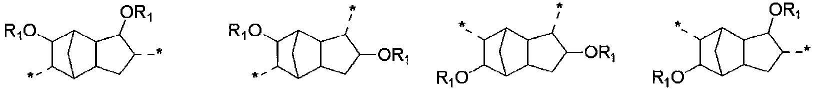

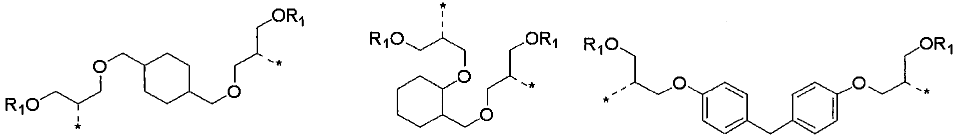

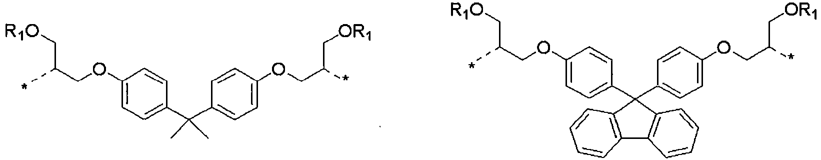

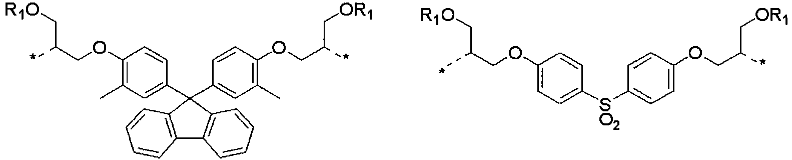

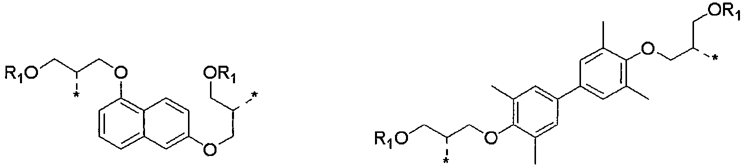

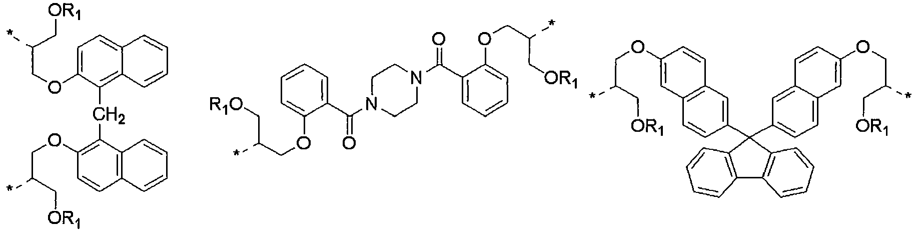

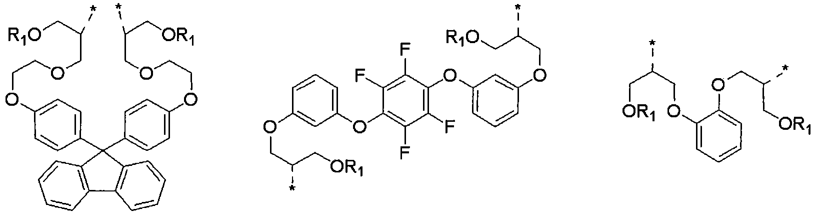

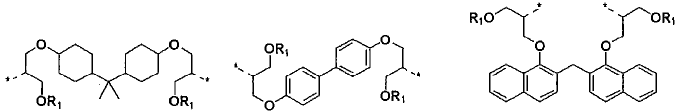

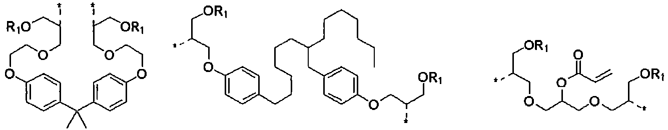

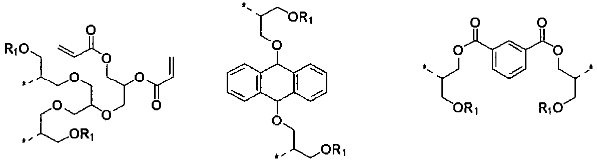

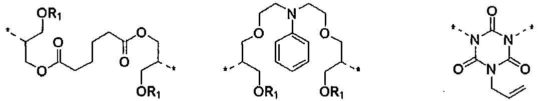

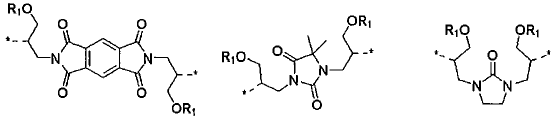

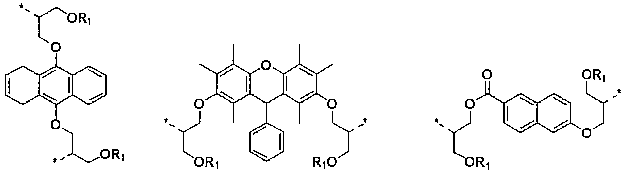

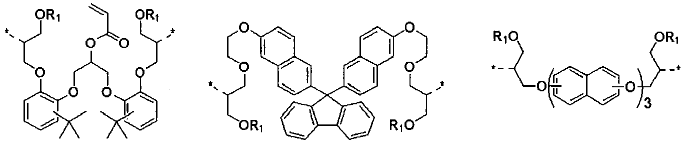

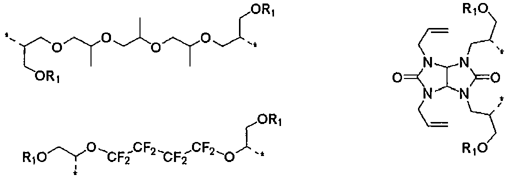

Out of the above, from the viewpoint of improving thermal decomposability, the structures containing no aromatic rings are preferable, and from the viewpoint of surface activating property, the structures having no nitrogen are preferable. As examples satisfying these conditions, the structures linked by a glyme chain and structures having a linear alkylene group as a linking group shown below are preferable.

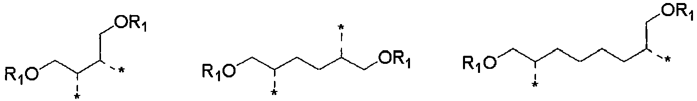

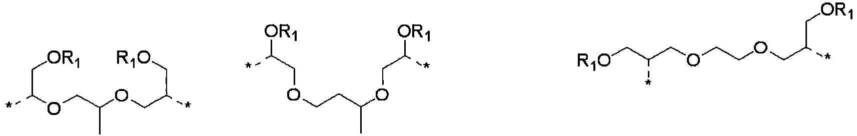

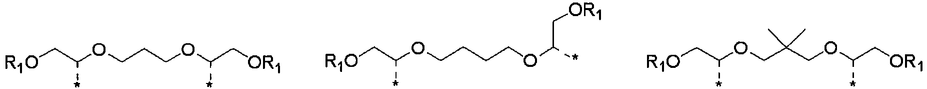

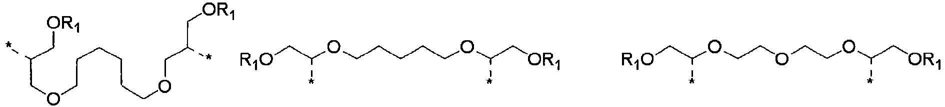

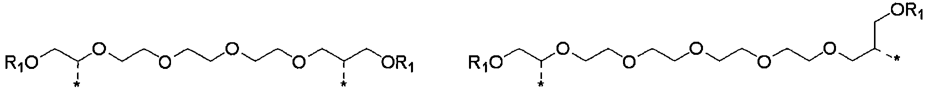

In the formulae, "*" represents an attachment point to the oxygen atom.

The R₁ in the general formula (3) represents a substituent having one or more of the structures represented by the formulae (2), and specific examples include the following. In the formulae, "n1", "n2", and "n3" each represent an integer of 1 to 10. "n6" to "n9" each represent an integer of 1 to 10. "*" represents an attachment point.

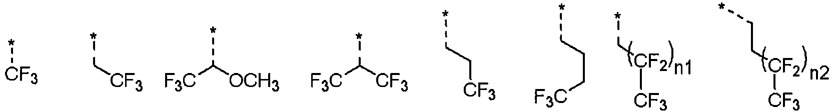

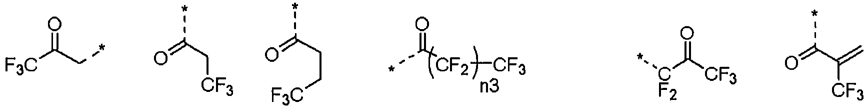

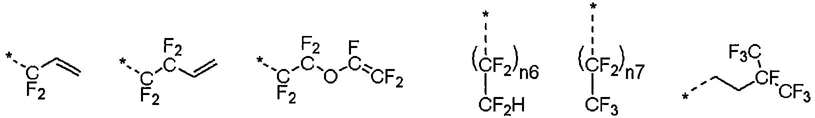

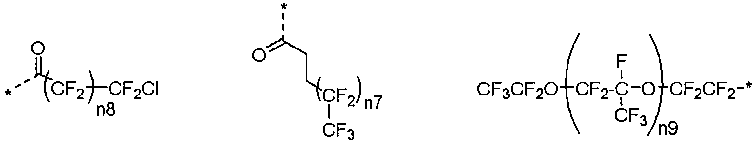

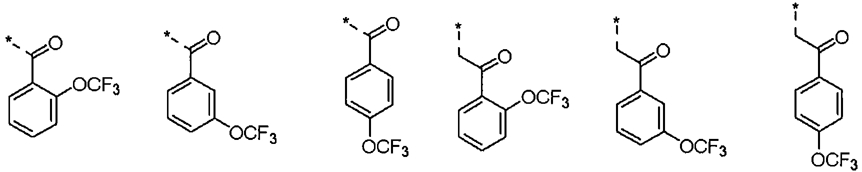

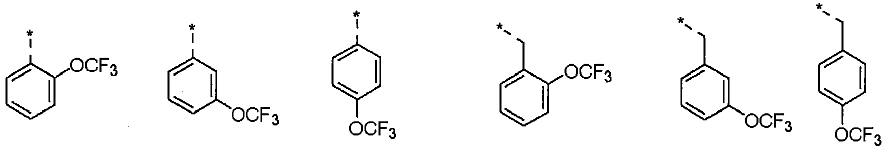

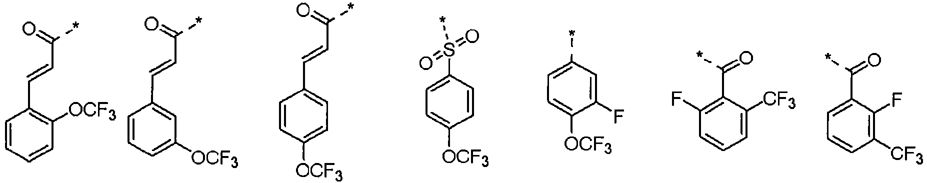

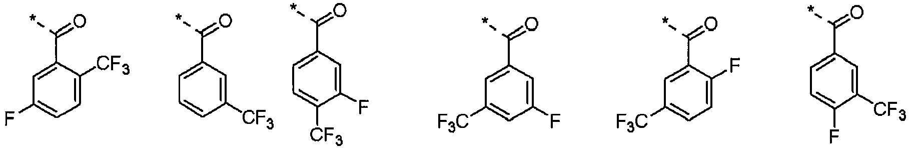

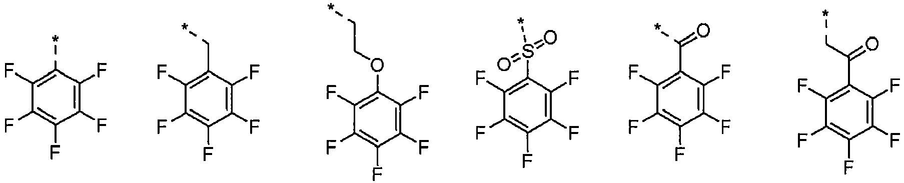

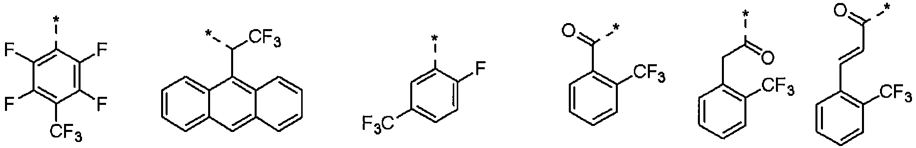

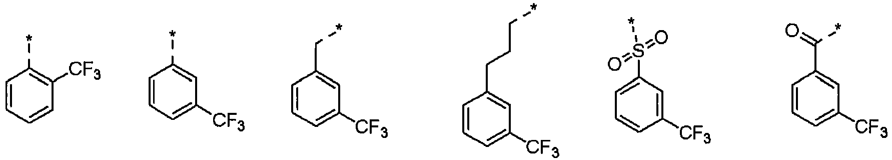

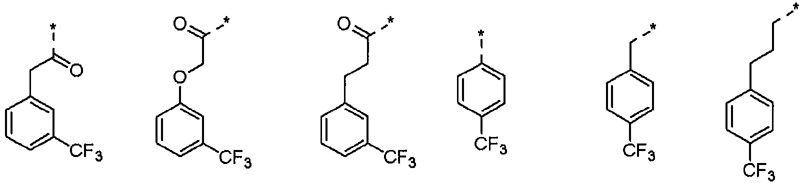

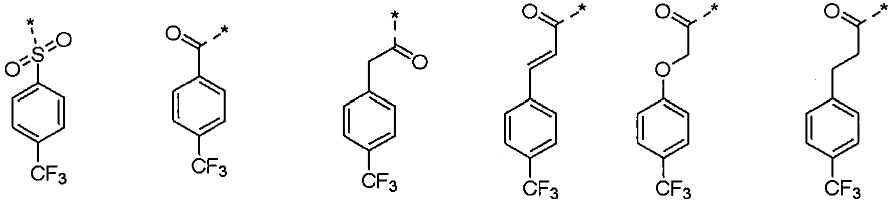

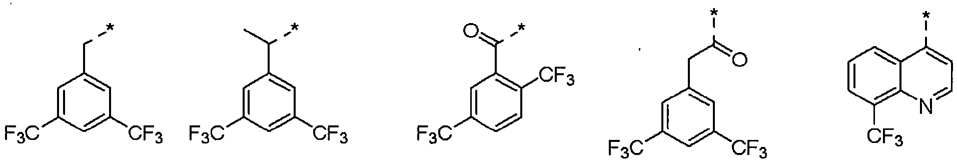

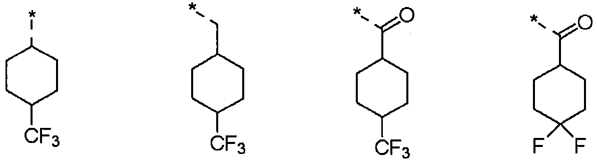

In particular, the following are preferable from the viewpoint of surface activating property. When such a group is contained, improvement of film-formability can be expected by the introduction of an appropriate fluorine structure with an appropriate fluorine content. "n1", "n2", and "n3" are as defined above.

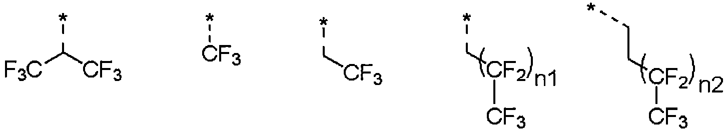

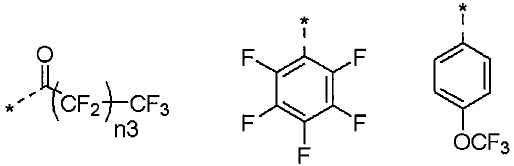

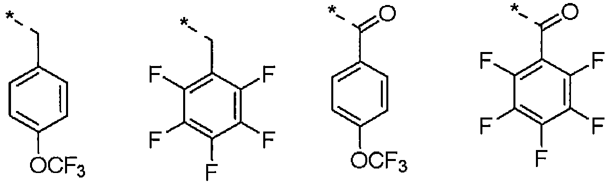

Examples of the W₂ in the general formula (1) include the following. "n4" and "n5" each represent an integer of 1 to 10.

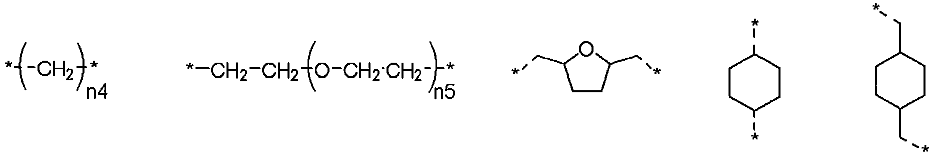

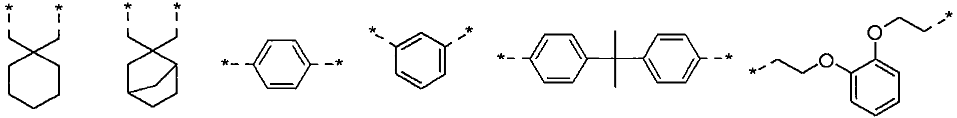

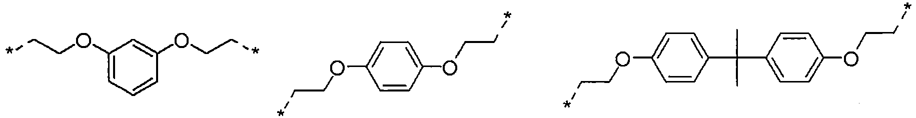

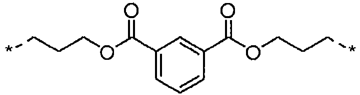

In particular, from the viewpoint of improving thermal decomposability, the structures not containing an aromatic ring are preferable, and as examples that satisfy this condition, structures represented by the following formula (5), being linked with a glyme chain, and structures having a linear alkylene group as a linking group are preferable. "n4" and "n5" are as defined above.

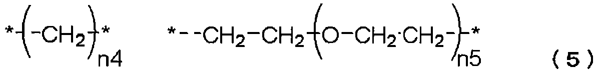

When the polymer has the above-described structure, thermal decomposability, surface active effect, and the flowability of the polymer can be adjusted, and the polymer can achieve film-formability, filling property, etc.

The polymer (B) preferably has a weight-average molecular weight of 1,000 to 30,000, more preferably 1,500 to 25,000. When the weight-average molecular weight is 1,000 or more, it is possible to suppress the degradation of a blending effect due to volatilization and so forth, and a sufficient blending effect can be achieved. Meanwhile, when the weight-average molecular weight is 30,000 or less, there is no risk of flowability being degraded and so forth, and excellent filling property can be achieved.

Note that in the present invention, the weight-average molecular weight (Mw) and the number-average molecular weight (Mn) are values in terms of standard polystyrene measured by gel permeation chromatography (GPC) using tetrahydrofuran as an eluent (solvent), and the dispersity (Mw/Mn) is calculated from Mw and Mn.

### [Method for Manufacturing Polymer]

A polymer having a structure represented by the general formula (1) can be manufactured, selecting the optimum method depending on the structure, and examples include a polyaddition reaction between a diol compound having W₁ as a partial structure (linking group) and a divinyl ether compound having W₂ as a partial structure (linking group), using an acid catalyst.

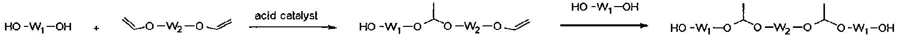

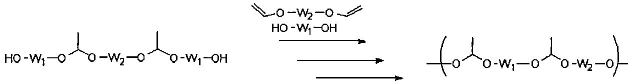

In the formulae, W₁ and W₂ are as defined above.

The reaction shown above is a general acetal formation reaction by an acid catalyst as an elementary reaction. A polymer can be finally obtained by this elementary reaction proceeding repeatedly. In the reaction, the optimum amount of the divinyl ether compound having W₂ as a partial structure to be used relative to the diol compound having W₁ as a partial structure is preferably 0.5 mol to 2 mol, particularly preferably 0.8 mol to 1.2 mol of the divinyl ether compound relative to 1 mol of the diol compound.

The acetalization reaction can be carried out by mixing the respective starting materials with an acid catalyst in a solvent or without the solvent, and cooling or heating the mixture. When a solvent is used in the reaction, the solvent may be selected from: aliphatic hydrocarbons, such as hexane and heptane; aromatic hydrocarbons, such as toluene, xylene, trimethylbenzene, and methylnaphthalene; ethers, such as diethyl ether, dibutyl ether, diethylene glycol diethyl ether, diethylene glycol dimethyl ether, and tetrahydrofuran; ketones, such as acetone and 2-butanone; alcohols, such as t-butyl alcohol and t-amyl alcohol; esters, such as ethyl acetate, propylene glycol monomethyl ether acetate, and γ-butyrolactone; nitriles, such as acetonitrile; amides, such as N,N-dimethylformamide and N,N-dimethylacetamide; halogenated hydrocarbons, such as o-dichlorobenzene, methylene chloride, and 1,2-dichloroethane; etc. One kind of solvent may be used or two or more kinds thereof may be used in mixture.

Various kinds of inorganic acids, organic acids, and solid acids may be used as the acid catalyst to be used in the reaction, and specific examples include acidic catalysts such as hydrochloric acid, nitric acid, sulfuric acid, formic acid, oxalic acid, acetic acid, methanesulfonic acid, camphorsulfonic acid, tosylic acid, trifluoromethanesulfonic acid, cation exchange resin, sodium hydrogen sulfate, and pyridinium p-toluenesulfonate. These acid catalysts are preferably used in an amount of 1×10⁻⁵ to 5×10⁻¹ mol relative to the total 1 mol of the starting materials.

The reaction temperature is preferably -20°C to 100°C, more preferably 0°C to 80°C. When the solvent is used, the upper limit is preferably approximately the boiling point of the solvent. When the reaction temperature is -20°C or higher, the reaction proceeds smoothly, and when 100°C or lower, side reactions such as a decomposition reaction of the product can be suppressed. The reaction time of the above-described reaction is preferably determined by tracing the progress of the reaction by thin layer chromatography, liquid chromatography, gel filtration chromatography, etc., to improve the yield, and is generally 0.5 to 200 hours or so. After completion of the reaction, the thermally decomposable polymer which is the target product can be obtained by a common aqueous system post treatment (aqueous work-up) and/or the filtration treatment of the insoluble components.

The obtained polymer having the structure (repeating unit) represented by the general formula (1) may be purified, if necessary, by the conventional method such as liquid-liquid separation, crystallization, concentration under reduced pressure, dialysis, ultrafiltration, etc., depending on the characteristics thereof. In addition, if necessary, the product may be passed through a commercially available demetallization filter to reduce the metal content therein.

Further, the polymer having the structure represented by the general formula (1) after the above-described purification can also be collected as a powder depending on the properties of the polymer by concentrating and drying the solvent or crystallizing the polymer under reduced pressure or normal pressure as described above. Alternatively, the polymer can be retained in a solution state with an appropriate concentration to improve the workability in preparing a composition for forming an organic film. The concentration at this point is preferably 0.1 to 50 mass%, more preferably 0.5 to 30 mass%. With such a concentration, the viscosity is hardly increased, preventing degradation of the workability; in addition, since the amount of the solvent is not excessive, the solution can be prepared economically.

The solvent in this event is not particularly limited, as long as it is capable of dissolving the compound. Specific examples of the solvent include: ketones, such as cyclohexanone and methyl-2-amyl ketone; alcohols, such as 3-methoxybutanol, 3-methyl-3-methoxybutanol, 1-methoxy-2-propanol, and 1-ethoxy-2-propanol; ethers, such as propylene glycol monomethyl ether, ethylene glycol monomethyl ether, propylene glycol monoethyl ether, ethylene glycol monoethyl ether, propylene glycol dimethyl ether, and diethylene glycol dimethyl ether; and esters such as propylene glycol monomethyl ether acetate (PGMEA), propylene glycol monoethyl ether acetate, ethyl lactate, ethyl pyruvate, butyl acetate, methyl 3-methoxypropionate, ethyl 3-ethoxypropionate, tert-butyl acetate, tert-butyl propionate, and propylene glycol mono-tert-butyl ether acetate. One of these or a mixture of two or more thereof can be used.

As a method for the reaction, it is possible to employ, for example: a method in which respective starting materials, an acid catalyst, and a solvent, if necessary, are charged at once; a method in which respective starting materials or a starting material solution is/are added dropwise solely or as a mixture in the presence of a catalyst; or a method in which mixed starting materials or a mixed starting material solution is/are passed through a column filled with a solid acid catalyst. The molecular weight may be adjusted, for example, by controlling a reaction time, by controlling an amount of the acid catalyst, by adjusting an added/contained ratio of a polymerization terminator, such as water, an alcohol, or a basic compound, and when two kinds of the starting materials are used, by controlling a ratio of the charged starting materials, or by controlling a combination of two or more of the above.

The diol compound having W₁ as a partial structure and the divinyl ether compound having W₂ as a partial structure may each be of one kind, or may each be a combination of two or more kinds. A divinyl ether compound having W₂ as a partial structure is unstable to oxygen, light, moisture, etc. in some cases, and in such a case, the reaction is preferably performed in an inert atmosphere, such as nitrogen, and under shading.

### [Different Method for Manufacturing Polymer]

When manufacturing the polymer having the structure represented by the general formula (1), a polymer having the following terminal structure can be manufactured depending on which of the charging proportions A and B is greater, A being the number of moles of the diol component and B being the number of moles of the divinyl ether component in a case where a polyaddition reaction is performed using a diol compound having W₁ as a partial structure, a divinyl ether compound having W₂ as a partial structure, and an acid catalyst. W₁ and W₂ are as defined above.

### Case 1 Charging ratio: A > B

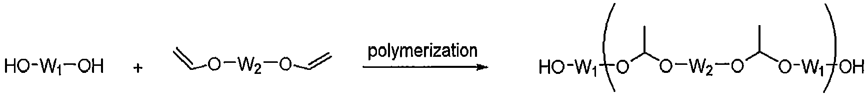

### Case 2 Charging ratio: B > A

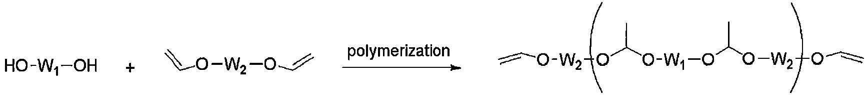

In Case 2 shown above, vinyl ether groups that are capable of reacting with an alcohol remain on the ends, and therefore, by further using a diol component, a block copolymer (I) can be obtained, and by using a monool component, end-capping (II) is possible. In a block polymer, when multiple diol components are used in the reaction shown in Case 2, the components are randomly incorporated in the polymer. However, by performing the reaction in two steps, different repeating units can be incorporated at the ends of the polymer, and by allowing different diol components to react in multiple steps, a multi-block copolymer can further be achieved. Furthermore, by further adjusting the charging ratio of the diol component to the divinyl ether component after synthesizing the block polymer, end-modification (III) using a monoalcohol is also possible.

W₃ represents a monovalent organic group having 1 to 30 carbon atoms, and W₁' is different from the W₁ used in Case 1 and has the same partial structure as the W₁.

### (I) Block polymer

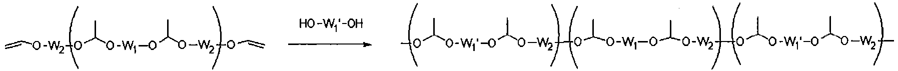

### (II) Polymer end-modification

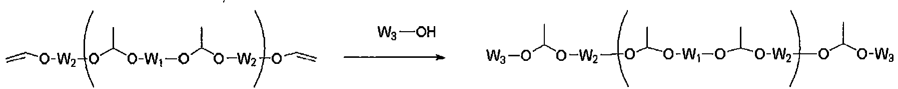

### (III) Block polymer + end-modification

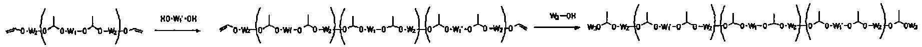

The above-described reaction can be performed according to the method for manufacturing the polymer having the structure represented by the general formula (1) described above regarding the reaction method and the method for collecting the polymer, the only difference being that the reaction is performed by adding the diol component and the monool component in multiple steps.

Examples of the monool component, having W₃ as a partial structure, used in the reaction formulae shown above include the following. In particular, a monool component having a boiling point of 180°C or higher is preferable for improving filling property on decomposition due to thermal decomposition. "n10" to "n15" each represent an integer of 1 to 10.

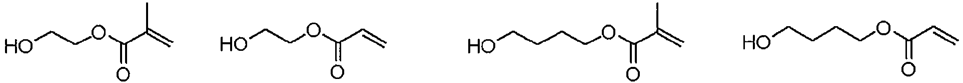

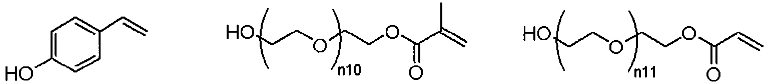

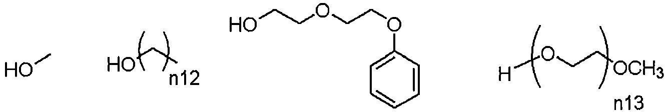

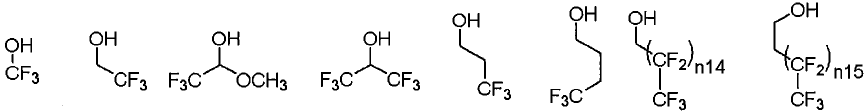

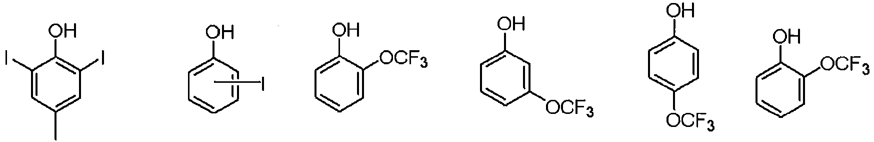

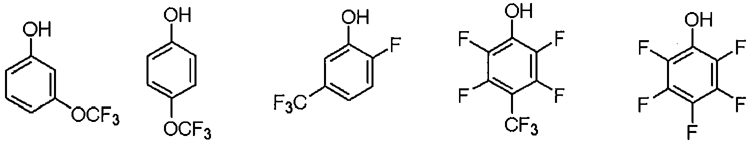

To prepare the polymer to be used in a composition for forming an organic film obtained by this method, it is possible to use various diol components and monool components and select appropriately the method for manufacturing the polymer depending on the required properties. For example, it is possible to use any combination of components having a side chain structure that contributes to the improvement of planarizing property, a fluorine-containing substituent for changing the surface activating property by controlling surface tension or the like, etc. Therefore, when a composition for forming an organic film containing the polymer is used for an organic film, it is possible to achieve high levels of various properties such as film-formability and filling property.

### [Material for Forming Organic Film]

The material (resin or compound) (A) for forming an organic film contained in the inventive composition for forming an organic film is not particularly limited as long as the material is a resin or compound that has sufficient film-formability in spin-coating and curability. From the viewpoints of etching resistance, optical characteristics, heat resistance, etc., a resin or compound including an aromatic skeleton is preferable.

Examples of the aromatic skeleton include benzene, naphthalene, anthracene, pyrene, indene, fluorene, furan, pyrrole, thiophene, phosphole, pyrazole, oxazole, isoxazole, thiazole, pyridine, pyrazine, pyrimidine, pyridazine, triazine, carbazole, etc. In particular, benzene, naphthalene, fluorene, and carbazole are particularly preferable.

In the following, the material (A) for forming an organic film will be described with reference to specific examples, but these are merely examples, and the material is not limited thereto. In addition, the numbers of the formulae shown in the following examples are used only for describing the formulae shown below.

Examples of the material (resin or compound) (A) for forming an organic film used in the present invention include resins containing the following structures, disclosed in JP 2012-001687 A and JP 2012-077295 A.

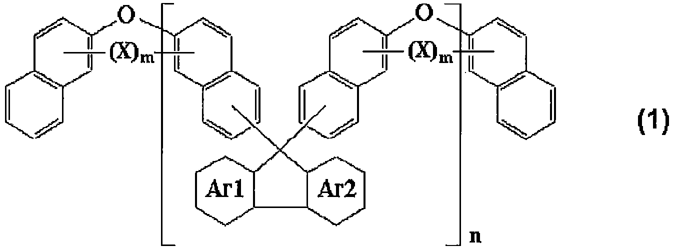

In the formula (1), the cyclic structures Ar1 and Ar2 each represent a benzene ring or a naphthalene ring. X represents a single bond or an alkylene group having 1 to 20 carbon atoms. "m" represents 0 or 1. "n" represents any natural number that provides a molecular weight of 100,000 or less. Note that the symbols in the formula apply only in this formula. 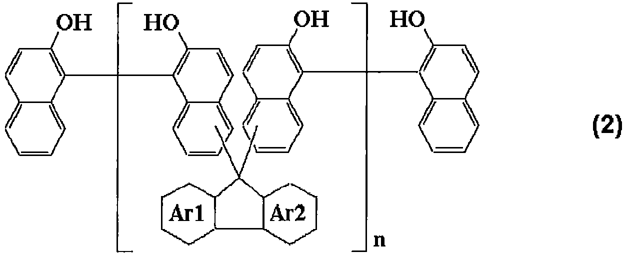 In the formula (2), the cyclic structures Ar1 and Ar2 each represent a benzene ring or a naphthalene ring. "n" represents any natural number that provides a weight-average molecular weight of 100,000 or less as measured by gel permeation chromatography in terms of polystyrene. Note that the symbols in the formula apply only in this formula.

Further examples of the material (A) for forming an organic film used in the present invention include resins containing the following structures, disclosed in JP 2004-264710 A, JP 2005-043471 A, JP 2005-250434 A, JP 2007-293294 A, and JP 2008-065303 A.

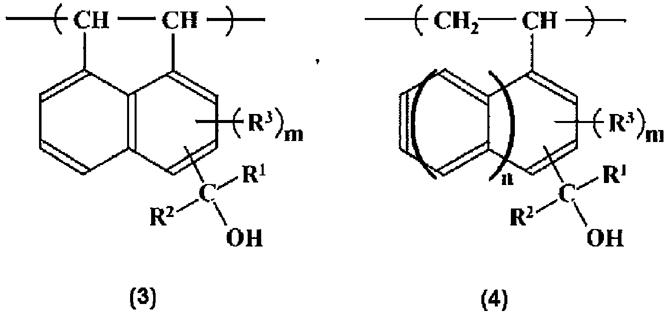

In the formula (3) and the formula (4), R¹ and R² each represent a hydrogen atom, an alkyl group having 1 to 3 carbon atoms, or an aryl group; R³ represents an alkyl group having 1 to 3 carbon atoms, a vinyl group, an allyl group, or an aryl group that is optionally substituted; "n" represents 0 or 1, and "m" represents 0, 1, or 2. Note that the symbols in the formulae apply only in these formulae.

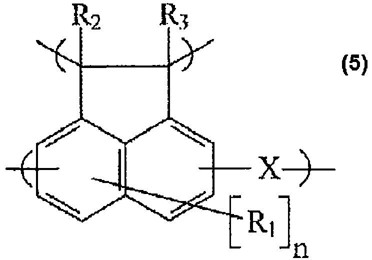

In the formula (5), R₁ represents a monovalent atom other than a hydrogen atom or a monovalent group; and "n" represents an integer of 0 to 4. Here, when "n" is 2 to 4, the multiple R₁'s may be identical to or different from each other. R₂ and R₃ each independently represent a monovalent atom or group. X represents a divalent group. Note that the symbols in the formula apply only in this formula.

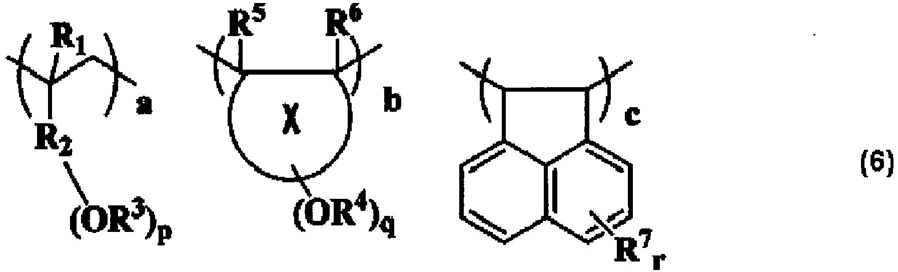

In the formula (6), R₁ represents a hydrogen atom or a methyl group. R₂ represents a single bond, a linear, branched, or cyclic alkylene group having 1 to 20 carbon atoms, or an arylene group having 6 to 10 carbon atoms, and may have any of ether, ester, lactone, and amide. R³ and R⁴ each represent a hydrogen atom or a glycidyl group. X represents any polymer of a hydrocarbon including an indene skeleton, a cycloolefin having 3 to 10 carbon atoms, and maleimide, and may have any of ether, ester, lactone, and carboxylic anhydride. R⁵ and R⁶ each represent a hydrogen atom, a fluorine atom, a methyl group, or a trifluoromethyl group. R⁷ represents a hydrogen atom, a linear, branched, or cyclic alkyl group having 1 to 6 carbon atoms, a hydroxy group, or an alkoxycarbonyl group. "p" and "q" each represent an integer of 1 to 4. "r" represents an integer of 0 to 4. "a", "b", and "c" each satisfy 0.5 ≤ a+b+c ≤ 1, 0 ≤ a ≤ 0.8, 0 ≤ b ≤ 0.8, 0.1 ≤ a+b ≤ 0.8, and 0.1 ≤ c ≤ 0.8. Note that the symbols in the formula apply only in this formula.

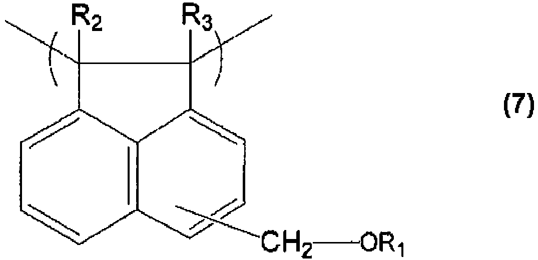

In the formula (7), R₁ represents a hydrogen atom or a monovalent organic group; and R₂ and R₃ each independently represent a monovalent atom or a monovalent organic group. Note that the symbols in the formula apply only in this formula.

Specific examples of the material (A) for forming an organic film used in the present invention include resins containing the following structures, disclosed in JP 2004-205685 A, JP 2007-171895 A, and JP 2009-014816 A.

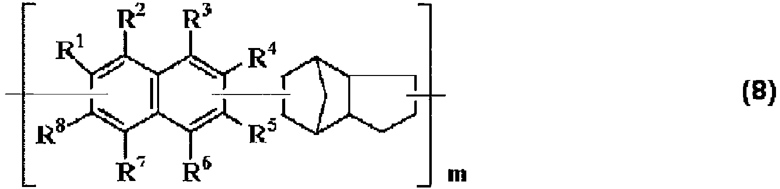

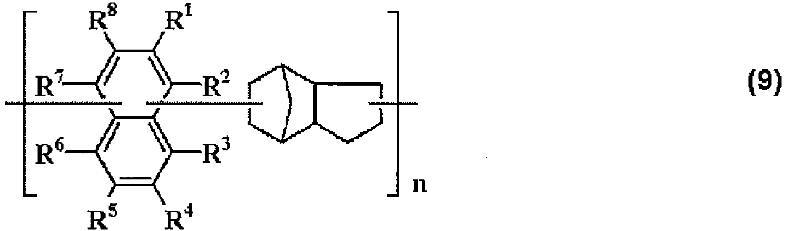

In the formula (8) and the formula (9), R¹ to R⁸ each independently represent a hydrogen atom, a hydroxy group, an alkyl group having 1 to 6 carbon atoms and optionally being substituted, an alkoxy group having 1 to 6 carbon atoms and optionally being substituted, an alkoxycarboxy group having 2 to 6 carbon atoms and optionally being substituted, an aryl group having 6 to 10 carbon atoms and optionally being substituted, a hydroxyalkyl group having 1 to 6 carbon atoms, an isocyanate group, or a glycidyl group. "m" and "n" each represent a positive integer. Note that the symbols in the formulae apply only in these formulae.

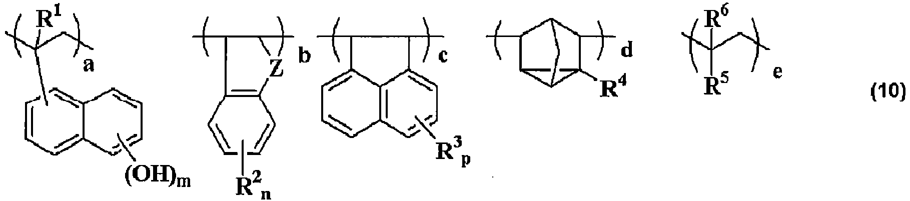

In the formula (10), R¹ and R⁶ each represent a hydrogen atom or a methyl group. R², R³, and R⁴ each represent a hydrogen atom, an alkyl group having 1 to 4 carbon atoms, an alkoxy group, a hydroxy group, an acetoxy group, an alkoxycarbonyl group, or an aryl group having 6 to 10 carbon atoms; R⁵ represents a condensed polycyclic hydrocarbon group having 13 to 30 carbon atoms, -O-R⁷, -C(=O)-O-R⁷, -O-C(=O)-R⁷, or -C(=O)-NR⁸-R⁷; "m" represents 1 or 2; "n" represents an integer of 0 to 4; and "p" represents an integer of 0 to 6. R⁷ represents an organic group having 7 to 30 carbon atoms; R⁸ represents a hydrogen atom or a hydrocarbon group having 1 to 6 carbon atoms. Z represents a methylene group, -O-, -S-, or -NH-. "a", "b", "c", "d", and "e" each satisfy 0 < a < 1.0, 0 ≤ b ≤ 0.8, 0 ≤ c ≤ 0.8, 0 ≤ d ≤ 0.8, 0 ≤ e ≤ 0.8, and 0 < b+c+d+e < 1.0. Note that the symbols in the formula apply only in this formula.

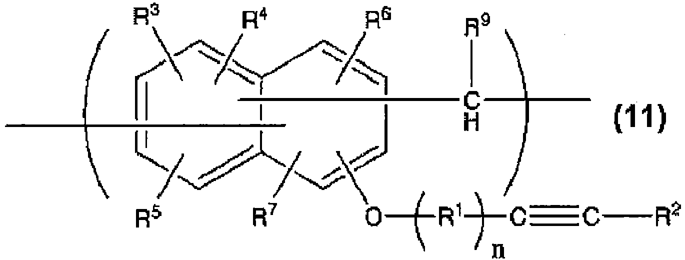

In the formula (11), "n" represents 0 or 1. R¹ represents a methylene group that is optionally substituted, an alkylene group having 2 to 20 carbon atoms and optionally being substituted, or an arylene group having 6 to 20 carbon atoms and optionally being substituted. R² represents a hydrogen atom, an alkyl group having 1 to 20 carbon atoms and optionally being substituted, or an aryl group having 6 to 20 carbon atoms and optionally being substituted. R³ to R⁷ each represent a hydroxy group, an alkyl group having 1 to 6 carbon atoms and optionally being substituted, an alkoxy group having 1 to 6 carbon atoms and optionally being substituted, an alkoxycarbonyl group having 2 to 10 carbon atoms and optionally being substituted, an aryl group having 6 to 14 carbon atoms and optionally being substituted, or a glycidyl ether group having 2 to 6 carbon atoms and optionally being substituted. R⁹ represents a hydrogen atom, a linear, branched, or cyclic alkyl group having 1 to 10 carbon atoms, a linear, branched, or cyclic alkyl ether group having 1 to 10 carbon atoms, or an aryl group having 6 to 10 carbon atoms. Note that the symbols in the formula apply only in this formula.

Examples of the formula (11) include the following resins.

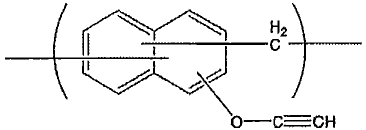

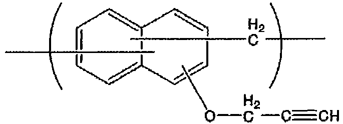

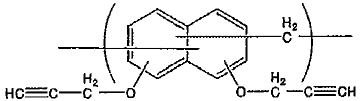

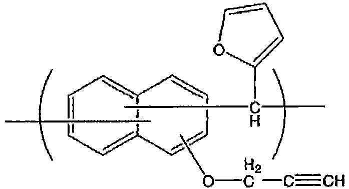

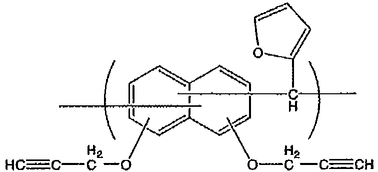

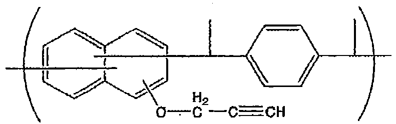

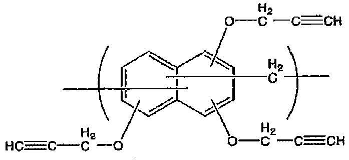

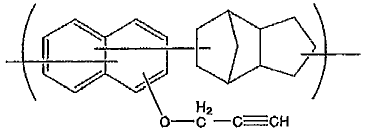

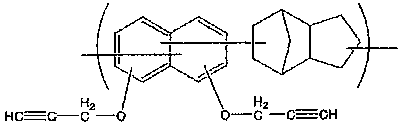

Examples of the material (A) for forming an organic film used in the present invention include resins containing the following structures, disclosed in JP 2007-199653 A, JP 2008-274250 A, and JP 2010-122656 A.

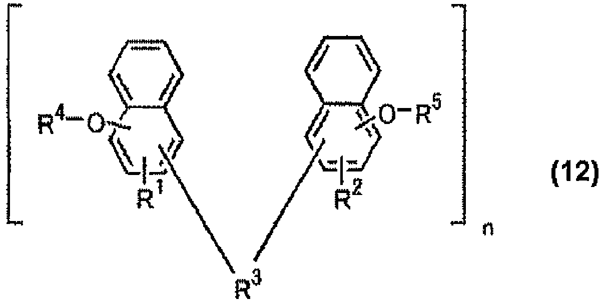

In the formula (12), R¹ and R² are identical to or different from each other and each independently represent a hydrogen atom, a linear, branched, or cyclic alkyl group having 1 to 10 carbon atoms, an aryl group having 6 to 10 carbon atoms, or an alkenyl group having 2 to 10 carbon atoms; R³ represents a single bond or a linear, branched, or cyclic alkylene group having 1 to 30 carbon atoms, and optionally has a bridged cyclic hydrocarbon group, a double bond, a heteroatom, or an aromatic group having 6 to 30 carbon atoms; R⁴ and R⁵ each independently represent a hydrogen atom or a glycidyl group; and "n" represents an integer of 1 to 4. Note that the symbols in the formula apply only in this formula.

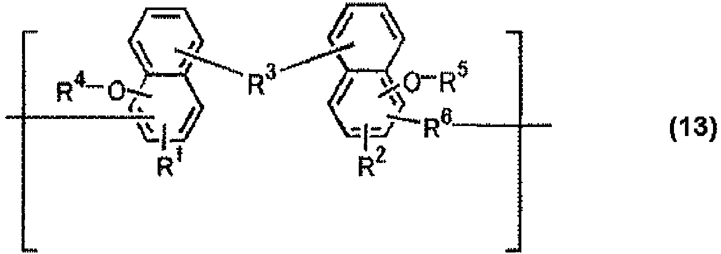

In the formula (13), R¹ and R² are identical to or different from each other and each independently represent a hydrogen atom, a linear, branched, or cyclic alkyl group having 1 to 10 carbon atoms, an aryl group having 6 to 10 carbon atoms, or an alkenyl group having 2 to 10 carbon atoms; R³ represents a single bond or a linear, branched, or cyclic alkylene group having 1 to 30 carbon atoms, and optionally has a bridged cyclic hydrocarbon group, a double bond, a heteroatom, or an aromatic group having 6 to 30 carbon atoms; R⁴ and R⁵ each independently represent a hydrogen atom or a glycidyl group; and R⁶ represents a single bond or a linear or branched alkylene group having 1 to 10 carbon atoms. Note that the symbols in the formula apply only in this formula.

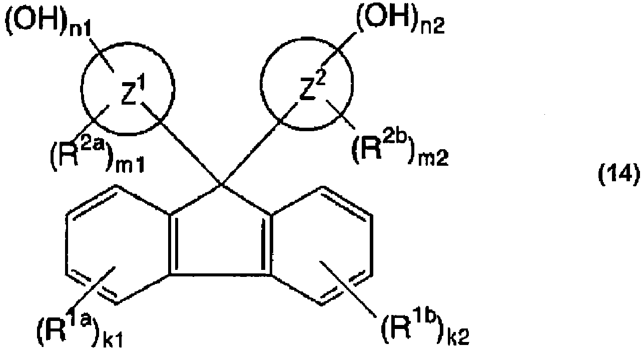

In the formula (14), the ring Z¹ and the ring Z² each represent a condensed polycyclic aromatic hydrocarbon ring; and R^{1a}, R^{1b}, R^{2a}, and R^{2b} are identical to or different from each other and each represent a substituent. "k1" and "k2" are identical to or different from each other and each represent 0 or an integer of 1 to 4; "m1" and "m2" each represent 0 or an integer of 1 or more; and "n1" and "n2" each represent 0 or an integer of 1 or more. Here, n1+n2 ≥ 1. Note that the symbols in the formula apply only in this formula.

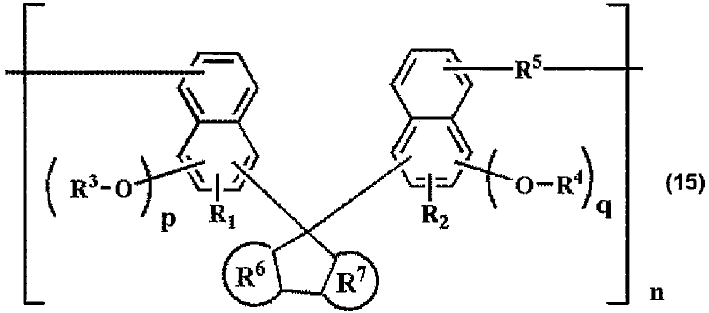

In the formula (15), R₁ and R₂ are identical to or different from each other, and each represent a hydrogen atom, a linear, branched, or cyclic alkyl group having 1 to 10 carbon atoms, an aryl group having 6 to 10 carbon atoms, or an alkenyl group having 2 to 10 carbon atoms. R³ and R⁴ each represent a hydrogen atom or a glycidyl group; R⁵ represents a single bond or a linear or branched alkylene group having 1 to 10 carbon atoms; and R⁶ and R⁷ each represent a benzene ring or a naphthalene ring. "p" and "q" each represent 1 or 2. "n" satisfies 0 < n ≤ 1. Note that the symbols in the formula apply only in this formula.

Examples of the formula (15) include the following resins.

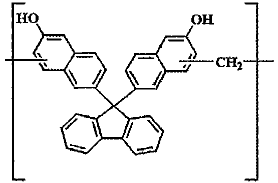

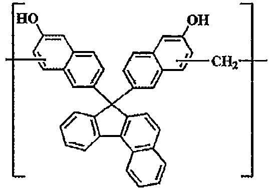

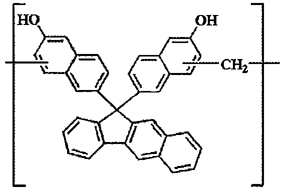

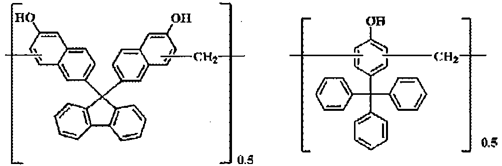

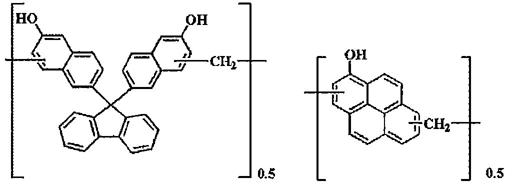

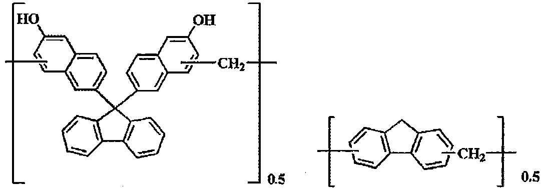

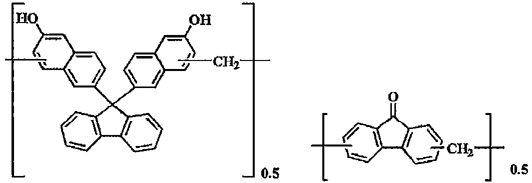

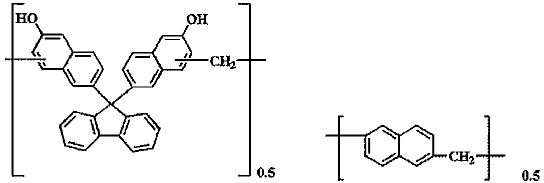

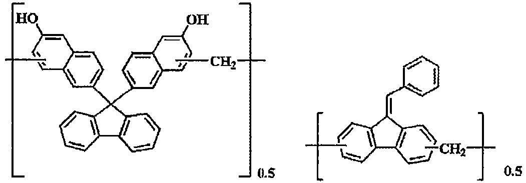

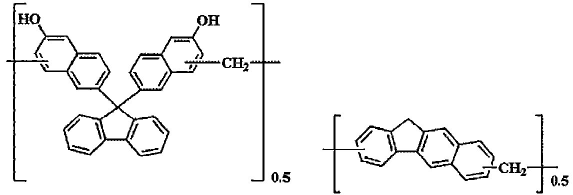

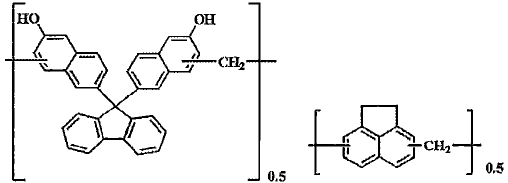

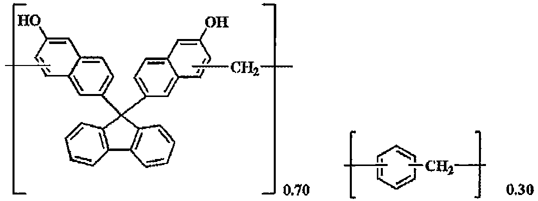

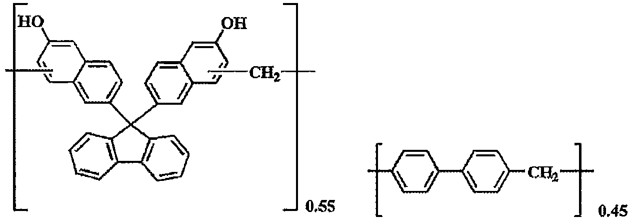

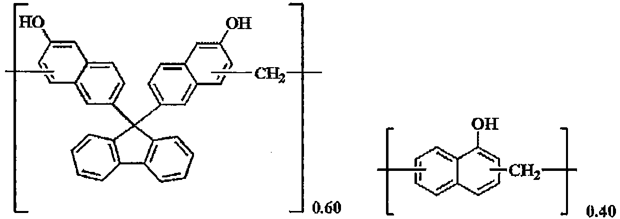

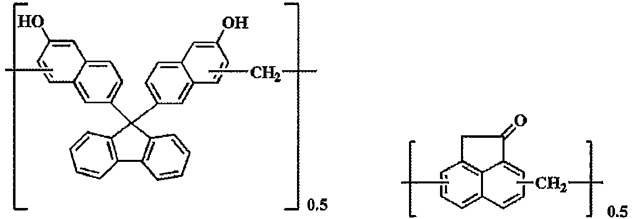

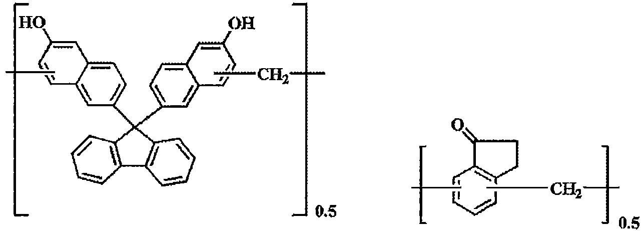

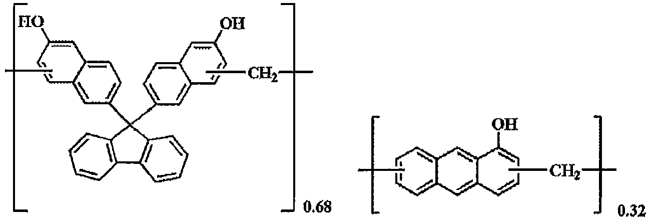

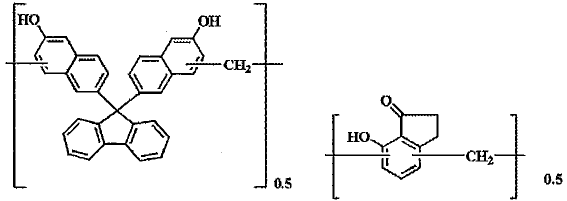

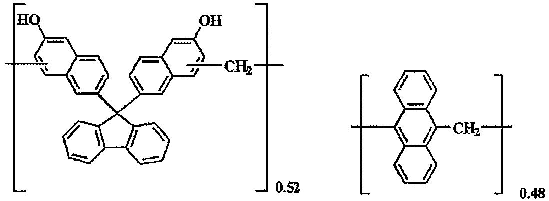

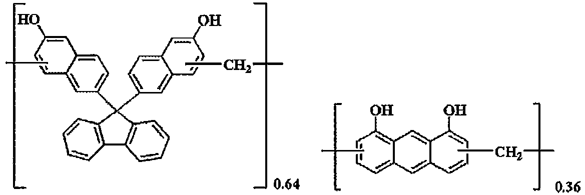

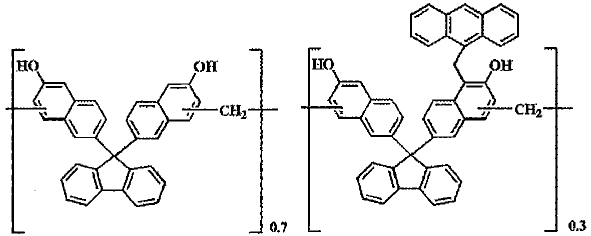

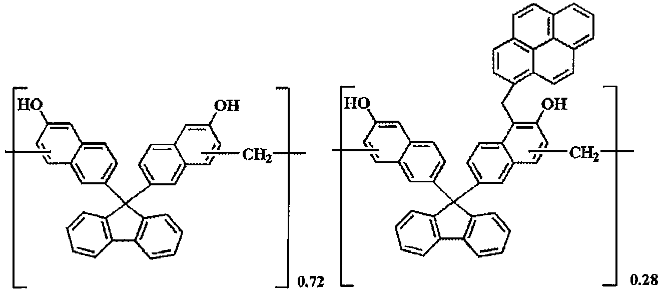

Examples of the material (A) for forming an organic film used in the present invention include resins containing the following structure, disclosed in JP 2012-214720 A.

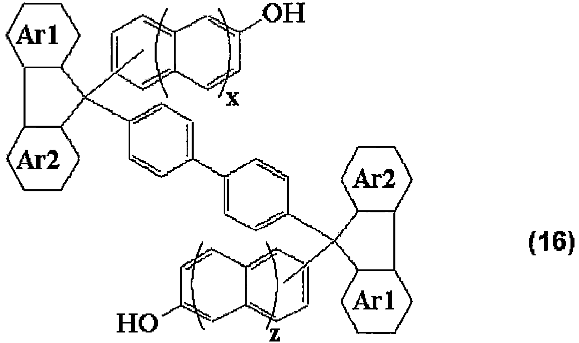

In the formula (16), the cyclic structures Ar1 and Ar2 each represent a benzene ring or a naphthalene ring. "x" and "z" each independently represent 0 or 1. Note that the symbols in the formula apply only in this formula.

Examples of the material (A) for forming an organic film used in the present invention include resins disclosed in JP 2014-029435 A.

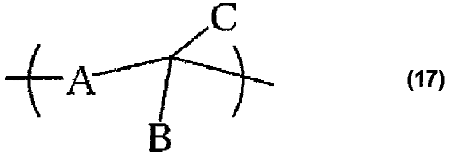

In the formula (17), A represents a structure having carbazole, B represents a structure having an aromatic ring, and C represents a hydrogen atom, an alkyl group, or a structure having an aromatic ring, B and C optionally constituting a ring with each other. 1 to 4 carboxy groups, a salt thereof, or a carboxylic acid ester group is contained in the structure of A, B, and C combined. Note that the symbols in the formula apply only in this formula.

Examples of the material (A) for forming an organic film used in the present invention also include polymers disclosed in WO 2012/077640 A1, the polymers containing a unit structure represented by the following formula (18) and a unit structure represented by the following formula (19), where the ratio of the unit structure represented by the formula (18) to the unit structure represented by the formula (19) is 3 to 97:97 to 3 by molar ratio.

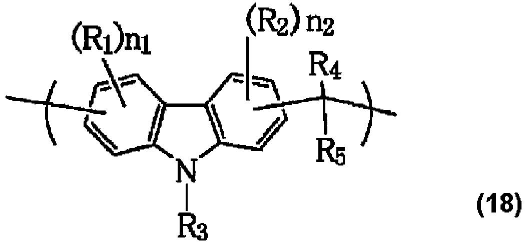

In the formula (18), R₁ and R₂ each independently represent a hydrogen atom, a halogen atom, a nitro group, an amino group, a hydroxy group, an alkyl group having 1 to 10 carbon atoms, an alkenyl group having 2 to 10 carbon atoms, an aryl group having 6 to 40 carbon atoms, or a combination of the groups, optionally including an ether bond, a ketone bond, or an ester bond. R₃ represents a hydrogen atom, an alkyl group having 1 to 10 carbon atoms, an alkenyl group having 2 to 10 carbon atoms, an aryl group having 6 to 40 carbon atoms, or a combination of the groups, optionally including an ether bond, a ketone bond, or an ester bond. R₄ represents a hydrogen atom, or an aryl group or heterocyclic group having 6 to 40 carbon atoms and optionally being substituted with a halogen atom, a nitro group, an amino group, or a hydroxy group; R₅ represents a hydrogen atom, or an alkyl group having 1 to 10 carbon atoms, aryl group having 6 to 40 carbon atoms, or heterocyclic group optionally substituted with a halogen atom, a nitro group, an amino group or a hydroxy group; and R₄ and R₅ may form a ring with each other. "n1" and "n2" each represent an integer of 1 to 3. Note that the symbols in the formula apply only in this formula.

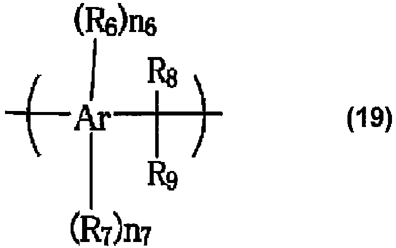

In the formula (19), Ar represents an aromatic ring group having 6 to 20 carbon atoms; R₆ represents a hydroxy group; and R₇ represents a hydrogen atom, a halogen atom, a nitro group, an amino group, an alkyl group having 1 to 10 carbon atoms, an alkenyl group having 2 to 10 carbon atoms, an aryl group having 6 to 40 carbon atoms, or a combination of the groups, optionally including an ether bond, a ketone bond, or an ester bond. R₈ represents a hydrogen atom, or an aryl group or heterocyclic group having 6 to 40 carbon atoms and optionally substituted with a halogen atom, a nitro group, an amino group, or a hydroxy group; R₉ represents a hydrogen atom, or an alkyl group having 1 to 10 carbon atoms, an aryl group having 6 to 40 carbon atoms, or a heterocyclic group optionally substituted with a halogen atom, a nitro group, an amino group or a hydroxy group; and R₈ and R₉ may form a ring with each other. "n6" represents an integer of 1 to "p", "n7" represents an integer of p-n6. Here, "p" is the maximum number of substituents with which the aromatic ring group Ar can be substituted. Note that the symbols in the formula apply only in this formula.

Examples of the material (A) for forming an organic film used in the present invention include polymers containing a unit structure represented by the following formula (20), disclosed in WO 2010/147155 A1.

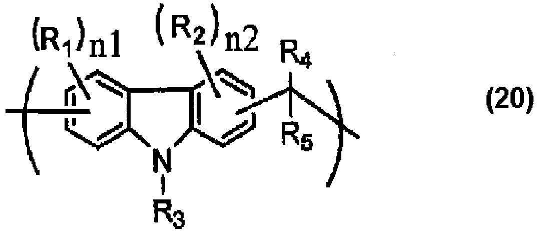

In the formula (20), R₁ and R₂ are each selected from a group consisting of a hydrogen atom, a halogen group, a nitro group, an amino group, a hydroxy group, alkyl groups having 1 to 10 carbon atoms, alkenyl groups having 2 to 10 carbon atoms, aryl groups having 6 to 40 carbon atoms, and combinations thereof, the alkyl groups, the alkenyl groups, or the aryl groups optionally containing an ether bond, a ketone bond, or an ester bond; R₃ is selected from a group consisting of a hydrogen atom, alkyl groups having 1 to 10 carbon atoms, alkenyl groups having 2 to 10 carbon atoms, aryl groups having 6 to 40 carbon atoms, and combinations thereof, the alkyl groups, the alkenyl groups, or the aryl groups optionally containing an ether bond, a ketone bond, or an ester bond; R₄ represents an aryl group or heterocyclic group having 6 to 40 carbon atoms and optionally substituted with a halogen group, a nitro group, an amino group, or a hydroxy group; R₅ represents a hydrogen atom or an alkyl group having 1 to 10 carbon atoms or an aryl group or heterocyclic group having 6 to 40 carbon atoms and optionally substituted with a halogen group, a nitro group, an amino group, or a hydroxy group; R₄ and R₅ optionally form a ring together with the carbon atom bonded to R₄ and R₅; "n1" and "n2" each represent an integer of 1 to 3. Note that the symbols in the formula apply only in this formula.

Examples of the material (A) for forming an organic film used in the present invention include: novolak resins obtained by a reaction between one or more phenols, such as phenol, cresol, xylenol, catechol, resorcinol, hydroquinone, pyrogallol, hydroxyquinol, and phloroglucinol, and one or more aldehyde sources, such as formaldehyde, paraformaldehyde, and trioxane, in the presence of an acid catalyst; and resins containing a repeating unit structure represented by the following formula (21), disclosed in WO 2012/176767 A1.

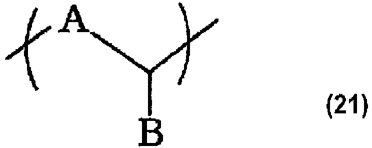

In the formula (21), A represents a hydroxy group-substituted phenylene group derived from polyhydroxybenzene; and B represents monovalent condensed aromatic hydrocarbon ring group in which 2 to 6 benzene rings are condensed. Note that the symbols in the formula apply only in this formula.

Examples of the material (A) for forming an organic film used in the present invention include novolak resins having a fluorene or tetrahydrospirobiindene structure, disclosed in JP 2005-128509 A, JP 2006-259249 A, JP 2006-259482 A, JP 2006-293298 A, and JP 2007-316282 A, the novolak resins containing a repeating unit structure represented by the following formula (22-1) or (22-2).

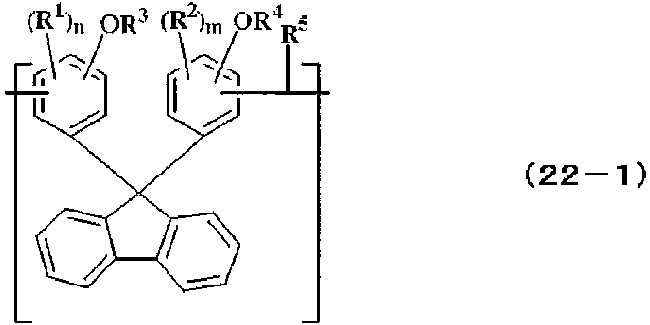

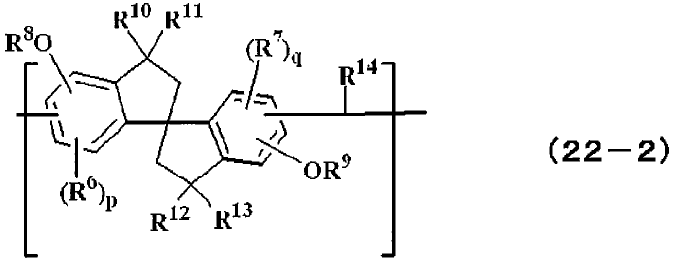

In the formula (22-1) and the formula (22-2), R¹, R², R⁶, and R⁷ each independently represent a hydrogen atom, a linear, branched, or cyclic alkyl group having 1 to 10 carbon atoms, an aryl group having 6 to 10 carbon atoms, an allyl group, or a halogen atom; R³, R⁴, R⁸, and R⁹ each independently represent a hydrogen atom, a linear, branched, or cyclic alkyl group having 1 to 6 carbon atoms, a linear, branched, or cyclic alkenyl group having 2 to 6 carbon atoms, an aryl group having 6 to 10 carbon atoms, or a glycidyl group; and R⁵ and R¹⁴ each independently represent a hydrogen atom, a linear, branched, or cyclic alkyl group having 1 to 10 carbon atoms, or an aryl group having 6 to 10 carbon atoms. "n", "m", "p", and "q" each represent an integer of 1 to 3. R¹⁰ to R¹³ each independently represent a hydrogen atom, a halogen atom, a hydroxy group, a linear, branched, or cyclic alkyl group having 1 to 6 carbon atoms, or a linear, branched, or cyclic alkoxy group having 1 to 6 carbon atoms. Note that the symbols in the formulae apply only in these formulae.

Examples of the material (A) for forming an organic film used in the present invention include reaction products obtained by a method disclosed in JP 2012-145897 A. More specific examples include polymers obtained by condensing one or more compounds represented by the following general formula (23-1) and/or (23-2) and one or more compounds represented by the following general formula (24-1) and/or (24-2) and/or an equivalent thereof.

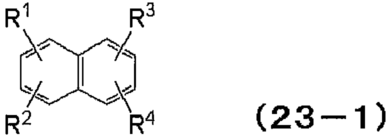

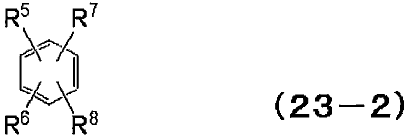

In the general formula (23-1) and the general formula (23-2), R¹ to R⁸ each independently represent a hydrogen atom, a halogen atom, a hydroxy group, an isocyanato group, a glycidyloxy group, a carboxy group, an amino group, an alkoxy group having 1 to 30 carbon atoms, an alkoxycarbonyl group having 1 to 30 carbon atoms, and an alkanoyloxy group having 1 to 30 carbon atoms, or a saturated or unsaturated organic group having 1 to 30 carbon atoms and optionally being substituted. Furthermore, any two substituents selected from each of R¹ to R⁴ or R⁵ to R⁸ may be bonded to each other within a molecule to form a cyclic substituent. Note that the symbols in the formulae apply only in these formulae.

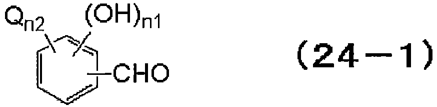

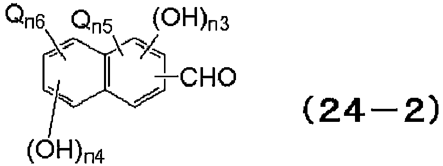

In the general formula (24-1) and the general formula (24-2), Q represents an organic group having 1 to 30 carbon atoms and optionally being substituted, and furthermore, any two Q's selected therefrom are optionally bonded with each other within a molecule to form a cyclic substituent. "n1" to "n6" each represent the number of each substituent, "n1" to "n6" are each 0, 1, or 2, and in the formula (24-1), hydroxybenzaldehyde is excluded. Meanwhile, in the formula (24-2), the relationships 0 ≤ n3+n5 ≤ 3, 0 ≤ n4+n6 ≤ 4, and 1 ≤ n3+n4 ≤ 4 exist. Note that the symbols in the formulae apply only in these formulae.

Further examples include polymers obtained by condensing one or more compounds represented by the general formula (23-1) and/or (23-2), one or more compounds represented by the general formula (24-1) and/or (24-2) and/or an equivalent thereof, and one or more compounds represented by the following general formula (25) and/or an equivalent thereof.

Y-CHO (25)

In the formula (25), Y represents a hydrogen atom or a monovalent organic group having 30 or fewer carbon atoms and optionally having a substituent, and the formula (25) is different from the general formula (24-1) and the general formula (24-2). Note that the symbol in the formula applies only in this formula.

Examples of the material (A) for forming an organic film used in the present invention include compounds containing the following structure, disclosed in JP 2017-119671 A.

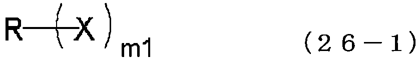

In the formula (26-1), R represents a single bond or an organic group having 1 to 50 carbon atoms; X represents a group represented by any of the following general formulae (26-2); and "m1" represents an integer that satisfies 2 ≤ m1 ≤ 10. Note that the symbols in the formula apply only in this formula.

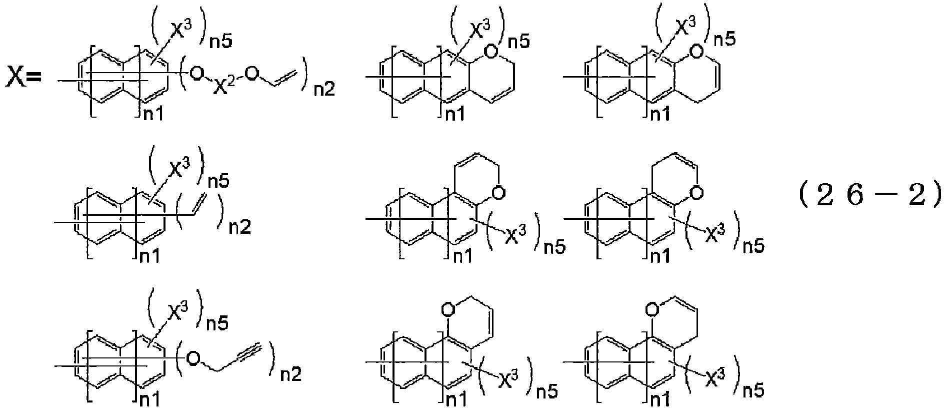

In the formulae, X² represents a divalent organic group having 1 to 10 carbon atoms; "n1" represents 0 or 1; "n2" represents 1 or 2; X³ represents a group represented by the following general formula (26-3); and "n5" represents 0, 1, or 2. Note that the symbols in the formulae apply only in these formulae.

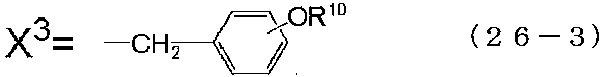

In the formula, R¹⁰ represents a hydrogen atom or a saturated or unsaturated hydrocarbon group having 1 to 10 carbon atoms, and a hydrogen atom on the benzene ring in the formula may be substituted with a methyl group or a methoxy group. Note that the symbols in the formula apply only in this formula.

Examples of the compounds containing the above-described structures include the following compounds.

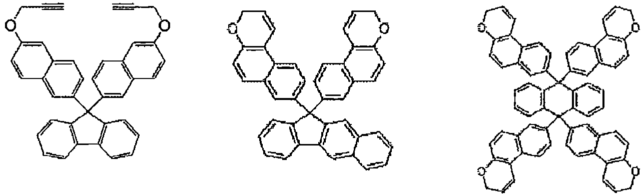

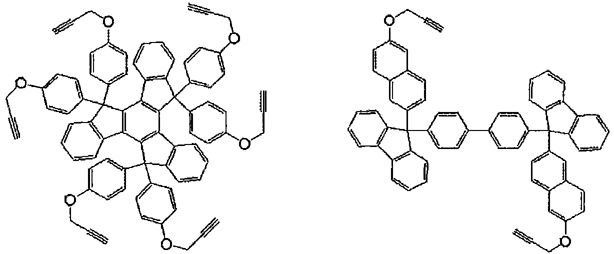

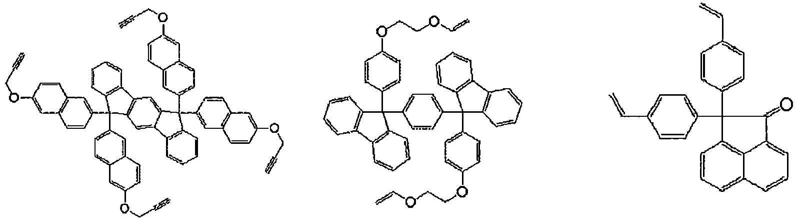

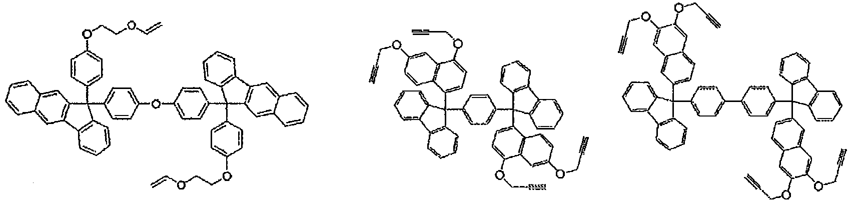

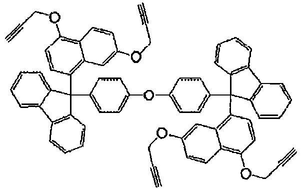

Examples of the material (A) for forming an organic film used in the present invention include polymers having a repeating unit represented by the following general formula (27-1), disclosed in JP 2019-044022 A.

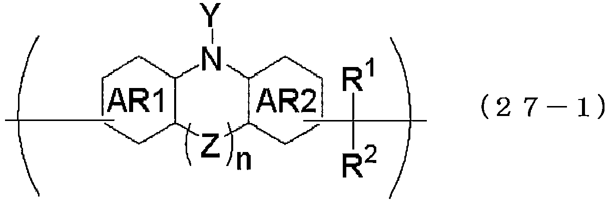

In the formula (27-1), AR1 and AR2 each represent a benzene ring or naphthalene ring optionally having a substituent. R¹ and R² each independently represent a hydrogen atom or an organic group having 1 to 30 carbon atoms, and when R¹ and R² each represent an organic group, R¹ and R² are optionally bonded to each other within a molecule to form a cyclic organic group. "n" represents 0 or 1; when n = 0, AR1 and AR2 do not form a bridged structure between the aromatic rings of AR1 and AR2 via Z; when n = 1, AR1 and AR2 form a bridged structure between the aromatic rings of AR1 and AR2 via Z; and Z represents a single bond or the following formula (27-2). Y represents a group represented by the following formula (27-3). Note that the symbols in the formula apply only in this formula.

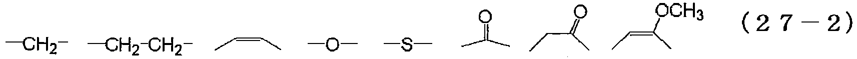

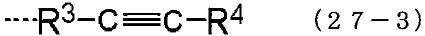

In the formula, R³ represents a single bond or a divalent organic group having 1 to 20 carbon atoms; R⁴ represents a hydrogen atom or a monovalent organic group having 1 to 20 carbon atoms; and a broken line represents an attachment point. Note that the symbols in the formula apply only in this formula.

Examples of the polymers having a repeating unit represented by the general formula (27-1) include the following polymers.

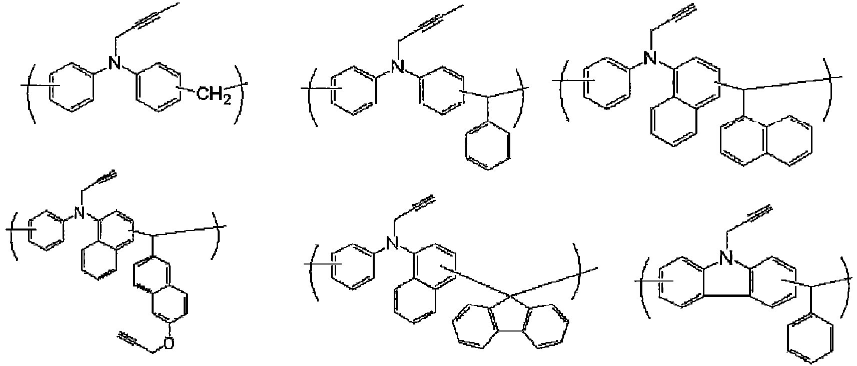

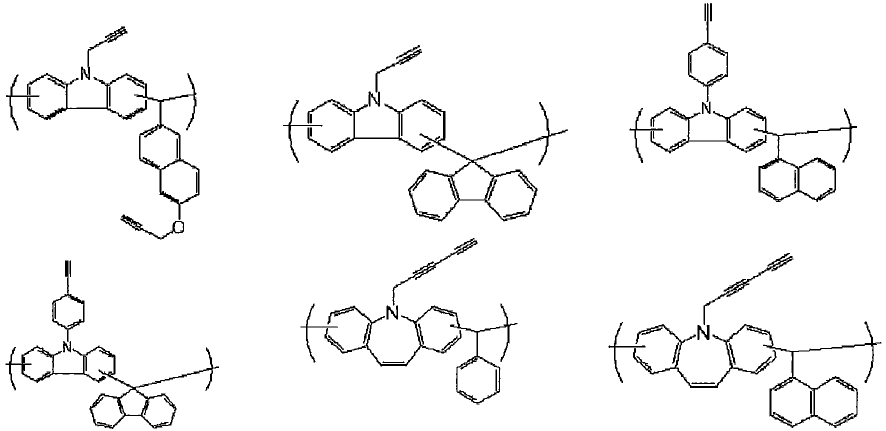

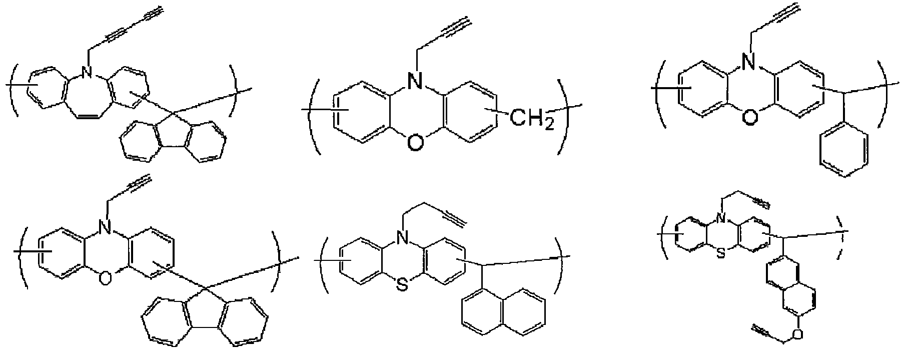

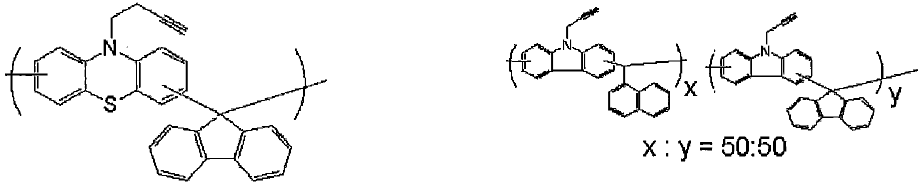

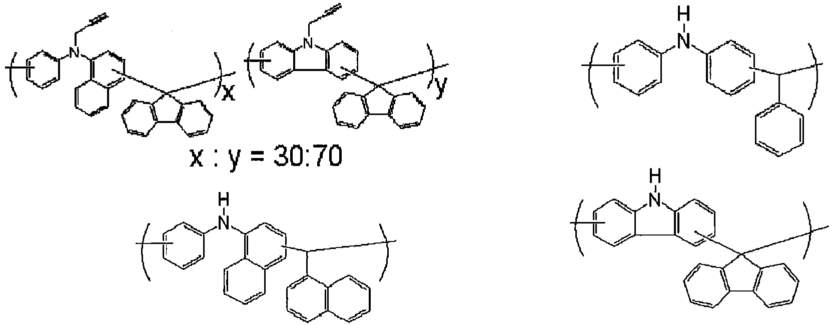

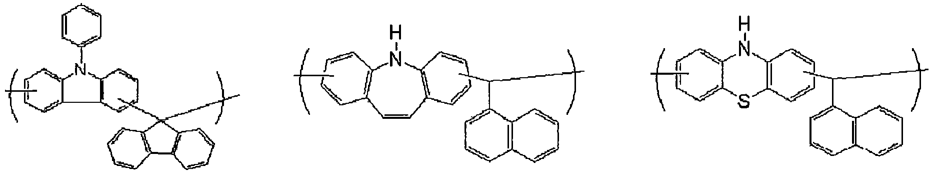

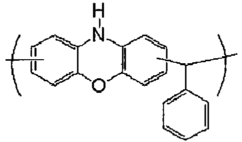

The material (A) for forming an organic film may be synthesized by a known method, and a commercially available product may be used.

The amount of the material (A) for forming an organic film to be contained is not particularly limited as long as sufficient film-formability can be achieved on spin-coating with the composition for forming an organic film, but the material (A) for forming an organic film is preferably contained in an amount of 10 to 40 parts by mass, more preferably 10 to 30 parts by mass, and further preferably 10 to 25 parts by mass, based on 100 parts by mass of the composition for forming an organic film. For example, when a hole or trench, having a very high aspect ratio, of a 3D NAND memory architecture is to be filled with the composition for forming an organic film, the contained amount of the material for forming an organic film needs to be large. However, on the other hand, such a composition for forming an organic film is highly viscous, and in-plane uniformity after spin-coating and filling property are degraded. Even when the material (A) for forming an organic film is contained in such a proportion, the inventive composition for forming an organic film makes it possible to form an organic film having excellent in-plane uniformity and excellent filling property, and can therefore be applied suitably.

Meanwhile, the polymer (B) is preferably contained in an amount of 0.01 parts by mass to 5 parts by mass based on 100 parts by mass of the material (A) for forming an organic film. A composition for forming an organic film containing the polymer in such an amount can provide a formed organic film with better in-plane uniformity.

### [Solvent]

The solvent (C) usable for the inventive composition for forming an organic film is not particularly limited as long as the solvent can dissolve the material (A) for forming an organic film and the polymer (B), and the solvent can preferably also dissolve the acid generator, crosslinking agent, surfactant, etc. described later. Specifically, it is possible to use a solvent having a boiling point lower than 180°C, such as the solvents disclosed in paragraphs

(0091) and (0092) of JP 2007-199653 A. In particular, preferable solvents are propylene glycol monomethyl ether acetate, propylene glycol monomethyl ether, 2-heptanone, cyclopentanone, cyclohexanone, and mixtures of two or more thereof.

The solvent (C) is preferably contained in an amount of 200 to 10,000 parts by mass, more preferably 300 to 5,000 parts based on 100 parts by mass of the material (A) for forming an organic film. When the amount is in such a range, the concentration is adjustable in accordance with the desired film thickness.

Furthermore, the inventive composition for forming an organic film may also contain, as an organic solvent, a high-boiling-point solvent, having a boiling point of 180°C or higher, in addition to the above-described solvent having a boiling point of lower than 180°C (a mixture of a solvent having a boiling point of lower than 180°C and a solvent having a boiling point of 180°C or higher). The high-boiling-point organic solvent is not particularly limited to hydrocarbons, alcohols, ketones, esters, ethers, or chlorine-based solvents as long as the solvent is capable of dissolving the compound for forming an organic film. Specific examples include 1-octanol, 2-ethylhexanol, 1-nonanol, 1-decanol, 1-undecanol, ethylene glycol, 1,2-propylene glycol, 1,3-butylene glycol, 2,4-pentanediol, 2-methyl-2,4-pentanediol, 2,5-hexanediol, 2,4-heptanediol, 2-ethyl-1,3-hexanediol, diethylene glycol, dipropylene glycol, triethylene glycol, tripropylene glycol, glycerin, n-nonyl acetate, ethylene glycol monohexyl ether, ethylene glycol mono-2-ethylhexyl ether, ethylene glycol monophenyl ether, ethylene glycol monobenzyl ether, diethylene glycol monoethyl ether, diethylene glycol monoisopropyl ether, diethylene glycol mono-n-butyl ether, diethylene glycol monoisobutyl ether, diethylene glycol monohexyl ether, diethylene glycol monophenyl ether, diethylene glycol monobenzyl ether, diethylene glycol diethyl ether, diethylene glycol dibutyl ether, diethylene glycol butyl methyl ether, triethylene glycol dimethyl ether, triethylene glycol monomethyl ether, triethylene glycol-n-butyl ether, triethylene glycol butyl methyl ether, triethylene glycol diacetate, tetraethylene glycol dimethyl ether, dipropylene glycol monomethyl ether, dipropylene glycol mono-n-propyl ether, dipropylene glycol mono-n-butyl ether, tripropylene glycol dimethyl ether, tripropylene glycol monomethyl ether, tripropylene glycol mono-n-propyl ether, tripropylene glycol mono-n-butyl ether, ethylene glycol monoethyl ether acetate, ethylene glycol monobutyl ether acetate, diethylene glycol monomethyl ether acetate, diethylene glycol monoethyl ether acetate, diethylene glycol monobutyl ether acetate, triacetin, propylene glycol diacetate, dipropylene glycol monomethyl ether acetate, dipropylene glycol methyl-n-propyl ether, dipropylene glycol methyl ether acetate, 1,4-butanediol diacetate, 1,3-butylene glycol diacetate, 1,6-hexanediol diacetate, γ-butyrolactone, dihexyl malonate, diethyl succinate, dipropyl succinate, dibutyl succinate, dihexyl succinate, dimethyl adipate, diethyl adipate, dibutyl adipate, and the like. One of the solvents may be used or a mixture of two or more kinds may be used.

The boiling point of the high-boiling-point solvent can be selected appropriately in accordance with the temperature at which the composition for forming an organic film is heated, and the boiling point of the high-boiling-point solvent to be contained is preferably 180°C to 300°C, further preferably 200°C to 300°C. When the boiling point is as described, sufficient thermal flowability can be achieved, since there is no risk of excessive evaporation rate at the baking (heating) due to the boiling point being too low. Moreover, a solvent having such a boiling point does not remain in the film without evaporating even after the baking due to the boiling point being too high. Therefore, there is no risk of the solvent adversely affecting the physical properties, such as etching resistance, of the film.

Furthermore, when the high-boiling-point solvent is used, the amount to be blended is preferably 1 to 30 parts by mass per 100 parts by mass of the solvent having a boiling point of lower than 180°C. When the contained amount is as described, there are no risks that sufficient thermal flowability cannot be imparted at the time of baking due to the contained amount being too small or that the solvent remains in the film due to the contained amount being too large and leads to degradation of physical properties, such as etching resistance, of the film.

The above-described composition for forming an organic film is provided with thermal flowability by the high-boiling-point solvent being contained, and the composition for forming an organic film is provided with both high filling and planarizing properties.

### [Other Components]

In addition, the inventive composition for forming an organic film can contain an acid generator or a crosslinking agent for further promoting the crosslinking reaction. Acid generators include materials that generate an acid by thermal decomposition and materials that generate an acid by light irradiation, and any acid generator can be contained. Specific examples of the acid generator include those disclosed in paragraphs [0061] to [0085] of JP 2007-199653 A. One kind of the acid generator may be used, or two or more kinds thereof may be used in combination. When the acid generator is contained, the contained amount is preferably 0.05 to 50 parts by mass, more preferably 0.1 to 10 parts by mass based on 100 parts by mass of the material (A) for forming an organic film. When the amount is as described, it is possible to promote the crosslinking reaction and form a dense film.

Specific examples of the crosslinking agent include those disclosed in paragraphs [0055] to [0060] of JP 2007-199653 A. One kind of the crosslinking agent may be used, or two or more kinds thereof may be used in combination. The crosslinking agent is preferably contained in an amount of 1 to 100 parts by mass, more preferably 5 to 50 parts by mass based on 100 parts by mass of the material (A) for forming an organic film. When the amount is as described, it is possible to enhance curability and further suppress intermixing with an upper layer film.

The inventive composition for forming an organic film can also contain a surfactant other than the polymer (B) of the present invention for further improving in-plane uniformity in spin-coating. Specific examples of the surfactant include those disclosed in paragraphs [0142] to [0147] of JP 2009-269953 A. One kind of the surfactant may be used, or two or more kinds thereof may be used in combination. When the surfactant is contained, the contained amount is preferably 0.01 to 10 parts by mass, more preferably 0.05 to 5 parts by mass based on 100 parts by mass of the material for forming an organic film. When the amount is as described, it is possible to form an organic film excellent in in-plane uniformity.

The inventive composition for forming an organic film can further contain a basic compound for enhancing storage stability. The basic compound serves as a quencher to an acid to prevent a very small amount of acid generated by the acid generator from promoting the crosslinking reaction. Specific examples of such a basic compound include those disclosed in paragraphs [0086] to [0090] of JP 2007-199653 A. One kind of the basic compound may be used, or two or more kinds thereof may be used in combination. When the basic compound is contained, the contained amount is preferably 0.05 to 50 parts by mass, more preferably 0.1 to 10 parts by mass based on 100 parts by mass of the material (A) for forming an organic film. When the amount is as described, it is possible to improve the storage stability of the composition for forming an organic film.

As described above, the inventive composition for forming an organic film is excellent in hump suppression at the time of an EBR process. Accordingly, the inventive composition for forming an organic film is extremely useful as a resist underlayer film material (organic film material) for multilayer resist processes such as two-layer resist processes, three-layer resist processes using a silicon-containing resist middle layer film or a silicon-containing inorganic hard mask middle layer film, and four-layer resist processes using a silicon-containing resist middle layer film or silicon-containing inorganic hard mask middle layer film and an organic antireflective film or adhesive film.

### [Method for Forming Organic Film]

The present invention provides a method for forming an organic film to be used in a manufacturing process of a semiconductor device, the method including: spin-coating a substrate to be processed with the inventive composition for forming an organic film described above to form a coating film; and forming an organic film by heating the coating film at a temperature of 100°C or higher and 600°C or lower for 10 to 600 seconds to cure the coating film. For example, an organic film is formed by heating a substrate coated with the composition for forming an organic film in the above-described temperature and time ranges to cure the composition.

In this method for forming an organic film, firstly, the inventive composition for forming an organic film described above is applied onto a substrate to be processed by spin-coating. An excellent filling property can be obtained by using a spin-coating method. After removing a film on an edge portion in an EBR process, baking (heating) is performed in order to promote the crosslinking reaction. Incidentally, the solvent in the composition can be evaporated by this baking, and therefore, mixing can be prevented even when a resist upper layer film or a silicon-containing resist middle layer film is formed on the organic film.

The baking is performed at a temperature of 100°C or higher and 600°C or lower for 10 to 600 seconds, preferably at a temperature of 200°C or higher and 500°C or lower for 10 to 300 seconds. Considering influence on device damage and wafer deformation, the upper limit of the heating temperature in a wafer process of lithography is preferably 600°C or lower, more preferably 500°C or lower. By performing the heat treatment under such conditions, the crosslinking reaction can be promoted, and it is possible to form an organic film that does not mix with a film formed thereon.

### [Patterning Process]

In the following, patterning processes using the inventive composition for forming an organic film will be described.

### [Three-Layer Resist Process Using Silicon-Containing Resist Middle Layer Film]

The present invention provides a patterning process including:
forming an organic film on a body to be processed by using the above-described composition for forming an organic film;
forming a silicon-containing resist middle layer film on the organic film by using a silicon-containing resist middle layer film material;
forming a resist upper layer film on the silicon-containing resist middle layer film by using a resist upper layer film material including a photoresist composition;
forming a circuit pattern in the resist upper layer film;
transferring the pattern to the silicon-containing resist middle layer film by etching while using the resist upper layer film having the formed circuit pattern as a mask;
transferring the pattern to the organic film by etching while using the silicon-containing resist middle layer film having the transferred pattern as a mask; and
further transferring the pattern to the body to be processed by etching while using the organic film having the transferred pattern as a mask.

The body to be processed is preferably a semiconductor device substrate or the semiconductor device substrate coated with any of a metal film, a metal carbide film, a metal oxide film, a metal nitride film, a metal oxycarbide film, and a metal oxynitride film. The body to be processed is not particularly limited, but more specifically, may be a substrate made of Si, α-Si, p-Si, SiO₂, SiN, SiON, W, TiN, Al, etc.;
the substrate coated with the above-mentioned metal film or the like as a layer to be processed; etc.

Examples of the layer to be processed include various Low-k films made of Si, SiO₂, SiON, SiN, p-Si, α-Si, W, W-Si, Al, Cu, Al-Si, or the like; and stopper films thereof. Generally, the layer can be formed to have a thickness of preferably 50 to 10,000 nm, particularly preferably 100 to 5,000 nm. Note that when the layer to be processed is formed, the substrate and the layer to be processed are formed from different materials.

Incidentally, the metal constituting the body to be processed is preferably silicon, titanium, tungsten, hafnium, zirconium, chromium, germanium, copper, silver, gold, aluminum, indium, gallium, arsenic, palladium, iron, tantalum, iridium, molybdenum, or an alloy thereof.

When forming an organic film on the body to be processed by using the inventive composition for forming an organic film, the inventive method for forming an organic film described above can be adopted.

Subsequently, a resist middle layer film (silicon-containing resist middle layer film) is formed on the organic film by using a resist middle layer film material containing a silicon atom. As the resist middle layer film material containing a silicon atom, a polysiloxane-based middle layer film material is preferable. By imparting an antireflective effect to the silicon-containing resist middle layer film, reflection can be suppressed. Particularly, for 193-nm light exposure, a material containing many aromatic groups and having high etching selectivity relative to the substrate is used as a composition for forming an organic film, so that the k-value and thus the substrate reflection are increased; in contrast, the reflection can be suppressed by imparting absorption to the silicon-containing resist middle layer film so as to have an appropriate k-value, and the substrate reflection can be reduced to 0.5% or less. As the silicon-containing resist middle layer film having an antireflective effect, a polysiloxane is preferably used which has an anthryl group for 248-nm and 157-nm light exposure, or a phenyl group or a light-absorbing group having a silicon-silicon bond for 193-nm light exposure in a pendant structure, and which is crosslinked by an acid or heat.

Subsequently, a resist upper layer film is formed on the silicon-containing resist middle layer film by using a resist upper layer film material containing a photoresist composition. The resist upper layer film material may be a positive type or a negative type, and a photoresist composition that is normally used can be used. After the spin-coating with the resist upper layer film material, pre-baking is preferably performed at 60 to 180°C for 10 to 300 seconds. Then, light exposure, post-exposure baking (PEB), and development are performed according to conventional methods to obtain a resist upper layer film pattern. Note that the thickness of the resist upper layer film is not particularly limited, but is preferably 30 to 500 nm, particularly preferably 50 to 400 nm.

Subsequently, a circuit pattern (resist upper layer film pattern) is formed in the resist upper layer film. The circuit pattern is preferably formed by a lithography using light having a wavelength of 10 nm or more and 300 nm or less, a direct writing with electron beam, nanoimprinting, or a combination thereof.

Examples of exposure light include high-energy beams having a wavelength of 300 nm or less, specifically, deep ultraviolet ray, KrF excimer laser beam (248 nm), ArF excimer laser beam (193 nm), F₂ laser beam (157 nm), Kr₂ laser beam (146 nm), Ar₂ laser beam (126 nm), soft X-ray (EUV) of 3 to 20 nm, electron beam (EB), ion beam, X-ray, etc.

Furthermore, the circuit pattern is preferably developed with an alkaline development or an organic solvent.

Subsequently, the pattern is transferred to the silicon-containing resist middle layer film by etching while using the resist upper layer film having the formed circuit pattern as a mask. The etching of the silicon-containing resist middle layer film performed while using the resist upper layer film pattern as a mask is preferably performed by using a fluorocarbon-based gas. Thus, a silicon-containing resist middle layer film pattern is transferred.

Subsequently, the pattern is transferred to the organic film by etching while using the silicon-containing resist middle layer film having the transferred pattern as a mask. The silicon-containing resist middle layer film exhibits etching resistance to oxygen gas or hydrogen gas, and therefore, the etching of the organic film performed while using the silicon-containing resist middle layer film pattern as a mask is preferably performed by using an etching gas mainly containing oxygen gas or hydrogen gas. Thus, an organic film pattern is transferred.

Subsequently, the pattern is transferred to the body to be processed by etching while using the organic film having the transferred pattern as a mask. This etching of the body to be processed (layer to be processed) can be performed by a conventional method. For example, a body to be processed made of SiO₂, SiN, or silica low-dielectric insulating film is etched mainly with a fluorocarbon-based gas; and a body to be processed made of p-Si, Al, or W is etched mainly with a chlorine- or bromine-based gas. When the substrate is processed by etching with a fluorocarbon-based gas, the silicon-containing resist middle layer film pattern is removed when the substrate is processed. Meanwhile, when the substrate is processed by etching with a chlorine- or bromine-based gas, the silicon-containing resist middle layer film pattern needs to be removed by additional dry etching with a fluorocarbon-based gas after the substrate processing.

The organic film obtained by using the inventive composition for forming an organic film can be provided with excellent etching resistance when the body to be processed is etched as described above.

### [Four-Layer Resist Process Using Silicon-Containing Resist Middle Layer Film and Organic Antireflective Film or Adhesive Film]

The present invention also provides a patterning process including:
forming an organic film on a body to be processed by using the above-described composition for forming an organic film;
forming a silicon-containing resist middle layer film on the organic film by using a silicon-containing resist middle layer film material;
forming an organic antireflective film or an adhesive film on the silicon-containing resist middle layer film;
forming a resist upper layer film on the organic antireflective film or the adhesive film by using a resist upper layer film material including a photoresist composition;
forming a circuit pattern in the resist upper layer film;
transferring the pattern to the organic antireflective film or the adhesive film and the silicon-containing resist middle layer film by etching while using the resist upper layer film having the formed circuit pattern as a mask;
transferring the pattern to the organic film by etching while using the silicon-containing resist middle layer film having the transferred pattern as a mask; and
further transferring the pattern to the body to be processed by etching while using the organic film having the transferred pattern as a mask.

This method can be performed in the same manner as the three-layer resist process using the silicon-containing resist middle layer film, except that the organic antireflective film (BARC) or the adhesive film is formed between the silicon-containing resist middle layer film and the resist upper layer film.

The organic antireflective film and the adhesive film can be formed by spin-coating by using a known organic antireflective film material.

### [Three-Layer Resist Process Using Inorganic Hard Mask Middle Layer Film]

The present invention also provides a patterning process including:
forming an organic film on a body to be processed by using the above-described composition for forming an organic film;
forming an inorganic hard mask middle layer film selected from a silicon oxide film, a silicon nitride film, and a silicon oxynitride film on the organic film;
forming a resist upper layer film on the inorganic hard mask middle layer film by using a resist upper layer film material including a photoresist composition;
forming a circuit pattern in the resist upper layer film;
transferring the pattern to the inorganic hard mask middle layer film by etching while using the resist upper layer film having the formed circuit pattern as a mask;
transferring the pattern to the organic film by etching while using the inorganic hard mask middle layer film having the transferred pattern as a mask; and
further transferring the pattern to the body to be processed by etching while using the organic film having the transferred pattern as a mask.

This method can be performed in the same manner as the three-layer resist process using the silicon-containing resist middle layer film, except that the inorganic hard mask middle layer film is formed instead of the silicon-containing resist middle layer film on the organic film.

The inorganic hard mask middle layer film selected from a silicon oxide film, a silicon nitride film, and a silicon oxynitride film (SiON film) can be formed by a CVD method, an ALD method, etc. Methods for forming the silicon nitride film are, for example, disclosed in JP 2002-334869 A, WO 2004/066377 A1, etc. The inorganic hard mask middle layer film preferably has a thickness of 5 to 200 nm, more preferably 10 to 100 nm. As the inorganic hard mask middle layer film, a SiON film, which has a high function as an antireflective film, is the most preferably used.

### [Four-Layer Resist Process Using Inorganic Hard Mask Middle Layer Film and Organic Antireflective Film or Adhesive Film]

The present invention also provides a patterning process including:
forming an organic film on a body to be processed by using the above-described composition for forming an organic film;
forming an inorganic hard mask middle layer film selected from a silicon oxide film, a silicon nitride film, and a silicon oxynitride film on the organic film;
forming an organic antireflective film or an adhesive film on the inorganic hard mask middle layer film;
forming a resist upper layer film on the organic antireflective film or the adhesive film by using a resist upper layer film material including a photoresist composition;
forming a circuit pattern in the resist upper layer film;
transferring the pattern to the organic antireflective film or the adhesive film and the inorganic hard mask middle layer film by etching while using the resist upper layer film having the formed circuit pattern as a mask;
transferring the pattern to the organic film by etching while using the inorganic hard mask middle layer film having the transferred pattern as a mask; and
further transferring the pattern to the body to be processed by etching while using the organic film having the transferred pattern as a mask.

This method can be performed in the same manner as the three-layer resist method using the inorganic hard mask middle layer film, except that the organic antireflective film (BARC) or the adhesive film is formed between the inorganic hard mask middle layer film and the resist upper layer film.

Particularly, when a SiON film is used as the inorganic hard mask middle layer film, two antireflective films including the SiON film and the BARC make it possible to suppress the reflection even in liquid immersion exposure at a high NA exceeding 1.0. Another merit of forming the BARC is having an effect of reducing trailing of the resist upper layer film pattern immediately above the SiON film.

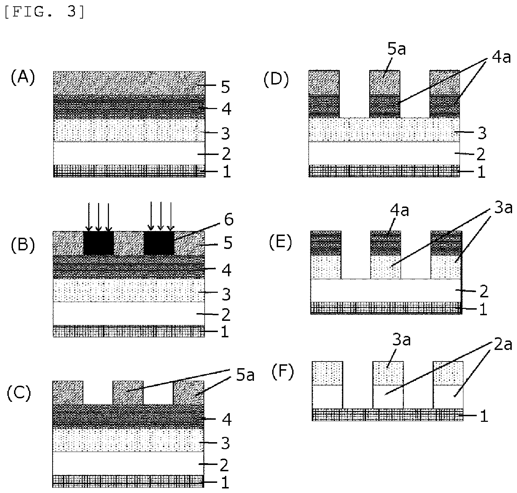

Here, an example of the inventive patterning processes according to a three-layer resist process is shown in FIG. 3 (A) to (F). In the case of a three-layer resist process, as shown in FIG. 3 (A), an organic film 3 is formed by using the inventive composition for forming an organic film on a layer 2 to be processed formed on a substrate 1; then, a silicon-containing resist middle layer film 4 is formed; and a resist upper layer film 5 is formed thereon. Next, as shown in FIG. 3 (B), an exposure portion 6 of the resist upper layer film 5 is exposed, and PEB (post-exposure baking) is performed. Next, as shown in FIG. 3 (C), development is performed to form a resist upper layer film pattern 5a. Next, as shown in FIG. 3 (D), a silicon-containing resist middle layer film 4 is dry-etched by using a fluorocarbon-based gas while using the resist upper layer film pattern 5a as a mask, and thus, a silicon-containing resist middle layer film pattern 4a is formed. Next, as shown in FIG. 3 (E), the resist upper layer film pattern 5a is removed, then the organic film 3 is etched with oxygen plasma while using the silicon-containing resist middle layer film pattern 4a as a mask, and thus, an organic film pattern 3a is formed. Furthermore, as shown in FIG. 3 (F), the silicon-containing resist middle layer film pattern 4a is removed, then the layer 2 to be processed is etched while using the organic film pattern 3a as a mask, and thus, a pattern 2a is formed. By humps being suppressed when the organic film is formed, it is possible to reduce defects that are generated due to humps of the organic film during the dry etching of FIG. 3 (D), (E), and (F).

In a case where an inorganic hard mask middle layer film is formed, the silicon-containing resist middle layer film 4 can be changed to an inorganic hard mask middle layer film, and in a case where a BARC or an adhesive film is formed, the BARC or the adhesive film can be formed between the silicon-containing resist middle layer film 4 and the resist upper layer film 5. The etching of the BARC or the adhesive film may be performed continuously before the etching of the silicon-containing resist middle layer film 4; alternatively, after the BARC or the adhesive film alone is etched, the etching apparatus may be changed and so forth, and then the etching of the silicon-containing resist middle layer film 4 may be performed.

As described above, the inventive patterning processes make it possible to form a fine pattern in a body to be processed with high precision according to a multilayer resist process, and to suppress hump formation on an organic film, thus reducing defects derived from humps of the organic film.

### EXAMPLES

Hereinafter, the present invention will be further specifically described with reference to Synthesis Examples, Comparative Synthesis Examples, Examples, and Comparative Examples. However, the present invention is not limited thereto. Note that, specifically, the molecular weight was measured in the following manner. Weight-average molecular weight (Mw) and number-average molecular weight (Mn) on polystyrene basis were measured by gel permeation chromatography (GPC) using tetrahydrofuran as an eluent (solvent), and dispersity (Mw/Mn) was calculated therefrom.

### [Synthesis of Polymers (A1) to (A25)]

For the synthesis of polymers (A1) to (A25), used for the preparation of compositions for forming an organic film, the following diol compounds (B1) to (B22), divinyl ether compounds (C1) to (C4), and alcohol compounds (D1) to (D3) were used.

### (Diol compounds)

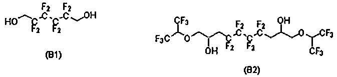

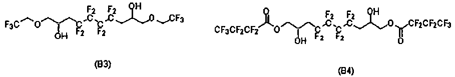

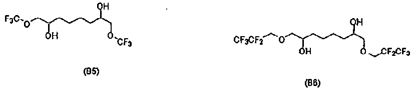

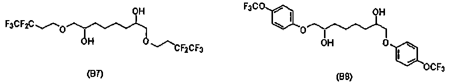

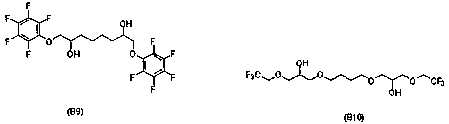

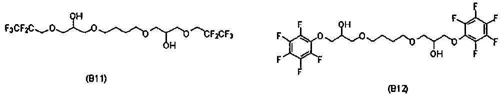

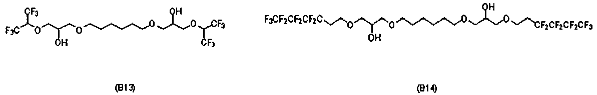

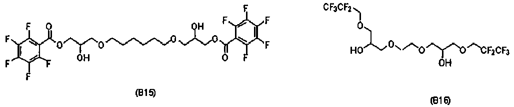

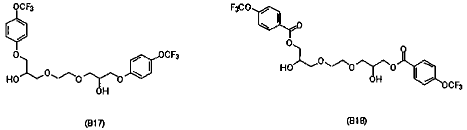

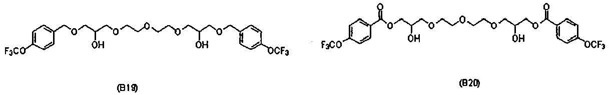

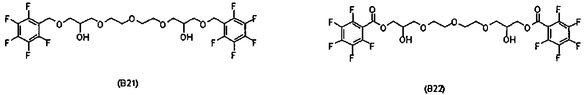

### (Divinyl ether compounds)

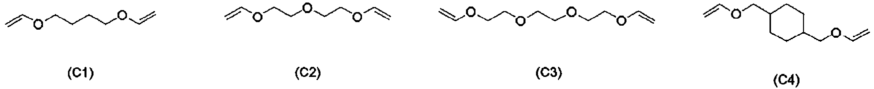

### (Alcohol compounds)

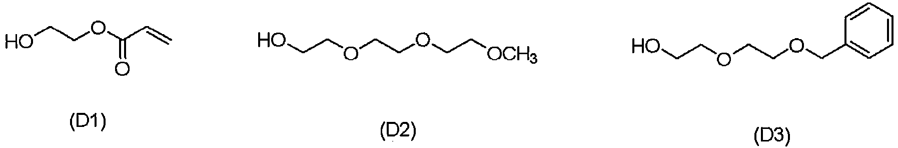

For the synthesis of the diol compounds (B2) to (B22), the following epoxy compounds (E1) to (E6) and fluorine-containing alcohol compounds and carboxylic acid compounds (F1) to (F13) were used. The method for synthesizing the diol compound differs depending on whether the diol compound contains an ether structure as in (B2), (B3), (B5) to (B14), (B16), (B17), (B19), and (B21) or contains an ester structure as in (B4), (B15), (B18), (B20), and (B22). Each method is described below. As the diol compound (B1), commercially available 2,2,3,3,4,4,5,5-octafluoro-1,6-hexanediol was used.

### (Epoxy compounds)

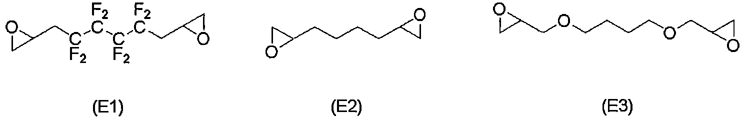

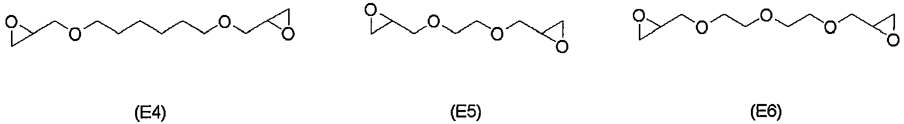

### (Fluorine-containing alcohols and carboxylic acid compounds)

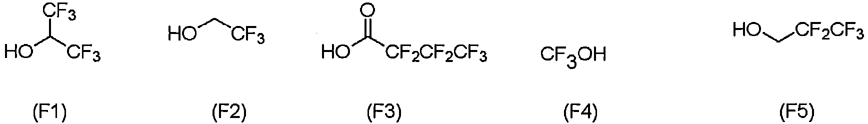

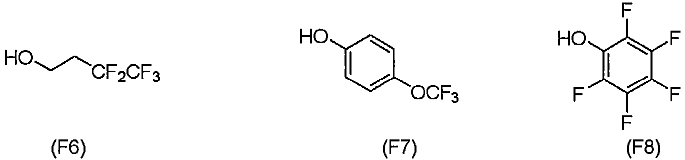

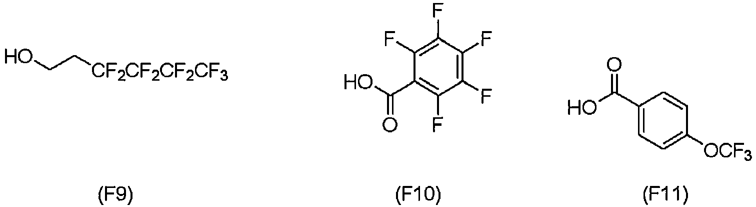

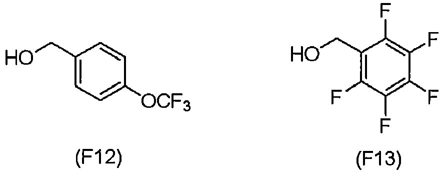

### [Synthesis Example 1] Synthesis of Diol Compound (B2) Containing Ether Structure

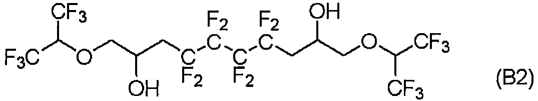

Under a nitrogen atmosphere, 100.0 g of THF (tetrahydrofuran) and 32.1 g (190.9 mmol) of the alcohol compound (F1) were added together and stirred in an ice bath to form a homogeneous solution. Then, 21.4 g (190.9 mmol) of potassium t-butoxide was added thereto and the mixture was stirred to form a homogeneous solution. After that, a mixed solution of 20.0 g (63.6 mmol) of the epoxy compound (E1) and 20.0 g of THF was added dropwise over 30 minutes, and then a reaction was allowed to take place at an internal temperature of 60°C for 24 hours. After cooling the reaction solution to room temperature, the reaction was quenched with 100 ml of ultrapure water, the solution was diluted with 300 ml of toluene, and the separated lower layer was removed. The product was washed twice with 100 g of a 5% aqueous potassium hydroxide solution, twice with 100 ml of ultrapure water and 100 ml of a 3.0% aqueous nitric acid solution, and five times with 100 g of ultrapure water in this order, and then the organic layer was evaporated under reduced pressure to dryness to obtain the diol compound (B2).

### [Synthesis Example 2] Synthesis of Diol Compound (B4) Containing Ester Structure

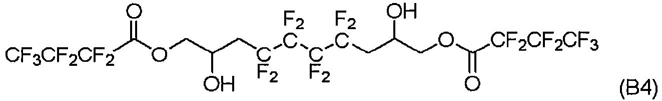

Under a nitrogen atmosphere, 20.0 g (63.6 mmol) of the epoxy compound (E1), 28.6 g (133.6 mmol) of the carboxylic acid compound (F3), 1.5 g (6.4 mmol) of benzyltriethylammonium chloride, and 100 g of 2-methoxy-1-propanol were added together to form a homogeneous solution at an internal temperature of 80°C, and then the solution was further stirred at an internal temperature of 100°C for 24 hours. After cooling the solution to room temperature, 200 ml of toluene was added thereto, and the product was washed twice with 100 g of a 3% aqueous solution of NaHCOs, twice with 100 g of ultrapure water and 100 g of a 3% aqueous nitric acid solution, and five times with 100 g of ultrapure water in this order. Then, the organic layer was evaporated under reduced pressure to dryness to obtain the diol compound (B4).

The diol compounds (B2) to (B22) were obtained as products under the same reaction conditions as in Synthesis Example 1 or Synthesis Example 2, except that the epoxy compound and the alcohol compound or carboxylic acid compound shown in Table 1 were used. The synthesis method (Synthesis Example 1 or 2) used for synthesizing the diol is also shown in the table.

**[Table 1]**

| Diol compound | Epoxy compound | Used amount (g) | Alcohol compound and carboxylic acid compound | Used amount (g) | Used synthesis method |
|---|---|---|---|---|---|
| B2 | E1 | 20.0 | F1 | 32.1 | Synthesis Example 1 |
| B3 | E1 | 20.0 | F2 | 19.1 | Synthesis Example 1 |
| B4 | E1 | 20.0 | F3 | 28.6 | Synthesis Example 2 |
| B5 | E2 | 9.1 | F4 | 16.4 | Synthesis Example 1 |
| B6 | E2 | 9.1 | F5 | 28.7 | Synthesis Example 1 |
| B7 | E2 | 9.1 | F6 | 31.3 | Synthesis Example 1 |
| B8 | E2 | 9.1 | F7 | 34.0 | Synthesis Example 1 |
| B9 | E2 | 9.1 | F8 | 35.2 | Synthesis Example 1 |
| B10 | E3 | 12.9 | F2 | 19.1 | Synthesis Example 1 |
| B11 | E3 | 12.9 | F5 | 28.7 | Synthesis Example 1 |
| B12 | E3 | 12.9 | F8 | 35.2 | Synthesis Example 1 |
| B13 | E4 | 14.7 | F1 | 32.1 | Synthesis Example 1 |
| B14 | E4 | 14.7 | F9 | 50.4 | Synthesis Example 1 |
| B15 | E4 | 14.7 | F10 | 28.3 | Synthesis Example 2 |
| B16 | E5 | 11.1 | F5 | 28.7 | Synthesis Example 1 |
| B17 | E5 | 11.1 | F7 | 34.0 | Synthesis Example 1 |
| B18 | E5 | 11.1 | F11 | 39.4 | Synthesis Example 2 |
| B19 | E6 | 13.9 | F12 | 36.7 | Synthesis Example 1 |
| B20 | E6 | 13.9 | F11 | 27.5 | Synthesis Example 2 |
| B21 | E6 | 13.9 | F13 | 37.8 | Synthesis Example 1 |
| B22 | E6 | 13.9 | F10 | 28.3 | Synthesis Example 2 |

### [Synthesis Example 3] Synthesis of Polymer (A1)

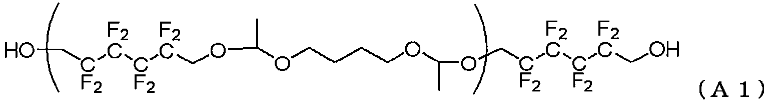

Under a nitrogen atmosphere, to a mixture of 0.81 g of a cation exchange resin (AMBERLYST (registered trademark) 15 DRY) and 30 g of ethyl acetate, 10.0 g (38.2 mmol) of the diol compound (B1) was added and the mixture was stirred at room temperature to form a homogeneous dispersion. 5.2 g (36.3 mmol) of the divinyl ether compound (C1) was added dropwise thereto over 20 minutes, and then the mixture was stirred at room temperature for 5 hours. 0.8 g (7.6 mmol) of triethylamine was added thereto to terminate the reaction, and then the cation exchange resin was removed by filtration. The filtrate was concentrated under reduced pressure to obtain a polymer (A1) as a highly viscous liquid. Mw=5200, Mw/Mn=2.73.

### [Synthesis Examples 4 to 24] Synthesis of Polymers (A2) to (A22)

Polymers (A2) to (A22), shown in Table 2, were obtained as products under the same reaction conditions as in Synthesis Example 3, except that the diol compound and the divinyl ether compound shown in Table 2 were used.

The used starting materials of the above-described Synthesis Examples 3 to 24 are shown together in Table 2.

**[Table 2]**

| Synthesis Example | Polymer | Diol compound | Used amount (g) | Divinyl ether compound | Used amount (g) |
|---|---|---|---|---|---|
| 3 | A1 | B1 | 10.0 | C1 | 5.2 |
| 4 | A2 | B2 | 24.8 | C1 | 5.2 |
| 5 | A3 | B3 | 19.6 | C2 | 5.7 |
| 6 | A4 | B4 | 28.3 | C3 | 7.3 |
| 7 | A5 | B5 | 12.0 | C1 | 5.2 |
| 8 | A6 | B6 | 16.9 | C2 | 5.7 |
| 9 | A7 | B7 | 17.9 | C3 | 7.3 |
| 10 | A8 | B8 | 19.0 | C1 | 5.2 |
| 11 | A9 | B9 | 19.5 | C4 | 7.1 |
| 12 | A10 | B10 | 15.4 | C1 | 5.2 |
| 13 | A11 | B11 | 19.2 | C2 | 5.7 |
| 14 | A12 | B12 | 21.8 | C3 | 7.3 |
| 15 | A13 | B13 | 21.6 | C1 | 5.2 |
| 16 | A14 | B14 | 28.9 | C2 | 5.7 |
| 17 | A15 | B15 | 25.0 | C3 | 7.3 |
| 18 | A16 | B16 | 18.1 | C1 | 5.2 |
| 19 | A17 | B17 | 20.2 | C2 | 5.7 |
| 20 | A18 | B18 | 22.4 | C3 | 7.3 |
| 21 | A19 | B19 | 23.0 | C4 | 7.1 |
| 22 | A20 | B20 | 24.1 | C1 | 5.2 |
| 23 | A21 | B21 | 23.4 | C2 | 5.7 |
| 24 | A22 | B22 | 24.5 | C3 | 7.3 |

### [Synthesis Example 25] Synthesis of Polymer (A23)

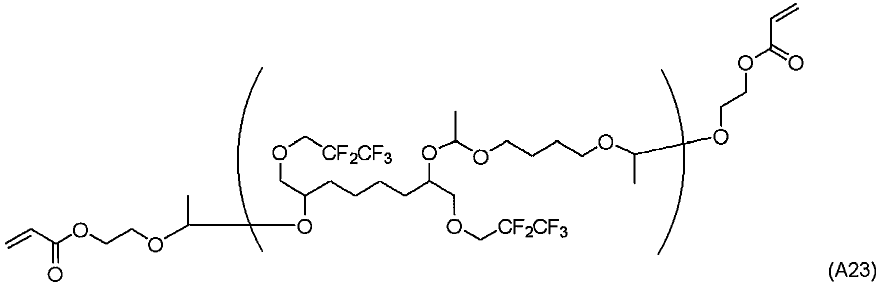

Under a nitrogen atmosphere, to a mixture of 0.81 g of a cation exchange resin (AMBERLYST (registered trademark) 15 DRY) and 30 g of ethyl acetate, 16.9 g (38.2 mmol) of the diol compound (B6) was added and the mixture was stirred at room temperature to form a homogeneous dispersion. 6.0 g (42.0 mmol) of the divinyl ether compound (C1) was added dropwise thereto over 20 minutes, and then the mixture was stirred at room temperature for 3 hours. Subsequently, 0.9 g of the alcohol compound (D1) was added dropwise thereto over 10 minutes, and the mixture was further stirred at room temperature for 3 hours. 0.8 g (7.6 mmol) of triethylamine was added thereto to terminate the reaction, and then the cation exchange resin was removed by filtration. The filtrate was concentrated under reduced pressure to obtain a polymer (A23) as a highly viscous liquid. Mw=8800, Mw/Mn=2.53.

### [Synthesis Example 26] Synthesis of Polymer (A24)

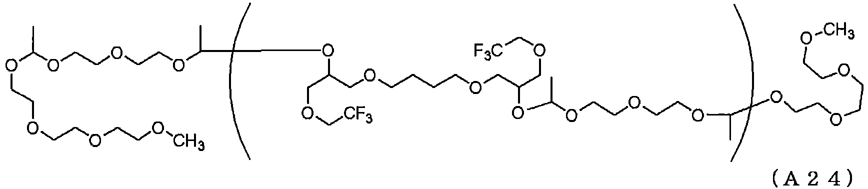

Under a nitrogen atmosphere, to a mixture of 0.81 g of a cation exchange resin (AMBERLYST (registered trademark) 15 DRY) and 30 g of ethyl acetate, 15.4 g (38.2 mmol) of the diol compound (B10) was added and the mixture was stirred at room temperature to form a homogeneous dispersion. 6.6 g (42.0 mmol) of the divinyl ether compound (C2) was added dropwise thereto over 20 minutes, and then the mixture was stirred at room temperature for 3 hours. Subsequently, 1.3 g of the alcohol compound (D2) was added dropwise thereto over 10 minutes, and the mixture was further stirred at room temperature for 3 hours. 0.8 g (7.6 mmol) of triethylamine was added thereto to terminate the reaction, and then the cation exchange resin was removed by filtration. The filtrate was concentrated under reduced pressure to obtain a polymer (A24) as a highly viscous liquid. Mw=8000, Mw/Mn=2.19.

### [Synthesis Example 27] Synthesis of Polymer (A25)

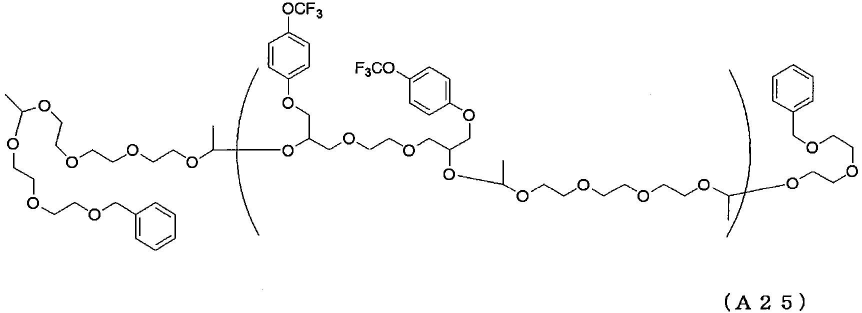

Under a nitrogen atmosphere, to a mixture of 0.81 g of a cation exchange resin (AMBERLYST (registered trademark) 15 DRY) and 30 g of ethyl acetate, 20.2 g (38.2 mmol) of the diol compound (B17) was added and the mixture was stirred at room temperature to form a homogeneous dispersion. 8.5 g (42.0 mmol) of the divinyl ether compound (C3) was added dropwise thereto over 20 minutes, and then the mixture was stirred at room temperature for 3 hours. Subsequently, 1.6 g of the alcohol compound (D3) was added dropwise thereto over 10 minutes, and the mixture was further stirred at room temperature for 3 hours. 0.8 g (7.6 mmol) of triethylamine was added thereto to terminate the reaction, and then the cation exchange resin was removed by filtration. The filtrate was concentrated under reduced pressure to obtain a polymer (A25) as a highly viscous liquid. Mw=10500, Mw/Mn=1.93.

The structural formula, the weight-average molecular weight (Mw), and the dispersity (Mw/Mn) of the polymers obtained in Synthesis Examples 3 to 27 were determined, and are shown in Tables 3 to 8.

**[Table 3]**

| Synthesis Example | Polymer | Mw | Mw /Mn |
|---|---|---|---|
| 3 | 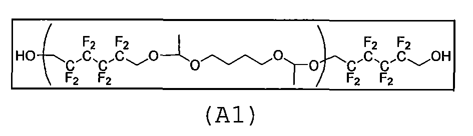 | 5200 | 2.73 |
| 4 | 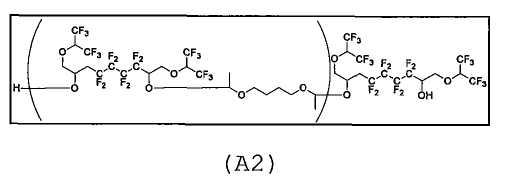 | 12600 | 2.45 |
| 5 | 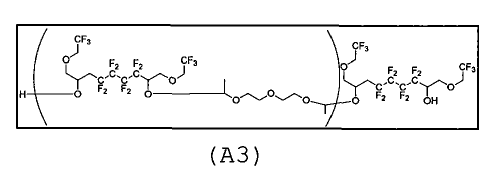 | 10000 | 2.19 |
| 6 | 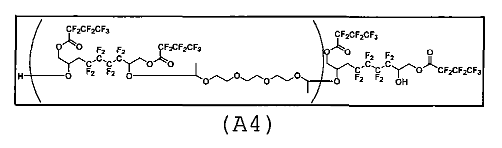 | 14400 | 3.07 |

**[Table 4]**

| Synthesis Example | Polymer | Mw | Mw /Mn |
|---|---|---|---|
| 7 | 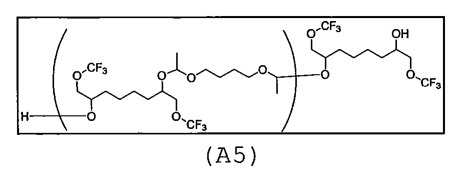 | 6200 | 2.84 |
| 8 | 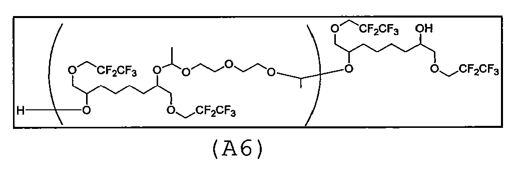 | 8800 | 3.02 |
| 9 | 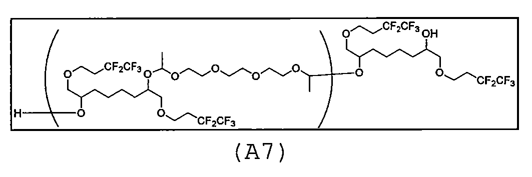 | 9300 | 2.3 |
| 10 | 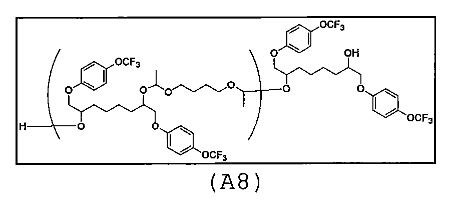 | 9900 | 2.26 |

**[Table 5]**

| Synthesis Example | Polymer | Mw | Mw /Mn |
|---|---|---|---|
| 11 | 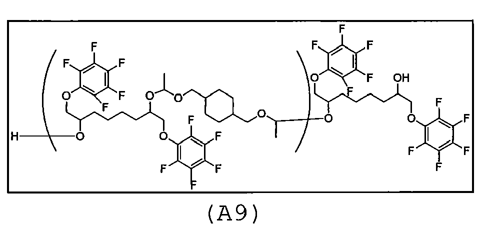 | 10100 | 3.07 |
| 12 | 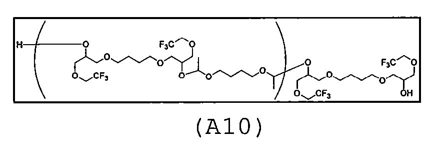 | 8000 | 2.62 |
| 13 | 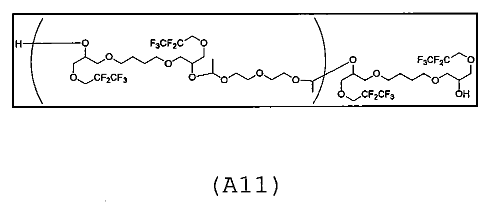 | 10100 | 2.22 |
| 14 | 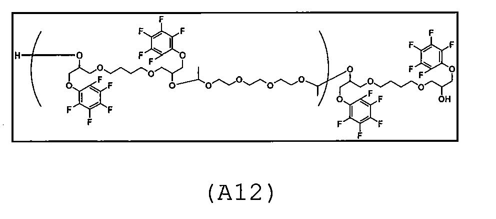 | 11300 | 2.46 |
| 15 | 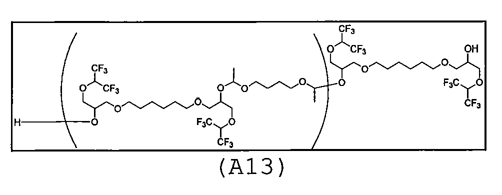 | 11200 | 3.17 |

**[Table 6]**

| Synthesis Example | Polymer | Mw | Mw /Mn |
|---|---|---|---|
| 16 | 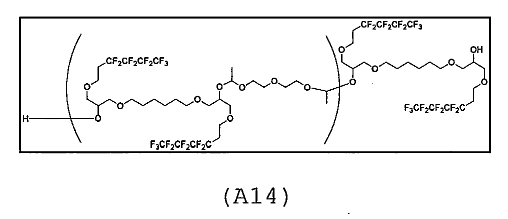 | 15000 | 3.19 |
| 17 | 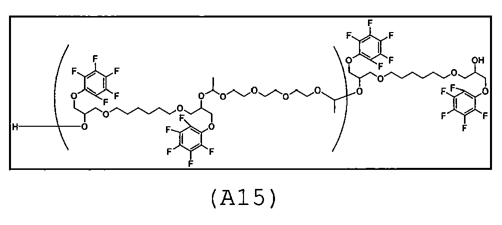 | 13000 | 2.75 |
| 18 | 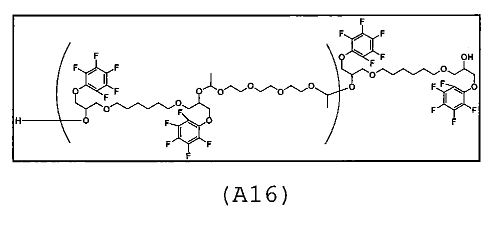 | 9400 | 2.09 |

**[Table 7]**

| Synthesis Example | Polymer | Mw | Mw /Mn |
|---|---|---|---|
| 19 | 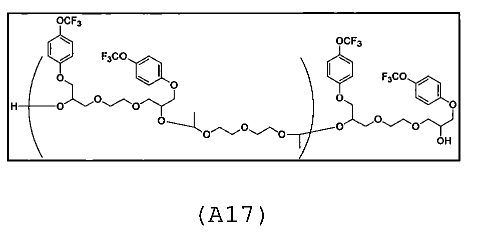 | 10500 | 3.12 |
| 20 | 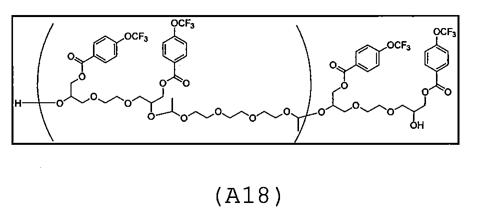 | 11600 | 2.21 |
| 21 | 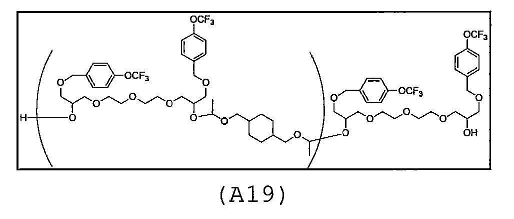 | 12000 | 2.86 |
| 22 | 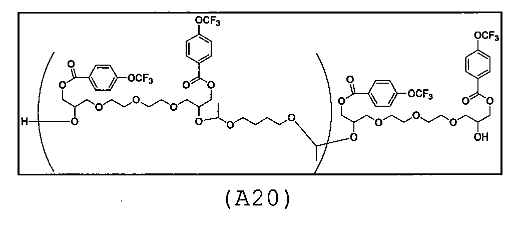 | 12500 | 3 |
| 23 | 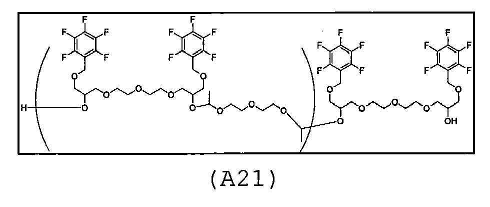 | 12200 | 2.21 |

**[Table 8]**

| Synthesis Example | Polymer | Mw | Mw /Mn |
|---|---|---|---|
| 24 | 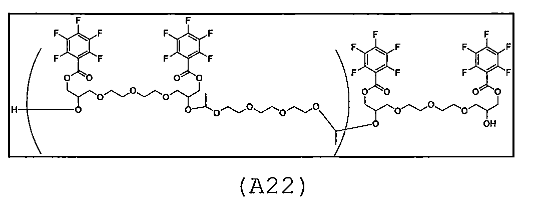 | 12700 | 2.7 |
| 25 | 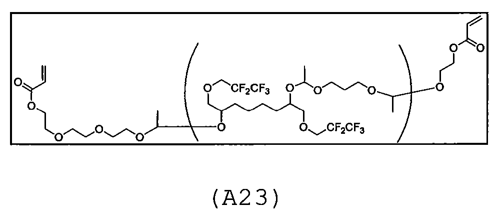 | 8800 | 2.45 |
| 26 | 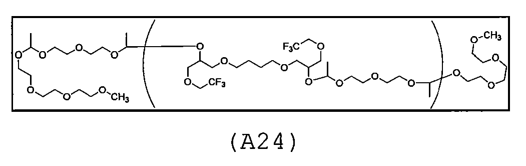 | 8000 | 2.19 |
| 27 | 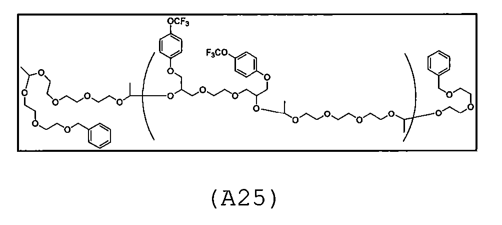 | 10500 | 1.93 |

### [Synthesis of Comparative Polymers (R1) to (R6)]

For the synthesis of comparative polymers (R1) to (R6), used for the preparation of compositions for forming an organic film, the following monomers (b1) to (b7) and the divinyl ether (C1) described above were used.

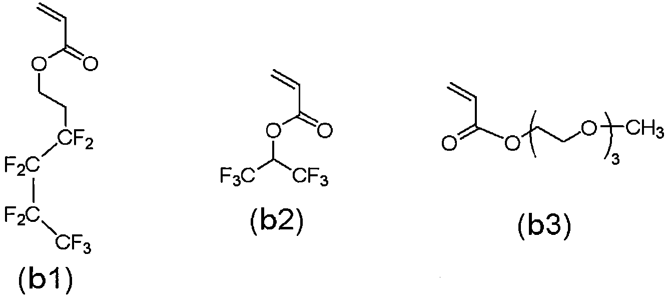

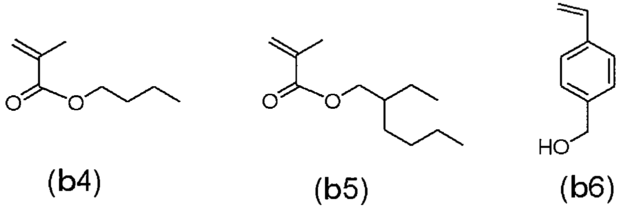

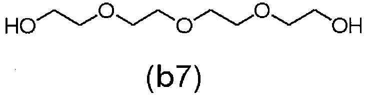

### [Comparative Synthesis Example 1] Synthesis of Comparative Polymer (R1)

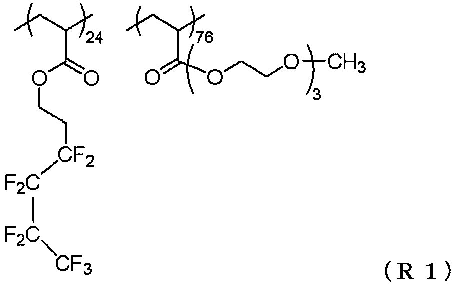

Under a nitrogen atmosphere, 6.0 g of propylene glycol monomethyl ether acetate (PGMEA) was heated and stirred at 80°C. A mixture of 3.44 g (0.011 mol) of (b1), 7.46 g (0.034 mol) of (b3), 0.473 g of dimethyl-2,2-azobis(2-methylpropionate), and 34 g of PGMEA was added dropwise thereto over 4 hours. The mixture was further heated and stirred for 16 hours, and then cooled to room temperature. Thus, a PGMEA solution of the target polymer (R1) was obtained.

The weight-average molecular weight (Mw) and the dispersity (Mw/Mn) were determined by GPC, and the following results were obtained. (R1): Mw=9500, Mw/Mn=1.20

### [Comparative Synthesis Example 2] Synthesis of Comparative Polymer (R2)

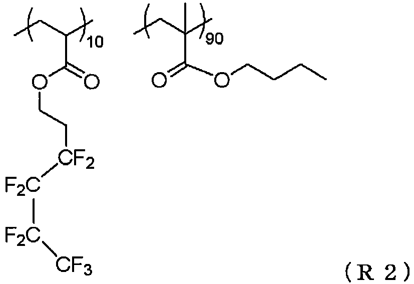

Under a nitrogen atmosphere, 6.0 g of propylene glycol monomethyl ether acetate (PGMEA) was heated and stirred at 80°C. A mixture of 1.43 g (0.005 mol) of (b1), 5.76 g (0.041 mol) of (b4), 0.473 g of dimethyl-2,2-azobis(2-methylpropionate), and 34 g of PGMEA was added dropwise thereto over 4 hours. The mixture was further heated and stirred for 16 hours, and then cooled to room temperature. Thus, a PGMEA solution of the target polymer (R2) was obtained.

The weight-average molecular weight (Mw) and the dispersity (Mw/Mn) were determined by GPC, and the following results were obtained. (R2): Mw=5800, Mw/Mn=1.42

### [Comparative Synthesis Example 3] Synthesis of Comparative Polymer (R3)

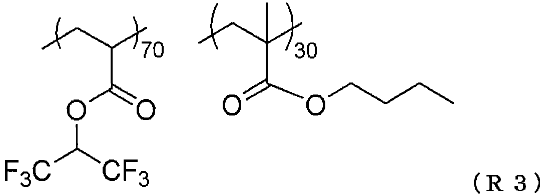

Under a nitrogen atmosphere, 6.0 g of propylene glycol monomethyl ether acetate (PGMEA) was heated and stirred at 80°C. A mixture of 7.00 g (0.032 mol) of (b2), 1.92 g (0.014 mol) of (b4), 0.473 g of dimethyl-2,2-azobis(2-methylpropionate), and 34 g of PGMEA was added dropwise thereto over 4 hours. The mixture was further heated and stirred for 16 hours, and then cooled to room temperature. Thus, a PGMEA solution of the target polymer (R3) was obtained.

The weight-average molecular weight (Mw) and the dispersity (Mw/Mn) were determined by GPC, and the following results were obtained. (R3): Mw=6200, Mw/Mn=1.33

### [Comparative Synthesis Example 4] Synthesis of Comparative Polymer (R4)

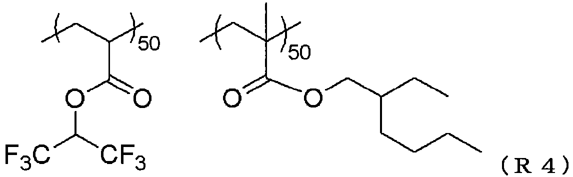

Under a nitrogen atmosphere, 6.0 g of propylene glycol monomethyl ether acetate (PGMEA) was heated and stirred at 80°C. A mixture of 5.00 g (0.023 mol) of (b2), 3.20 g (0.023 mol) of (b5), 0.473 g of dimethyl-2,2-azobis(2-methylpropionate), and 34 g of PGMEA was added dropwise thereto over 4 hours. The mixture was further heated and stirred for 16 hours, and then cooled to room temperature. Thus, a PGMEA solution of the target polymer (R4) was obtained.

The weight-average molecular weight (Mw) and the dispersity (Mw/Mn) were determined by GPC, and the following results were obtained. (R4): Mw=8300, Mw/Mn=1.33

### [Comparative Synthesis Example 5] Synthesis of Comparative Polymer (R5)

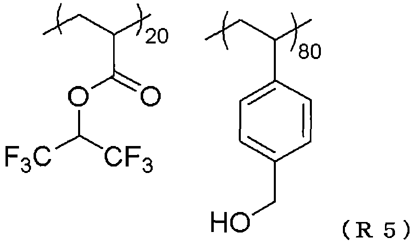

Under a nitrogen atmosphere, 6.0 g of propylene glycol monomethyl ether acetate (PGMEA) was heated and stirred at 80°C. A mixture of 2.00 g (0.009 mol) of (b2), 5.41 g (0.036 mol) of (b6), 0.473 g of dimethyl-2,2-azobis(2-methylpropionate), and 34 g of PGMEA was added dropwise thereto over 4 hours. The mixture was further heated and stirred for 16 hours, and then cooled to room temperature. Thus, a PGMEA solution of the target polymer (R5) was obtained.

The weight-average molecular weight (Mw) and the dispersity (Mw/Mn) were determined by GPC, and the following results were obtained. (R5): Mw=3800, Mw/Mn=1.44

### [Comparative Synthesis Example 6] Synthesis of

### Comparative Polymer (R6)

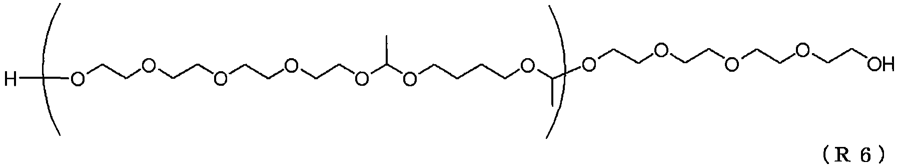

Under a nitrogen atmosphere, to a mixture of 0.81 g of a cation exchange resin (AMBERLYST (registered trademark) 15 DRY) and 30 g of ethyl acetate, 7.4 g (38.2 mmol) of the compound (b7) was added and the mixture was stirred at room temperature to form a homogeneous dispersion. 5.3 g (37.4 mmol) of the divinyl ether compound (C1) was added dropwise thereto over 20 minutes, and then the mixture was stirred at room temperature for 5 hours. 0.8 g (7.6 mmol) of triethylamine was added thereto to terminate the reaction, and then the cation exchange resin was removed by filtration. The filtrate was concentrated under reduced pressure to obtain a polymer (R6) as a highly viscous liquid. (R6): Mw=8200, Mw/Mn=2.77.

### [Materials for Forming Organic Film (Resin or Compound)]

M1: a resin represented by the following formula (M1) M2: a resin represented by the following formula (M2) M3: a compound represented by the following formula (M3) M4: a compound represented by the following formula (M4) M5: a resin represented by the following formula (M5) M6: a resin represented by the following formula (M6)

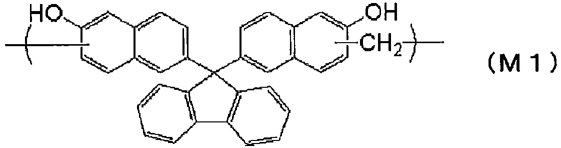

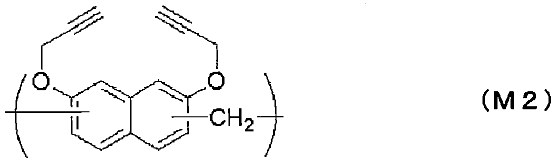

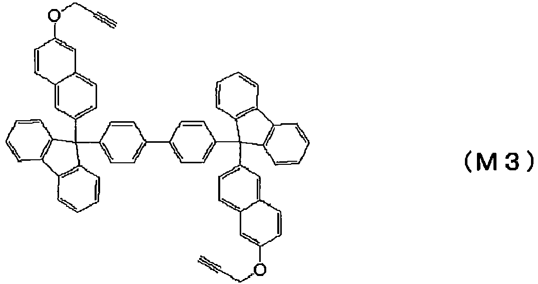

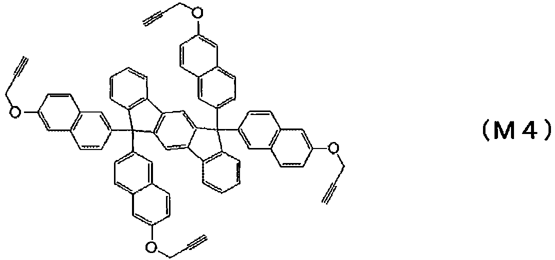

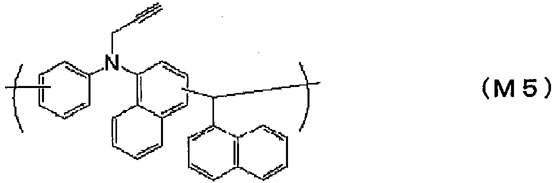

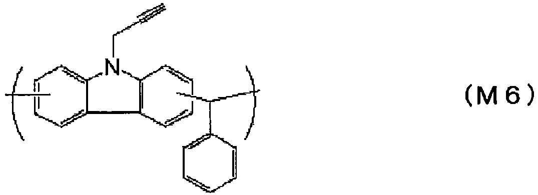

### [Solvents]

(S1): propylene glycol monomethyl ether acetate
(S2): propylene glycol monoethyl ether

### [Preparation of Compositions (UDL-1 to -155 and Comparative UDL-1 to -17) for Forming Organic Film]

The polymers (A1) to (A25) and (R1) to (R6), materials (M1) to (M6) for forming an organic film, and solvents were dissolved in the proportions shown in Tables 9 to 13. Then, the solutions were filtered through a 0.1-µm filter made of a fluorinated resin to prepare compositions (resist underlayer film materials: UDL-1 to -155 and comparative UDL-1 to -17) for forming an organic film.

**[Table 9]**

| Composition for forming organic film | Material for forming organic film | | Polymer | | Solvent 1 | | Solvent 2 | |
|---|---|---|---|---|---|---|---|---|
| | Type | Parts by mass | Type | Parts by mass | Type | Parts by mass | Type | Parts by mass |
| UDL-1 | (M1) | 10.00 | (A1) | 0.10 | (S1) | 89.90 | | |
| UDL-2 | (M1) | 10.00 | (A2) | 0.10 | (S1) | 89.90 | | |
| UDL-3 | (M1) | 10.00 | (A3) | 0.10 | (S1) | 89.90 | | |
| UDL-4 | (M1) | 10.00 | (A4) | 0.10 | (S1) | 89.90 | | |
| UDL-5 | (M1) | 10.00 | (A5) | 0.10 | (S1) | 89.90 | | |
| UDL-6 | (M1) | 10.00 | (A6) | 0.10 | (S1) | 89.90 | | |
| UDL-7 | (M1) | 10.00 | (A7) | 0.10 | (S1) | 89.90 | | |
| UDL-8 | (M1) | 10.00 | (A8) | 0.10 | (S1) | 89.90 | | |
| UDL-9 | (M1) | 10.00 | (A9) | 0.10 | (S1) | 89.90 | | |
| UDL-10 | (M1) | 10.00 | (A10) | 0.10 | (S1) | 89.90 | | |
| UDL-11 | (M1) | 10.00 | (A11) | 0.10 | (S1) | 89.90 | | |
| UDL-12 | (M1) | 10.00 | (A12) | 0.10 | (S1) | 89.90 | | |
| UDL-13 | (M1) | 10.00 | (A13) | 0.10 | (S1) | 89.90 | | |
| UDL-14 | (M1) | 10.00 | (A14) | 0.10 | (S1) | 89.90 | | |
| UDL-15 | (M1) | 10.00 | (A15) | 0.10 | (S1) | 89.90 | | |
| UDL-16 | (M1) | 10.00 | (A16) | 0.10 | (S1) | 89.90 | | |
| UDL-17 | (M1) | 10.00 | (A17) | 0.10 | (S1) | 89.90 | | |
| UDL-18 | (M1) | 10.00 | (A18) | 0.10 | (S1) | 89.90 | | |
| UDL-19 | (M1) | 10.000 | (A19) | 0.10 | (S1) | 89.90 | | |
| UDL-20 | (M1) | 10.00 | (A20) | 0.10 | (S1) | 89.90 | | |
| UDL-21 | (M1) | 10.00 | (A21) | 0.10 | (S1) | 89.90 | | |
| UDL-22 | (M1) | 10.00 | (A22) | 0.10 | (S1) | 89.90 | | |
| UDL-23 | (M1) | 10.00 | (A23) | 0.10 | (S1) | 89.90 | | |
| UDL-24 | (M1) | 10.00 | (A24) | 0.10 | (S1) | 89.90 | | |
| UDL-25 | (M1) | 10.00 | (A25) | 0.10 | (S1) | 89.90 | | |
| UDL-26 | (M1) | 10.00 | (A5) | 0.10 | (S1) | 62.93 | (S2) | 26.97 |
| UDL-27 | (M1) | 10.00 | (A6) | 0.10 | (S1) | 62.93 | (S2) | 26.97 |
| UDL-28 | (M1) | 10.00 | (A8) | 0.10 | (S1) | 62.93 | (S2) | 26.97 |
| UDL-29 | (M1) | 10.00 | (A10) | 0.10 | (S1) | 62.93 | (S2) | 26.97 |
| UDL-30 | (M1) | 10.00 | (A11) | 0.10 | (S1) | 62.93 | (S2) | 26.97 |
| UDL-31 | (M2) | 10.00 | (A1) | 0.10 | (S1) | 89.90 | | |
| UDL-32 | (M2) | 10.00 | (A2) | 0.10 | (S1) | 89.90 | | |
| UDL-33 | (M2) | 10.00 | (A3) | 0.10 | (S1) | 89.90 | | |
| UDL-34 | (M2) | 10.00 | (A4) | 0.10 | (S1) | 89.90 | | |
| UDL-35 | (M2) | 10.00 | (A5) | 0.10 | (S1) | 89.90 | | |

**[Table 10]**

| Composition for forming organic film | Material for forming organic film | | Polymer | | Solvent 1 | | Solvent 2 | |
|---|---|---|---|---|---|---|---|---|
| | Type | Parts by mass | Type | Parts by mass | Type | Parts by mass | Type | Parts by mass |
| UDL-36 | (M2) | 10.00 | (A6) | 0.10 | (S1) | 89.90 | | |
| UDL-37 | (M2) | 10.00 | (A7) | 0.10 | (S1) | 89.90 | | |
| UDL-38 | (M2) | 10.00 | (A8) | 0.10 | (S1) | 89.90 | | |
| UDL-39 | (M2) | 10.00 | (A9) | 0.10 | (S1) | 89.90 | | |
| UDL-40 | (M2) | 10.00 | (A10) | 0.10 | (S1) | 89.90 | | |
| UDL-41 | (M2) | 10.00 | (A11) | 0.10 | (S1) | 89.90 | | |
| UDL-42 | (M2) | 10.00 | (A12) | 0.10 | (S1) | 89.90 | | |
| UDL-43 | (M2) | 10.00 | (A13) | 0.10 | (S1) | 89.90 | | |
| UDL-44 | (M2) | 10.00 | (A14) | 0.10 | (S1) | 89.90 | | |
| UDL-45 | (M2) | 10.00 | (A15) | 0.10 | (S1) | 89.90 | | |
| UDL-46 | (M2) | 10.00 | (A16) | 0.10 | (S1) | 89.90 | | |
| UDL-47 | (M2) | 10.00 | (A17) | 0.10 | (S1) | 89.90 | | |
| UDL-48 | (M2) | 10.00 | (A18) | 0.10 | (S1) | 89.90 | | |
| UDL-49 | (M2) | 10.000 | (A19) | 0.10 | (S1) | 89.90 | | |
| UDL-50 | (M2) | 10.00 | (A20) | 0.10 | (S1) | 89.90 | | |
| UDL-51 | (M2) | 10.00 | (A21) | 0.10 | (S1) | 89.90 | | |
| UDL-52 | (M2) | 10.00 | (A22) | 0.10 | (S1) | 89.90 | | |
| UDL-53 | (M2) | 10.00 | (A23) | 0.10 | (S1) | 89.90 | | |
| UDL-54 | (M2) | 10.00 | (A24) | 0.10 | (S1) | 89.90 | | |
| UDL-55 | (M2) | 10.00 | (A25) | 0.10 | (S1) | 89.90 | | |
| UDL-56 | (M3) | 10.00 | (A1) | 0.10 | (S1) | 89.90 | | |
| UDL-57 | (M3) | 10.00 | (A2) | 0.10 | (S1) | 89.90 | | |
| UDL-58 | (M3) | 10.00 | (A3) | 0.10 | (S1) | 89.90 | | |
| UDL-59 | (M3) | 10.00 | (A4) | 0.10 | (S1) | 89.90 | | |
| UDL-60 | (M3) | 10.00 | (A5) | 0.10 | (S1) | 89.90 | | |
| UDL-61 | (M3) | 10.00 | (A6) | 0.10 | (S1) | 89.90 | | |
| UDL-62 | (M3) | 10.00 | (A7) | 0.10 | (S1) | 89.90 | | |
| UDL-63 | (M3) | 10.00 | (A8) | 0.10 | (S1) | 89.90 | | |
| UDL-64 | (M3) | 10.00 | (A9) | 0.10 | (S1) | 89.90 | | |
| UDL-65 | (M3) | 10.00 | (A10) | 0.10 | (S1) | 89.90 | | |
| UDL-66 | (M3) | 10.00 | (A11) | 0.10 | (S1) | 89.90 | | |
| UDL-67 | (M3) | 10.00 | (A12) | 0.10 | (S1) | 89.90 | | |
| UDL-68 | (M3) | 10.00 | (A13) | 0.10 | (S1) | 89.90 | | |
| UDL-69 | (M3) | 10.00 | (A14) | 0.10 | (S1) | 89.90 | | |
| UDL-70 | (M3) | 10.00 | (A15) | 0.10 | (S1) | 89.90 | | |

**[Table 11]**

| Composition for forming organic film | Material for forming organic film | | Polymer | | Solvent 1 | | Solvent 2 | |
|---|---|---|---|---|---|---|---|---|
| | Type | Parts by mass | Type | Parts by mass | Type | Parts by mass | Type | Parts by mass |
| UDL-71 | (M3) | 10.00 | (A16) | 0.10 | (S1) | 89.90 | | |
| UDL-72 | (M3) | 10.00 | (A17) | 0.10 | (S1) | 89.90 | | |
| UDL-73 | (M3) | 10.00 | (A18) | 0.10 | (S1) | 89.90 | | |
| UDL-74 | (M3) | 10.000 | (A19) | 0.10 | (S1) | 89.90 | | |
| UDL-75 | (M3) | 10.00 | (A20) | 0.10 | (S1) | 89.90 | | |
| UDL-76 | (M3) | 10.00 | (A21) | 0.10 | (S1) | 89.90 | | |
| UDL-77 | (M3) | 10.00 | (A22) | 0.10 | (S1) | 89.90 | | |
| UDL-78 | (M3) | 10.00 | (A23) | 0.10 | (S1) | 89.90 | | |
| UDL-79 | (M3) | 10.00 | (A24) | 0.10 | (S1) | 89.90 | | |
| UDL-80 | (M3) | 10.00 | (A25) | 0.10 | (S1) | 89.90 | | |
| UDL-81 | (M4) | 10.00 | (A1) | 0.10 | (S1) | 89.90 | | |
| UDL-82 | (M4) | 10.00 | (A2) | 0.10 | (S1) | 89.90 | | |
| UDL-83 | (M4) | 10.00 | (A3) | 0.10 | (S1) | 89.90 | | |
| UDL-84 | (M4) | 10.00 | (A4) | 0.10 | (S1) | 89.90 | | |
| UDL-85 | (M4) | 10.00 | (A5) | 0.10 | (S1) | 89.90 | | |
| UDL-86 | (M4) | 10.00 | (A6) | 0.10 | (S1) | 89.90 | | |
| UDL-87 | (M4) | 10.00 | (A7) | 0.10 | (S1) | 89.90 | | |
| UDL-88 | (M4) | 10.00 | (A8) | 0.10 | (S1) | 89.90 | | |
| UDL-89 | (M4) | 10.00 | (A9) | 0.10 | (S1) | 89.90 | | |
| UDL-90 | (M4) | 10.00 | (A10) | 0.10 | (S1) | 89.90 | | |
| UDL-91 | (M4) | 10.00 | (A11) | 0.10 | (S1) | 89.90 | | |
| UDL-92 | (M4) | 10.00 | (A12) | 0.10 | (S1) | 89.90 | | |
| UDL-93 | (M4) | 10.00 | (A13) | 0.10 | (S1) | 89.90 | | |
| UDL-94 | (M4) | 10.00 | (A14) | 0.10 | (S1) | 89.90 | | |
| UDL-95 | (M4) | 10.00 | (A15) | 0.10 | (S1) | 89.90 | | |
| UDL-96 | (M4) | 10.00 | (A16) | 0.10 | (S1) | 89.90 | | |
| UDL-97 | (M4) | 10.00 | (A17) | 0.10 | (S1) | 89.90 | | |
| UDL-98 | (M4) | 10.00 | (A18) | 0.10 | (S1) | 89.90 | | |
| UDL-99 | (M4) | 10.000 | (A19) | 0.10 | (S1) | 89.90 | | |
| UDL-100 | (M4) | 10.00 | (A20) | 0.10 | (S1) | 89.90 | | |
| UDL-101 | (M4) | 10.00 | (A21) | 0.10 | (S1) | 89.90 | | |
| UDL-102 | (M4) | 10.00 | (A22) | 0.10 | (S1) | 89.90 | | |
| UDL-103 | (M4) | 10.00 | (A23) | 0.10 | (S1) | 89.90 | | |
| UDL-104 | (M4) | 10.00 | (A24) | 0.10 | (S1) | 89.90 | | |
| UDL-105 | (M4) | 10.00 | (A25) | 0.10 | (S1) | 89.90 | | |

**[Table 12]**

| Composition for forming organic film | Material for forming organic film | | Polymer | | Solvent 1 | | Solvent 2 | |
|---|---|---|---|---|---|---|---|---|
| | Type | Parts by mass | Type | Parts by mass | Type | Parts by mass | Type | Parts by mass |
| UDL-106 | (M5) | 10.00 | (A1) | 0.10 | (S1) | 89.90 | | |
| UDL-107 | (M5) | 10.00 | (A2) | 0.10 | (S1) | 89.90 | | |
| UDL-108 | (M5) | 10.00 | (A3) | 0.10 | (S1) | 89.90 | | |
| UDL-109 | (M5) | 10.00 | (A4) | 0.10 | (S1) | 89.90 | | |
| UDL-110 | (M5) | 10.00 | (A5) | 0.10 | (S1) | 89.90 | | |
| UDL-111 | (M5) | 10.00 | (A6) | 0.10 | (S1) | 89.90 | | |
| UDL-112 | (M5) | 10.00 | (A7) | 0.10 | (S1) | 89.90 | | |
| UDL-113 | (M5) | 10.00 | (A8) | 0.10 | (S1) | 89.90 | | |
| UDL-114 | (M5) | 10.00 | (A9) | 0.10 | (S1) | 89.90 | | |
| UDL-115 | (M5) | 10.00 | (A10) | 0.10 | (S1) | 89.90 | | |
| UDL-116 | (M5) | 10.00 | (A11) | 0.10 | (S1) | 89.90 | | |
| UDL-117 | (M5) | 10.00 | (A12) | 0.10 | (S1) | 89.90 | | |
| UDL-118 | (M5) | 10.00 | (A13) | 0.10 | (S1) | 89.90 | | |
| UDL-119 | (M5) | 10.00 | (A14) | 0.10 | (S1) | 89.90 | | |
| UDL-120 | (M5) | 10.00 | (A15) | 0.10 | (S1) | 89.90 | | |
| UDL-121 | (M5) | 10.00 | (A16) | 0.10 | (S1) | 89.90 | | |
| UDL-122 | (M5) | 10.00 | (A17) | 0.10 | (S1) | 89.90 | | |
| UDL-123 | (M5) | 10.00 | (A18) | 0.10 | (S1) | 89.90 | | |
| UDL-124 | (M5) | 10.000 | (A19) | 0.10 | (S1) | 89.90 | | |
| UDL-125 | (M5) | 10.00 | (A20) | 0.10 | (S1) | 89.90 | | |
| UDL-126 | (M5) | 10.00 | (A21) | 0.10 | (S1) | 89.90 | | |
| UDL-127 | (M5) | 10.00 | (A22) | 0.10 | (S1) | 89.90 | | |
| UDL-128 | (M5) | 10.00 | (A23) | 0.10 | (S1) | 89.90 | | |
| UDL-129 | (M5) | 10.00 | (A24) | 0.10 | (S1) | 89.90 | | |
| UDL-130 | (M5) | 10.00 | (A25) | 0.10 | (S1) | 89.90 | | |
| UDL-131 | (M6) | 10.00 | (A1) | 0.10 | (S1) | 89.90 | | |
| UDL-132 | (M6) | 10.00 | (A2) | 0.10 | (S1) | 89.90 | | |
| UDL-133 | (M6) | 10.00 | (A3) | 0.10 | (S1) | 89.90 | | |
| UDL-134 | (M6) | 10.00 | (A4) | 0.10 | (S1) | 89.90 | | |
| UDL-135 | (M6) | 10.00 | (A5) | 0.10 | (S1) | 89.90 | | |
| UDL-136 | (M6) | 10.00 | (A6) | 0.10 | (S1) | 89.90 | | |
| UDL-137 | (M6) | 10.00 | (A7) | 0.10 | (S1) | 89.90 | | |
| UDL-138 | (M6) | 10.00 | (A8) | 0.10 | (S1) | 89.90 | | |
| UDL-139 | (M6) | 10.00 | (A9) | 0.10 | (S1) | 89.90 | | |
| UDL-140 | (M6) | 10.00 | (A10) | 0.10 | (S1) | 89.90 | | |

**[Table 13]**

| Composition for forming organic film | Material for forming organic film | | Polymer | | Solvent 1 | | Solvent 2 | |
|---|---|---|---|---|---|---|---|---|
| | Type | Parts by mass | Type | Parts by mass | Type | Parts by mass | Type | Parts by mass |
| UDL-141 | (M6) | 10.00 | (A11) | 0.10 | (S1) | 89.90 | | |
| UDL-142 | (M6) | 10.00 | (A12) | 0.10 | (S1) | 89.90 | | |
| UDL-143 | (M6) | 10.00 | (A13) | 0.10 | (S1) | 89.90 | | |
| UDL-144 | (M6) | 10.00 | (A14) | 0.10 | (S1) | 89.90 | | |
| UDL-145 | (M6) | 10.00 | (A15) | 0.10 | (S1) | 89.90 | | |
| UDL-146 | (M6) | 10.00 | (A16) | 0.10 | (S1) | 89.90 | | |
| UDL-147 | (M6) | 10.00 | (A17) | 0.10 | (S1) | 89.90 | | |
| UDL-148 | (M6) | 10.00 | (A18) | 0.10 | (S1) | 89.90 | | |
| UDL-149 | (M6) | 10.000 | (A19) | 0.10 | (S1) | 89.90 | | |
| UDL-150 | (M6) | 10.00 | (A20) | 0.10 | (S1) | 89.90 | | |
| UDL-151 | (M6) | 10.00 | (A21) | 0.10 | (S1) | 89.90 | | |
| UDL-152 | (M6) | 10.00 | (A22) | 0.10 | (S1) | 89.90 | | |
| UDL-153 | (M6) | 10.00 | (A23) | 0.10 | (S1) | 89.90 | | |
| UDL-154 | (M6) | 10.00 | (A24) | 0.10 | (S1) | 89.90 | | |
| UDL-155 | (M6) | 10.00 | (A25) | 0.10 | (S1) | 89.90 | | |
| Comparative UDL-1 | (M1) | 10.00 | (R1) | 0.10 | (S1) | 89.90 | | |
| Comparative UDL-2 | (M2) | 10.00 | (R1) | 0.10 | (S1) | 89.90 | | |
| Comparative UDL-3 | (M3) | 10.00 | (R1) | 0.10 | (S1) | 89.90 | | |
| Comparative UDL-4 | (M4) | 10.00 | (R1) | 0.10 | (S1) | 89.90 | | |
| Comparative UDL-5 | (M5) | 10.00 | (R1) | 0.10 | (S1) | 89.90 | | |
| Comparative UDL-6 | (M6) | 10.00 | (R1) | 0.10 | (S1) | 89.90 | | |
| Comparative UDL-7 | (M1) | 10.00 | (R2) | 0.10 | (S1) | 89.90 | | |
| Comparative UDL-8 | (M1) | 10.00 | (R3) | 0.10 | (S1) | 89.90 | | |
| Comparative UDL-9 | (M1) | 10.00 | (R4) | 0.10 | (S1) | 89.90 | | |
| Comparative UDL-10 | (M1) | 10.00 | (R5) | 0.10 | (S1) | 89.90 | | |
| Comparative UDL-11 | (M1) | 10.00 | (R6) | 0.10 | (S1) | 89.90 | | |
| Comparative UDL-12 | (M1) | 10.00 | | | (S1) | 90.00 | | |
| Comparative UDL-13 | (M2) | 10.00 | | | (S1) | 90.00 | | |
| Comparative UDL-14 | (M3) | 10.00 | | | (S1) | 90.00 | | |
| Comparative UDL-15 | (M4) | 10.00 | | | (S1) | 90.00 | | |
| Comparative UDL-16 | (M5) | 10.00 | | | (S1) | 90.00 | | |
| Comparative UDL-17 | (M6) | 10.00 | | | (S1) | 90.00 | | |

### [Preparation of Silicon Wafers Having Cured Organic Film Formed Thereon By Using Compositions (UDL-1 to -155 and Comparative UDL-1 to -17) for Forming Organic Film]

Using a coater/developer "CLEAN TRACK LITHIUS Pro AP" of Tokyo Electron Ltd., each of the compositions (UDL-1 to -155 and comparative UDL-1 to -17) for forming an organic film prepared above was respectively discharged in an amount of 2 ml onto a silicon wafer at the center and baked. Then, the wafer was rotated at a rotational rate to achieve the average film thickness shown in Tables 14 to 18 to spread the composition, and thus, a film was formed. While rotating the silicon wafer at a rate of 1000 rpm, the remover-discharging nozzle was moved at a speed of 5 mm/s from the periphery of the silicon wafer to a position 3 mm from the center while discharging a remover (mixed solution of propylene glycol monomethyl ether acetate and propylene glycol monomethyl ether (30:70, mass ratio)) at a discharge rate of 2 ml/s, and the remover was further discharged at that position for 5 seconds at a discharge rate of 2 ml/s. After that, the discharging of the discharged liquid was terminated, and the wafer was further rotated at a rate of 1000 rpm for 30 seconds. Next, the silicon wafer, having a film of the composition for forming an organic film formed thereon, was heated at 350°C for 60 seconds to obtain silicon wafers having a cured organic film formed.

### [Solvent Resistance Evaluation: Examples 1-1 to 1-155 and Comparative Examples 1-1 to 1-17]

A film of each of the compositions (UDL-1 to -155 and comparative UDL-1 to -17) for forming an organic film was respectively formed on a silicon wafer by the above-described method, and the film thickness was measured. A PGMEA solvent was dispensed thereon, the wafer was left to stand for 30 seconds, spin-dried, and baked at 100°C for 60 seconds to evaporate the PGMEA, and the film thickness was measured. The absolute value of the value determined by (X₁-X)/X × 100 was obtained as a film thickness change rate (%), where X is the film thickness before dispensing the PGMEA solvent, and X₁ is the film thickness after the PGMEA solvent was dispensed. When the film thickness change rate was lower than 0.5%, the composition was evaluated as "Good", and when 0.5% or higher, "Poor". Tables 14 to 18 show the results.

### [In-Plane Uniformity Evaluation: Examples 1-1 to 1-155 and Comparative Examples 1-1 to 1-17]

A film of each of the compositions (UDL-1 to -155 and comparative UDL-1 to -17) for forming an organic film was respectively formed on a silicon wafer by the above-described method, and the film thickness of the cured organic film within a radius of 145 mm from the center was measured. The value determined by (Xₘₐₓ-Xₘᵢₙ)/X_{average} was obtained as in-plane uniformity (%), where Xₘₐₓ is the maximum value of the film thickness, Xₘᵢₙ is the minimum value of the film thickness, and X_{average} is the average film thickness. When the in-plane uniformity was less than 2%, the composition was evaluated as A (good), when 2% or more to less than 3%, B, and when 3% or more, C (poor). Tables 14 to 18 show the results.

**[Table 14]**

| | Composition for forming organic film | Average film thickness | Solvent resistance | In-plane uniformity |
|---|---|---|---|---|
| Example 1-1 | UDL-1 | 500 nm | Good | B |
| Example 1-2 | UDL-2 | 500 nm | Good | A |
| Example 1-3 | UDL-3 | 500 nm | Good | A |
| Example 1-4 | UDL-4 | 500 nm | Good | A |
| Example 1-5 | UDL-5 | 500 nm | Good | A |
| Example 1-6 | UDL-6 | 500 nm | Good | A |
| Example 1-7 | UDL-7 | 500 nm | Good | A |
| Example 1-8 | UDL-8 | 500 nm | Good | A |
| Example 1-9 | UDL-9 | 500 nm | Good | B |
| Example 1-10 | UDL-10 | 500 nm | Good | A |
| Example 1-11 | UDL-11 | 500 nm | Good | A |
| Example 1-12 | UDL-12 | 500 nm | Good | A |
| Example 1-13 | UDL-13 | 500 nm | Good | A |
| Example 1-14 | UDL-14 | 500 nm | Good | A |
| Example 1-15 | UDL-15 | 500 nm | Good | A |
| Example 1-16 | UDL-16 | 500 nm | Good | A |
| Example 1-17 | UDL-17 | 500 nm | Good | A |
| Example 1-18 | UDL-18 | 500 nm | Good | A |
| Example 1-19 | UDL-19 | 500 nm | Good | B |
| Example 1-20 | UDL-20 | 500 nm | Good | A |
| Example 1-21 | UDL-21 | 500 nm | Good | A |
| Example 1-22 | UDL-22 | 500 nm | Good | A |
| Example 1-23 | UDL-23 | 500 nm | Good | A |
| Example 1-24 | UDL-24 | 500 nm | Good | A |
| Example 1-25 | UDL-25 | 500 nm | Good | A |
| Example 1-26 | UDL-26 | 500 nm | Good | A |
| Example 1-27 | UDL-27 | 500 nm | Good | A |
| Example 1-28 | UDL-28 | 500 nm | Good | A |
| Example 1-29 | UDL-29 | 500 nm | Good | A |
| Example 1-30 | UDL-30 | 500 nm | Good | A |
| Example 1-31 | UDL-31 | 500 nm | Good | B |
| Example 1-32 | UDL-32 | 500 nm | Good | A |
| Example 1-33 | UDL-33 | 500 nm | Good | A |
| Example 1-34 | UDL-34 | 500 nm | Good | A |
| Example 1-35 | UDL-35 | 500 nm | Good | A |

**[Table 15]**

| | Composition for forming organic film | Average film thickness | Solvent resistance | In-plane uniformity |
|---|---|---|---|---|
| Example 1-36 | UDL-36 | 500 nm | Good | A |
| Example 1-37 | UDL-37 | 500 nm | Good | A |
| Example 1-38 | UDL-38 | 500 nm | Good | A |
| Example 1-39 | UDL-39 | 500 nm | Good | B |
| Example 1-40 | UDL-40 | 500 nm | Good | A |
| Example 1-41 | UDL-41 | 500 nm | Good | A |
| Example 1-42 | UDL-42 | 500 nm | Good | A |
| Example 1-43 | UDL-43 | 500 nm | Good | A |
| Example 1-44 | UDL-44 | 500 nm | Good | A |
| Example 1-45 | UDL-45 | 500 nm | Good | A |
| Example 1-46 | UDL-46 | 500 nm | Good | A |
| Example 1-47 | UDL-47 | 500 nm | Good | A |
| Example 1-48 | UDL-48 | 500 nm | Good | A |
| Example 1-49 | UDL-49 | 500 nm | Good | B |
| Example 1-50 | UDL-50 | 500 nm | Good | A |
| Example 1-51 | UDL-51 | 500 nm | Good | A |
| Example 1-52 | UDL-52 | 500 nm | Good | A |
| Example 1-53 | UDL-53 | 500 nm | Good | A |
| Example 1-54 | UDL-54 | 500 nm | Good | A |
| Example 1-55 | UDL-55 | 500 nm | Good | A |
| Example 1-56 | UDL-56 | 500 nm | Good | B |
| Example 1-57 | UDL-57 | 500 nm | Good | A |
| Example 1-58 | UDL-58 | 500 nm | Good | A |
| Example 1-59 | UDL-59 | 500 nm | Good | A |
| Example 1-60 | UDL-60 | 500 nm | Good | A |
| Example 1-61 | UDL-61 | 500 nm | Good | A |
| Example 1-62 | UDL-62 | 500 nm | Good | A |
| Example 1-63 | UDL-63 | 500 nm | Good | A |
| Example 1-64 | UDL-64 | 500 nm | Good | B |
| Example 1-65 | UDL-65 | 500 nm | Good | A |
| Example 1-66 | UDL-66 | 500 nm | Good | A |
| Example 1-67 | UDL-67 | 500 nm | Good | A |
| Example 1-68 | UDL-68 | 500 nm | Good | A |
| Example 1-69 | UDL-69 | 500 nm | Good | A |
| Example 1-70 | UDL-70 | 500 nm | Good | A |

**[Table 16]**

| | Composition for forming organic film | Average film thickness | Solvent resistance | In-plane uniformity |
|---|---|---|---|---|
| Example 1-71 | UDL-71 | 500 nm | Good | A |
| Example 1-72 | UDL-72 | 500 nm | Good | A |
| Example 1-73 | UDL-73 | 500 nm | Good | A |
| Example 1-74 | UDL-74 | 500 nm | Good | B |
| Example 1-75 | UDL-75 | 500 nm | Good | A |
| Example 1-76 | UDL-76 | 500 nm | Good | A |
| Example 1-77 | UDL-77 | 500 nm | Good | A |
| Example 1-78 | UDL-78 | 500 nm | Good | A |
| Example 1-79 | UDL-79 | 500 nm | Good | A |
| Example 1-80 | UDL-80 | 500 nm | Good | A |
| Example 1-81 | UDL-81 | 500 nm | Good | B |
| Example 1-82 | UDL-82 | 500 nm | Good | A |
| Example 1-83 | UDL-83 | 500 nm | Good | A |
| Example 1-84 | UDL-84 | 500 nm | Good | A |
| Example 1-85 | UDL-85 | 500 nm | Good | A |
| Example 1-86 | UDL-86 | 500 nm | Good | A |
| Example 1-87 | UDL-87 | 500 nm | Good | A |
| Example 1-88 | UDL-88 | 500 nm | Good | A |
| Example 1-89 | UDL-89 | 500 nm | Good | B |
| Example 1-90 | UDL-90 | 500 nm | Good | A |
| Example 1-91 | UDL-91 | 500 nm | Good | A |
| Example 1-92 | UDL-92 | 500 nm | Good | A |
| Example 1-93 | UDL-93 | 500 nm | Good | A |
| Example 1-94 | UDL-94 | 500 nm | Good | A |
| Example 1-95 | UDL-95 | 500 nm | Good | A |
| Example 1-96 | UDL-96 | 500 nm | Good | A |
| Example 1-97 | UDL-97 | 500 nm | Good | A |
| Example 1-98 | UDL-98 | 500 nm | Good | A |
| Example 1-99 | UDL-99 | 500 nm | Good | B |
| Example 1-100 | UDL-100 | 500 nm | Good | A |
| Example 1-101 | UDL-101 | 500 nm | Good | A |
| Example 1-102 | UDL-102 | 500 nm | Good | A |
| Example 1-103 | UDL-103 | 500 nm | Good | A |
| Example 1-104 | UDL-104 | 500 nm | Good | A |
| Example 1-105 | UDL-105 | 500 nm | Good | A |

**[Table 17]**

| | Composition for forming organic film | Average film thickness | Solvent resistance | In-plane uniformity |
|---|---|---|---|---|
| Example 1-106 | UDL-106 | 500 nm | Good | B |
| Example 1-107 | UDL-107 | 500 nm | Good | A |
| Example 1-108 | UDL-108 | 500 nm | Good | A |
| Example 1-109 | UDL-109 | 500 nm | Good | A |
| Example 1-110 | UDL-110 | 500 nm | Good | A |
| Example 1-111 | UDL-111 | 500 nm | Good | A |
| Example 1-112 | UDL-112 | 500 nm | Good | A |
| Example 1-113 | UDL-113 | 500 nm | Good | A |
| Example 1-114 | UDL-114 | 500 nm | Good | B |
| Example 1-115 | UDL-115 | 500 nm | Good | A |
| Example 1-116 | UDL-116 | 500 nm | Good | A |
| Example 1-117 | UDL-117 | 500 nm | Good | A |
| Example 1-118 | UDL-118 | 500 nm | Good | A |
| Example 1-119 | UDL-119 | 500 nm | Good | A |
| Example 1-120 | UDL-120 | 500 nm | Good | A |
| Example 1-121 | UDL-121 | 500 nm | Good | A |
| Example 1-122 | UDL-122 | 500 nm | Good | A |
| Example 1-123 | UDL-123 | 500 nm | Good | A |
| Example 1-124 | UDL-124 | 500 nm | Good | B |
| Example 1-125 | UDL-125 | 500 nm | Good | A |
| Example 1-126 | UDL-126 | 500 nm | Good | A |
| Example 1-127 | UDL-127 | 500 nm | Good | A |
| Example 1-128 | UDL-128 | 500 nm | Good | A |
| Example 1-129 | UDL-129 | 500 nm | Good | A |
| Example 1-130 | UDL-130 | 500 nm | Good | A |
| Example 1-131 | UDL-131 | 500 nm | Good | B |
| Example 1-132 | UDL-132 | 500 nm | Good | A |
| Example 1-133 | UDL-133 | 500 nm | Good | A |
| Example 1-134 | UDL-134 | 500 nm | Good | A |
| Example 1-135 | UDL-135 | 500 nm | Good | A |
| Example 1-136 | UDL-136 | 500 nm | Good | A |
| Example 1-137 | UDL-137 | 500 nm | Good | A |
| Example 1-138 | UDL-138 | 500 nm | Good | A |
| Example 1-139 | UDL-139 | 500 nm | Good | B |
| Example 1-140 | UDL-140 | 500 nm | Good | A |

**[Table 18]**

| | Composition for forming organic film | Average film thickness | Solvent resistance | In-plane uniformity |
|---|---|---|---|---|
| Example 1-141 | UDL-141 | 500 nm | Good | A |
| Example 1-142 | UDL-142 | 500 nm | Good | A |
| Example 1-143 | UDL-143 | 500 nm | Good | A |
| Example 1-144 | UDL-144 | 500 nm | Good | A |
| Example 1-145 | UDL-145 | 500 nm | Good | A |
| Example 1-146 | UDL-146 | 500 nm | Good | A |
| Example 1-147 | UDL-147 | 500 nm | Good | A |
| Example 1-148 | UDL-148 | 500 nm | Good | A |
| Example 1-149 | UDL-149 | 500 nm | Good | B |
| Example 1-150 | UDL-150 | 500 nm | Good | A |
| Example 1-151 | UDL-151 | 500 nm | Good | A |
| Example 1-152 | UDL-152 | 500 nm | Good | A |
| Example 1-153 | UDL-153 | 500 nm | Good | A |
| Example 1-154 | UDL-154 | 500 nm | Good | A |
| Example 1-155 | UDL-155 | 500 nm | Good | A |
| Comparative Example 1-1 | Comparative UDL-1 | 500 nm | Good | A |
| Comparative Example 1-2 | Comparative UDL-2 | 500 nm | Good | A |
| Comparative Example 1-3 | Comparative UDL-3 | 500 nm | Good | A |
| Comparative Example 1-4 | Comparative UDL-4 | 500 nm | Good | A |
| Comparative Example 1-5 | Comparative UDL-5 | 500 nm | Good | A |
| Comparative Example 1-6 | Comparative UDL-6 | 500 nm | Good | A |
| Comparative Example 1-7 | Comparative UDL-7 | 500 nm | Good | A |
| Comparative Example 1-8 | Comparative UDL-8 | 500 nm | Good | A |
| Comparative Example 1-9 | Comparative UDL-9 | 500 nm | Good | A |
| Comparative Example 1-10 | Comparative UDL-10 | 500 nm | Good | A |
| Comparative Example 1-11 | Comparative UDL-11 | 500 nm | Good | C |
| Comparative Example 1-12 | Comparative UDL-12 | 500 nm | Good | C |
| Comparative Example 1-13 | Comparative UDL-13 | 500 nm | Good | C |
| Comparative Example 1-14 | Comparative UDL-14 | 500 nm | Good | C |
| Comparative Example 1-15 | Comparative UDL-15 | 500 nm | Good | C |
| Comparative Example 1-16 | Comparative UDL-16 | 500 nm | Good | C |
| Comparative Example 1-17 | Comparative UDL-17 | 500 nm | Good | C |

As shown in Tables 14 to 18, in Examples 1-1 to 1-155, where the inventive compositions for forming an organic film were used, an organic film having both good solvent resistance and good in-plane uniformity was obtained, but in Comparative Examples 1-11 to 1-17, where a composition not containing the inventive polymer was used, in-plane uniformity was poor. Therefore, in the following evaluations, comparative UDL-1 to -10, which had both good solvent resistance and good in-plane uniformity, were considered.

### [Hump Suppression Property Evaluation: Examples 2-1 to 2-155 and Comparative Examples 2-1 to 2-10]

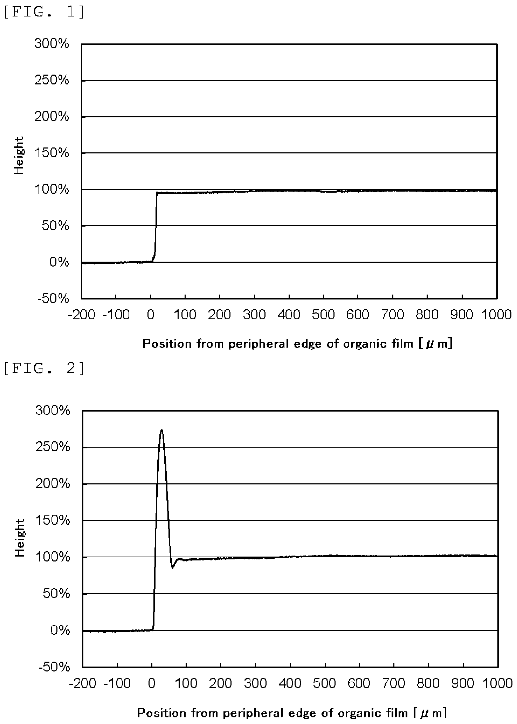

A film of each of the compositions (UDL-1 to -155 and comparative UDL-1 to -10) for forming an organic film was respectively formed on a silicon wafer by the above-described method, and the change in height was measured by using Alpha-Step D-600 (a stylus profiler) manufactured by KLA corporation from the peripheral edge of the organic film towards the center of the silicon wafer to a position of 1000 µm. The height of the silicon wafer was set to 0, and when the maximum height was less than 110% of the film thickness as shown in FIG. 1, the composition was evaluated as A (good), when the maximum height was 110% or more to less than 150%, evaluated as B, and when a region where the height was 150% or more occurred as shown in FIG. 2, evaluated as C (poor). Tables 19 to 23 show the results.

### [Filling Property Evaluation: Examples 2-1 to 2-155 and Comparative Examples 2-1 to 2-10]

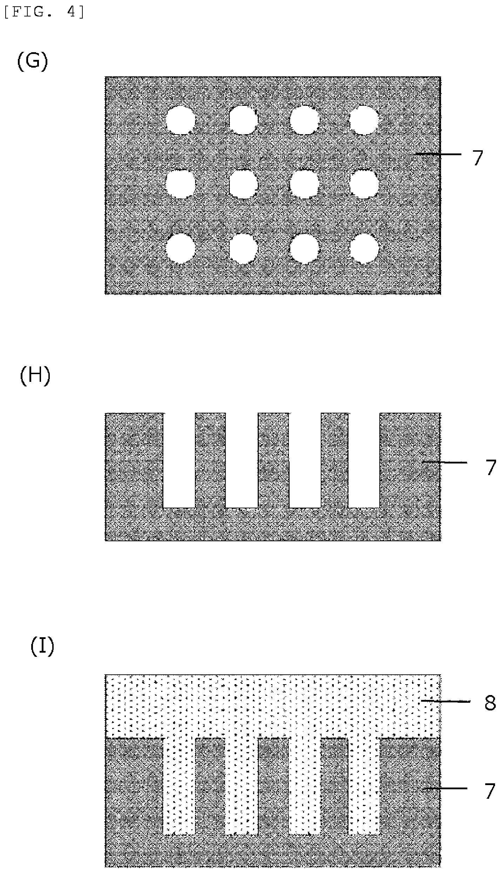

As shown in FIG. 4, a film of each of the compositions (UDL-1 to -155 and comparative UDL-1 to -10) for forming an organic film was respectively formed by the above-described method on an SiO₂ wafer substrate having a dense hole pattern (hole diameter 0.2 µm, hole depth 1.0 um, distance between the centers of two adjacent holes 0.4 µm). Thus, an organic film 8 was formed. The substrate used was a base substrate (SiO₂ wafer substrate) 7 having a dense hole pattern shown in FIG. 4 (G) (downward view) and (H) (cross-sectional view). The cross-sectional shape of each of the obtained wafer substrates was observed using a scanning electron microscope (SEM), and it was observed whether or not the inside of the holes was filled with the organic film without gaps. When a composition for forming an organic film having poor filling property is used, gaps are generated inside the holes. When a composition for forming an organic film having a desirable filling property is used in the present evaluation, the inside of the holes is filled with the organic film without gaps, as shown in FIG. 4 (I). The composition was evaluated as "Good" when no gaps were generated, and when gaps were generated, as "Poor". Tables 19 to 23 show the results.

### [Silicon Middle Layer Film-Coatability Evaluation-1: Examples 2-1 to 2-155 and Comparative Examples 2-1 to 2-10]

A cured organic film was formed respectively on a silicon wafer substrate by using each of the compositions (UDL-1 to -155 and comparative UDL-1 to -10) for forming an organic film by the above-described method, the silicon-containing resist middle layer film material (SOG1) described below was applied thereto, and baking was performed at 200°C for 60 seconds to form a silicon-containing resist middle layer film. Then, the state of the coating film of the silicon middle layer film was visually observed and evaluated.

When the state of the coating film was good, the composition was evaluated as "Good", and when dewetting had occurred, as "Poor".

Note that, in this evaluation, to evaluate the coatability of the silicon middle layer film, the thickness of the silicon middle layer film was set to 10 nm, and this is a severe evaluation condition. Tables 19 to 23 show the results.

### [Silicon Middle Layer Film-Coatability Evaluation-2: Examples 2-1 to 2-155 and Comparative Examples 2-1 to 2-10]

A cured organic film was formed respectively on a silicon wafer substrate by using each of the compositions (UDL-1 to -155 and comparative UDL-1 to -10) for forming an organic film by the above-described method, the silicon-containing resist middle layer film material (SOG1) described below was applied thereto, and baking was performed at 200°C for 60 seconds to form a silicon-containing resist middle layer film. Then, the state of the coating film of the silicon middle layer film was visually observed and evaluated.

When the state of the coating film was good, the composition was evaluated as "Good", and when dewetting had occurred, as "Poor".

Note that, in this evaluation, to evaluate the coatability of the silicon middle layer film, the thickness of the silicon middle layer film was set to 5 nm, and this is a special, severe evaluation condition.

### Tables 19 to 23 show the results.

As the silicon-containing resist middle layer film material (SOG1), a solution of the following polymer in propylene glycol ethyl ether was prepared. The polymer solution used in the silicon middle layer film-coatability evaluation-1 was 0.5 mass%, and the polymer solution used in the silicon middle layer film-coatability evaluation-2 was 0.2 mass%.

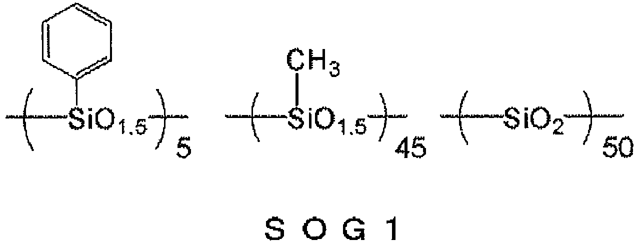

**[Table 19]**

| | Composition for forming organic film | Hump suppression property evaluation | Filling property evaluation | Silicon middle layer film-coatability evaluation-1 | Silicon middle layer film-coatability evaluation-2 |
|---|---|---|---|---|---|
| Example 2-1 | UDL-1 | A | Good | Good | Poor |
| Example 2-2 | UDL-2 | A | Good | Good | Poor |
| Example 2-3 | UDL-3 | A | Good | Good | Poor |
| Example 2-4 | UDL-4 | A | Good | Good | Poor |
| Example 2-5 | UDL-5 | A | Good | Good | Good |
| Example 2-6 | UDL-6 | A | Good | Good | Good |
| Example 2-7 | UDL-7 | A | Good | Good | Good |
| Example 2-8 | UDL-8 | A | Good | Good | Good |
| Example 2-9 | UDL-9 | A | Good | Good | Good |
| Example 2-10 | UDL-10 | A | Good | Good | Good |
| Example 2-11 | UDL-11 | A | Good | Good | Good |
| Example 2-12 | UDL-12 | A | Good | Good | Good |
| Example 2-13 | UDL-13 | A | Good | Good | Good |
| Example 2-14 | UDL-14 | A | Good | Good | Good |
| Example 2-15 | UDL-15 | A | Good | Good | Good |
| Example 2-16 | UDL-16 | A | Good | Good | Good |
| Example 2-17 | UDL-17 | A | Good | Good | Good |
| Example 2-18 | UDL-18 | A | Good | Good | Good |
| Example 2-19 | UDL-19 | A | Good | Good | Good |
| Example 2-20 | UDL-20 | A | Good | Good | Good |
| Example 2-21 | UDL-21 | A | Good | Good | Good |
| Example 2-22 | UDL-22 | A | Good | Good | Good |
| Example 2-23 | UDL-23 | A | Good | Good | Good |
| Example 2-24 | UDL-24 | A | Good | Good | Good |
| Example 2-25 | UDL-25 | A | Good | Good | Good |
| Example 2-26 | UDL-26 | A | Good | Good | Good |
| Example 2-27 | UDL-27 | A | Good | Good | Good |
| Example 2-28 | UDL-28 | A | Good | Good | Good |
| Example 2-29 | UDL-29 | A | Good | Good | Good |
| Example 2-30 | UDL-30 | A | Good | Good | Good |
| Example 2-31 | UDL-31 | A | Good | Good | Poor |
| Example 2-32 | UDL-32 | A | Good | Good | Poor |
| Example 2-33 | UDL-33 | A | Good | Good | Poor |
| Example 2-34 | UDL-34 | A | Good | Good | Poor |

**[Table 20]**

| | Composition for forming organic film | Hump suppression property evaluation | Filling property evaluation | Silicon middle layer film-coatability evaluation-1 | Silicon middle layer film-coatability evaluation-2 |
|---|---|---|---|---|---|
| Example 2-35 | UDL-35 | A | Good | Good | Good |
| Example 2-36 | UDL-36 | A | Good | Good | Good |
| Example 2-37 | UDL-37 | A | Good | Good | Good |
| Example 2-38 | UDL-38 | A | Good | Good | Good |
| Example 2-39 | UDL-39 | A | Good | Good | Good |
| Example 2-40 | UDL-40 | A | Good | Good | Good |
| Example 2-41 | UDL-41 | A | Good | Good | Good |
| Example 2-42 | UDL-42 | A | Good | Good | Good |
| Example 2-43 | UDL-43 | A | Good | Good | Good |
| Example 2-44 | UDL-44 | A | Good | Good | Good |
| Example 2-45 | UDL-45 | A | Good | Good | Good |
| Example 2-46 | UDL-46 | A | Good | Good | Good |
| Example 2-47 | UDL-47 | A | Good | Good | Good |
| Example 2-48 | UDL-48 | A | Good | Good | Good |
| Example 2-49 | UDL-49 | A | Good | Good | Good |
| Example 2-50 | UDL-50 | A | Good | Good | Good |
| Example 2-51 | UDL-51 | A | Good | Good | Good |
| Example 2-52 | UDL-52 | A | Good | Good | Good |
| Example 2-53 | UDL-53 | A | Good | Good | Good |
| Example 2-54 | UDL-54 | A | Good | Good | Good |
| Example 2-55 | UDL-55 | A | Good | Good | Good |
| Example 2-56 | UDL-56 | A | Good | Good | Poor |
| Example 2-57 | UDL-57 | A | Good | Good | Poor |
| Example 2-58 | UDL-58 | A | Good | Good | Poor |
| Example 2-59 | UDL-59 | A | Good | Good | Poor |
| Example 2-60 | UDL-60 | A | Good | Good | Good |
| Example 2-61 | UDL-61 | A | Good | Good | Good |
| Example 2-62 | UDL-62 | A | Good | Good | Good |
| Example 2-63 | UDL-63 | A | Good | Good | Good |
| Example 2-64 | UDL-64 | A | Good | Good | Good |
| Example 2-65 | UDL-65 | A | Good | Good | Good |
| Example 2-66 | UDL-66 | A | Good | Good | Good |
| Example 2-67 | UDL-67 | A | Good | Good | Good |
| Example 2-68 | UDL-68 | A | Good | Good | Good |
| Example 2-69 | UDL-69 | A | Good | Good | Good |

**[Table 21]**

| | Composition for forming organic film | Hump suppression property evaluation | Filling property evaluation | Silicon middle layer film-coatability evaluation-1 | Silicon middle layer film-coatability evaluation-2 |
|---|---|---|---|---|---|
| Example 2-70 | UDL-70 | A | Good | Good | Good |
| Example 2-71 | UDL-71 | A | Good | Good | Good |
| Example 2-72 | UDL-72 | A | Good | Good | Good |
| Example 2-73 | UDL-73 | A | Good | Good | Good |
| Example 2-74 | UDL-74 | A | Good | Good | Good |
| Example 2-75 | UDL-75 | A | Good | Good | Good |
| Example 2-76 | UDL-76 | A | Good | Good | Good |
| Example 2-77 | UDL-77 | A | Good | Good | Good |
| Example 2-78 | UDL-78 | A | Good | Good | Good |
| Example 2-79 | UDL-79 | A | Good | Good | Good |
| Example 2-80 | UDL-80 | A | Good | Good | Good |
| Example 2-81 | UDL-81 | A | Good | Good | Poor |
| Example 2-82 | UDL-82 | A | Good | Good | Poor |
| Example 2-83 | UDL-83 | A | Good | Good | Poor |
| Example 2-84 | UDL-84 | A | Good | Good | Poor |
| Example 2-85 | UDL-85 | A | Good | Good | Good |
| Example 2-86 | UDL-86 | A | Good | Good | Good |
| Example 2-87 | UDL-87 | A | Good | Good | Good |
| Example 2-88 | UDL-88 | A | Good | Good | Good |
| Example 2-89 | UDL-89 | A | Good | Good | Good |
| Example 2-90 | UDL-90 | A | Good | Good | Good |
| Example 2-91 | UDL-91 | A | Good | Good | Good |
| Example 2-92 | UDL-92 | A | Good | Good | Good |
| Example 2-93 | UDL-93 | A | Good | Good | Good |
| Example 2-94 | UDL-94 | A | Good | Good | Good |
| Example 2-95 | UDL-95 | A | Good | Good | Good |
| Example 2-96 | UDL-96 | A | Good | Good | Good |
| Example 2-97 | UDL-97 | A | Good | Good | Good |
| Example 2-98 | UDL-98 | A | Good | Good | Good |
| Example 2-99 | UDL-99 | A | Good | Good | Good |
| Example 2-100 | UDL-100 | A | Good | Good | Good |
| Example 2-101 | UDL-101 | A | Good | Good | Good |
| Example 2-102 | UDL-102 | A | Good | Good | Good |
| Example 2-103 | UDL-103 | A | Good | Good | Good |
| Example 2-104 | UDL-104 | A | Good | Good | Good |

**[Table 22]**

| | Composition for forming organic film | Hump suppression property evaluation | Filling property evaluation | Silicon middle layer film-coatability evaluation-1 | Silicon middle layer film-coatability evaluation-2 |
|---|---|---|---|---|---|
| Example 2-105 | UDL-105 | A | Good | Good | Good |
| Example 2-106 | UDL-106 | A | Good | Good | Poor |
| Example 2-107 | UDL-107 | A | Good | Good | Poor |
| Example 2-108 | UDL-108 | A | Good | Good | Poor |
| Example 2-109 | UDL-109 | A | Good | Good | Poor |
| Example 2-110 | UDL-110 | A | Good | Good | Good |
| Example 2-111 | UDL-111 | A | Good | Good | Good |
| Example 2-112 | UDL-112 | A | Good | Good | Good |
| Example 2-113 | UDL-113 | A | Good | Good | Good |
| Example 2-114 | UDL-114 | A | Good | Good | Good |
| Example 2-115 | UDL-115 | A | Good | Good | Good |
| Example 2-116 | UDL-116 | A | Good | Good | Good |
| Example 2-117 | UDL-117 | A | Good | Good | Good |
| Example 2-118 | UDL-118 | A | Good | Good | Good |
| Example 2-119 | UDL-119 | A | Good | Good | Good |
| Example 2-120 | UDL-120 | A | Good | Good | Good |
| Example 2-121 | UDL-121 | A | Good | Good | Good |
| Example 2-122 | UDL-122 | A | Good | Good | Good |
| Example 2-123 | UDL-123 | A | Good | Good | Good |
| Example 2-124 | UDL-124 | A | Good | Good | Good |
| Example 2-125 | UDL-125 | A | Good | Good | Good |
| Example 2-126 | UDL-126 | A | Good | Good | Good |
| Example 2-127 | UDL-127 | A | Good | Good | Good |
| Example 2-128 | UDL-128 | A | Good | Good | Good |
| Example 2-129 | UDL-129 | A | Good | Good | Good |
| Example 2-130 | UDL-130 | A | Good | Good | Good |
| Example 2-131 | UDL-131 | A | Good | Good | Poor |
| Example 2-132 | UDL-132 | A | Good | Good | Poor |
| Example 2-133 | UDL-133 | A | Good | Good | Poor |
| Example 2-134 | UDL-134 | A | Good | Good | Poor |
| Example 2-135 | UDL-135 | A | Good | Good | Good |
| Example 2-136 | UDL-136 | A | Good | Good | Good |
| Example 2-137 | UDL-137 | A | Good | Good | Good |
| Example 2-138 | UDL-138 | A | Good | Good | Good |
| Example 2-139 | UDL-139 | A | Good | Good | Good |

**[Table 23]**

| | Composition for forming organic film | Hump suppression property evaluation | Filling property evaluation | Silicon middle layer film-coatability evaluation-1 | Silicon middle layer film-coatability evaluation-2 |
|---|---|---|---|---|---|
| Example 2-140 | UDL-140 | A | Good | Good | Good |
| Example 2-141 | UDL-141 | A | Good | Good | Good |
| Example 2-142 | UDL-142 | A | Good | Good | Good |
| Example 2-143 | UDL-143 | A | Good | Good | Good |
| Example 2-144 | UDL-144 | A | Good | Good | Good |
| Example 2-145 | UDL-145 | A | Good | Good | Good |
| Example 2-146 | UDL-146 | A | Good | Good | Good |
| Example 2-147 | UDL-147 | A | Good | Good | Good |
| Example 2-148 | UDL-148 | A | Good | Good | Good |
| Example 2-149 | UDL-149 | A | Good | Good | Good |
| Example 2-150 | UDL-150 | A | Good | Good | Good |
| Example 2-151 | UDL-151 | A | Good | Good | Good |
| Example 2-152 | UDL-152 | A | Good | Good | Good |
| Example 2-153 | UDL-153 | A | Good | Good | Good |
| Example 2-154 | UDL-154 | A | Good | Good | Good |
| Example 2-155 | UDL-155 | A | Good | Good | Good |
| Comparative Example 2-1 | Comparative UDL-1 | C | Poor | Good | Poor |
| Comparative Example 2-2 | Comparative UDL-2 | C | Poor | Good | Poor |
| Comparative Example 2-3 | Comparative UDL-3 | C | Poor | Good | Poor |
| Comparative Example 2-4 | Comparative UDL-4 | C | Poor | Good | Poor |
| Comparative Example 2-5 | Comparative UDL-5 | C | Poor | Good | Poor |
| Comparative Example 2-6 | Comparative UDL-6 | C | Poor | Good | Poor |
| Comparative Example 2-7 | Comparative UDL-7 | C | Poor | Poor | Poor |
| Comparative Example 2-8 | Comparative UDL-8 | C | Poor | Poor | Poor |
| Comparative Example 2-9 | Comparative UDL-9 | C | Poor | Poor | Poor |
| Comparative Example 2-10 | Comparative UDL-10 | A | Poor | Good | Poor |

As shown in Tables 19 to 23, it was confirmed that the inventive compositions (UDL-1 to -155) for forming an organic film were excellent in solvent resistance, in-plane uniformity, hump suppression property, filling property, and silicon middle layer film-coatability.

### [Patterning Test: Examples 3-1 to 3-155]

A cured organic film was formed respectively on an SiO₂ wafer substrate by using each of the compositions (UDL-1 to -155) for forming an organic film by the above-described method, the silicon-containing resist middle layer film material (SOG1) described below was applied thereto, and baking was performed at 200°C for 60 seconds to form a 35-nm thick silicon-containing resist middle layer film. The monolayer resist for ArF described below was applied thereto as a resist upper layer film material and baked at 105°C for 60 seconds to form a 100-nm thick photoresist film. The liquid immersion top coat composition (TC-1) described below was applied to the photoresist film and baked at 90°C for 60 seconds to form a 50-nm thick top coat.

As the silicon-containing resist middle layer film material (SOG1), a 2% solution of the following polymer in propylene glycol ethyl ether was prepared.

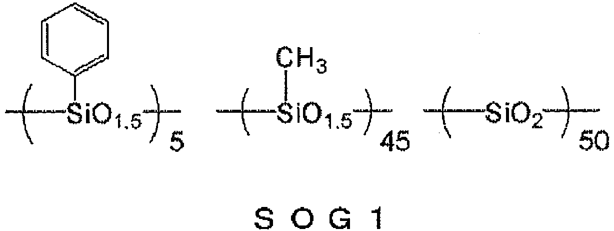

The resist upper layer film material (monolayer resist for ArF) was prepared by dissolving a polymer (RP1), an acid generator (PAG1), and a basic compound (Amine1), each in the proportion shown in Table 24, in a solvent containing 0.1% by mass of FC-430 (manufactured by Sumitomo 3M Limited), and filtering the solution through a 0.1-pm filter made of a fluororesin.

**[Table 24]**

| | Polymer (parts by mass) | Acid generator (parts by mass) | Basic compound (parts by mass) | Solvent (parts by mass) |
|---|---|---|---|---|
| Monolayer resist for ArF | RP1 (100) | PAG1 (6.6) | Amine1 (0.8) | PGMEA (2500) |

The polymer (RP1), the acid generator (PAG1), and the basic compound (Amine1) are shown below.

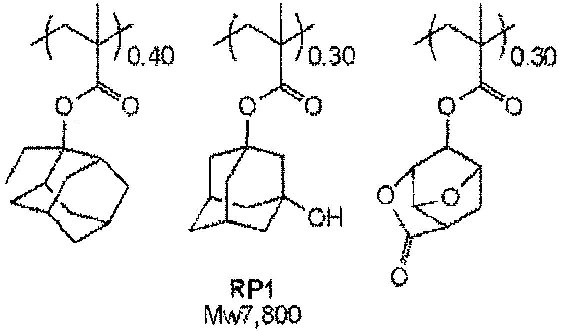

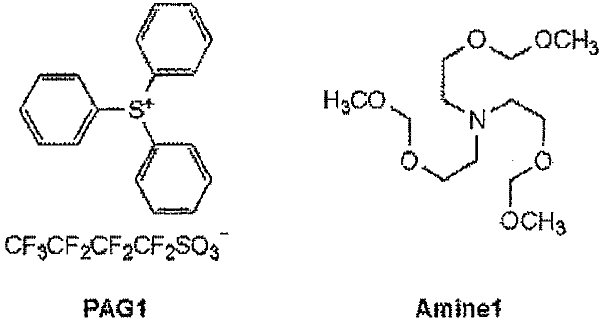

The liquid immersion top coat composition (TC-1) was prepared by dissolving a polymer (PP1) in an organic solvent at the proportion shown in Table 25, and filtering the solution through a 0.1-pm filter made of a fluororesin.

**[Table 25]**

| | Polymer (parts by mass) | Organic solvent (parts by mass) |
|---|---|---|
| TC-1 | PP1 (100) | Diisoamyl ether (2700) |
| | | 2-methyl-1-butanol (270) |

The polymer (PP1) is shown below.

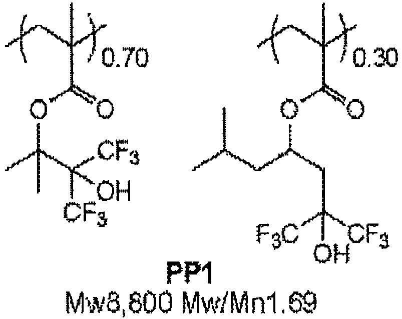

Then, the substrate was exposed to light with an ArF liquid immersion exposure apparatus (NSR-S610C manufactured by Nikon Corporation, NA: 1.30, σ: 0.98/0.65, 35° s-polarized dipole illumination, 6% halftone phase shift mask), baked at 100°C for 60 seconds (PEB), and developed with a 2.38% by mass aqueous solution of tetramethylammonium hydroxide (TMAH) for 30 seconds, thereby obtaining a 55 nm 1:1 positive line-and-space pattern (a resist upper layer film pattern).

Subsequently, the silicon-containing resist middle layer film was dry-etched (the pattern was transferred) by using an etching apparatus Telius manufactured by Tokyo Electron Ltd. while using the resist upper layer film pattern as a mask; the organic film was dry-etched (the pattern was transferred) while using the obtained silicon-containing resist middle layer film pattern as a mask; and the SiO₂ wafer substrate (SiO₂ film) was dry-etched (the pattern was transferred) while using the obtained organic film pattern as a mask. The etching conditions were as follows.

### Conditions in transferring resist upper layer film pattern to silicon-containing resist middle layer film Chamber pressure: 10.0 Pa

RF-power: 1,500 W
CF₄ gas flow rate: 75 mL/min
O₂ gas flow rate: 15 mL/min
Time: 15 sec

### Conditions in transferring silicon-containing resist middle layer film pattern to organic film

Chamber pressure: 2.0 Pa
RF-power: 500 W
Ar gas flow rate: 75 mL/min
Oz gas flow rate: 45 mL/min
Time: 120 sec

### Conditions in transferring organic film pattern to SiO₂ wafer substrate

Chamber pressure: 2.0 Pa
RF-power: 2,200 W
C₅F₁₂ gas flow rate: 20 mL/min
C₂F₆ gas flow rate: 10 mL/min
Ar gas flow rate: 300 mL/min
O₂ gas flow rate: 60 mL/min
Time: 90 sec

The cross section of the obtained pattern was observed with an electron microscope (S-4700) manufactured by Hitachi, Ltd. Tables 26 to 30 show the results.

**[Table 26]**

| | Composition for forming organic film | Profile after etching for transferring to substrate |
|---|---|---|
| Example 3-1 | UDL-1 | Good |
| Example 3-2 | UDL-2 | Good |
| Example 3-3 | UDL-3 | Good |
| Example 3-4 | UDL-4 | Good |
| Example 3-5 | UDL-5 | Good |
| Example 3-6 | UDL-6 | Good |
| Example 3-7 | UDL-7 | Good |
| Example 3-8 | UDL-8 | Good |
| Example 3-9 | UDL-9 | Good |
| Example 3-10 | UDL-10 | Good |
| Example 3-11 | UDL-11 | Good |
| Example 3-12 | UDL-12 | Good |
| Example 3-13 | UDL-13 | Good |
| Example 3-14 | UDL-14 | Good |
| Example 3-15 | UDL-15 | Good |
| Example 3-16 | UDL-16 | Good |
| Example 3-17 | UDL-17 | Good |
| Example 3-18 | UDL-18 | Good |
| Example 3-19 | UDL-19 | Good |
| Example 3-20 | UDL-20 | Good |
| Example 3-21 | UDL-21 | Good |
| Example 3-22 | UDL-22 | Good |
| Example 3-23 | UDL-23 | Good |
| Example 3-24 | UDL-24 | Good |
| Example 3-25 | UDL-25 | Good |
| Example 3-26 | UDL-26 | Good |
| Example 3-27 | UDL-27 | Good |
| Example 3-28 | UDL-28 | Good |
| Example 3-29 | UDL-29 | Good |
| Example 3-30 | UDL-30 | Good |
| Example 3-31 | UDL-31 | Good |
| Example 3-32 | UDL-32 | Good |
| Example 3-33 | UDL-33 | Good |
| Example 3-34 | UDL-34 | Good |
| Example 3-35 | UDL-35 | Good |
| Example 3-36 | UDL-36 | Good |

**[Table 27]**

| | Composition for forming organic film | Profile after etching for transferring to substrate |
|---|---|---|
| Example 3-37 | UDL-37 | Good |
| Example 3-38 | UDL-38 | Good |
| Example 3-39 | UDL-39 | Good |
| Example 3-40 | UDL-40 | Good |
| Example 3-41 | UDL-41 | Good |
| Example 3-42 | UDL-42 | Good |
| Example 3-43 | UDL-43 | Good |
| Example 3-44 | UDL-44 | Good |
| Example 3-45 | UDL-45 | Good |
| Example 3-46 | UDL-46 | Good |
| Example 3-47 | UDL-47 | Good |
| Example 3-48 | UDL-48 | Good |
| Example 3-49 | UDL-49 | Good |
| Example 3-50 | UDL-50 | Good |
| Example 3-51 | UDL-51 | Good |
| Example 3-52 | UDL-52 | Good |
| Example 3-53 | UDL-53 | Good |
| Example 3-54 | UDL-54 | Good |
| Example 3-55 | UDL-55 | Good |
| Example 3-56 | UDL-56 | Good |
| Example 3-57 | UDL-57 | Good |
| Example 3-58 | UDL-58 | Good |
| Example 3-59 | UDL-59 | Good |
| Example 3-60 | UDL-60 | Good |
| Example 3-61 | UDL-61 | Good |
| Example 3-62 | UDL-62 | Good |
| Example 3-63 | UDL-63 | Good |
| Example 3-64 | UDL-64 | Good |
| Example 3-65 | UDL-65 | Good |
| Example 3-66 | UDL-66 | Good |
| Example 3-67 | UDL-67 | Good |
| Example 3-68 | UDL-68 | Good |
| Example 3-69 | UDL-69 | Good |
| Example 3-70 | UDL-70 | Good |
| Example 3-71 | UDL-71 | Good |
| Example 3-72 | UDL-72 | Good |

**[Table 28]**

| | Composition for forming organic film | Profile after etching for transferring to substrate |
|---|---|---|
| Example 3-73 | UDL-73 | Good |
| Example 3-74 | UDL-74 | Good |
| Example 3-75 | UDL-75 | Good |
| Example 3-76 | UDL-76 | Good |
| Example 3-77 | UDL-77 | Good |
| Example 3-78 | UDL-78 | Good |
| Example 3-79 | UDL-79 | Good |
| Example 3-80 | UDL-80 | Good |
| Example 3-81 | UDL-81 | Good |
| Example 3-82 | UDL-82 | Good |
| Example 3-83 | UDL-83 | Good |
| Example 3-84 | UDL-84 | Good |
| Example 3-85 | UDL-85 | Good |
| Example 3-86 | UDL-86 | Good |
| Example 3-87 | UDL-87 | Good |
| Example 3-88 | UDL-88 | Good |
| Example 3-89 | UDL-89 | Good |
| Example 3-90 | UDL-90 | Good |
| Example 3-91 | UDL-91 | Good |
| Example 3-92 | UDL-92 | Good |
| Example 3-93 | UDL-93 | Good |
| Example 3-94 | UDL-94 | Good |
| Example 3-95 | UDL-95 | Good |
| Example 3-96 | UDL-96 | Good |
| Example 3-97 | UDL-97 | Good |
| Example 3-98 | UDL-98 | Good |
| Example 3-99 | UDL-99 | Good |
| Example 3-100 | UDL-100 | Good |
| Example 3-101 | UDL-101 | Good |
| Example 3-102 | UDL-102 | Good |
| Example 3-103 | UDL-103 | Good |
| Example 3-104 | UDL-104 | Good |
| Example 3-105 | UDL-105 | Good |
| Example 3-106 | UDL-106 | Good |
| Example 3-107 | UDL-107 | Good |
| Example 3-108 | UDL-108 | Good |

**[Table 29]**

| | Composition for forming organic film | Profile after etching for transferring to substrate |
|---|---|---|
| Example 3-109 | UDL-109 | Good |
| Example 3-110 | UDL-110 | Good |
| Example 3-111 | UDL-111 | Good |
| Example 3-112 | UDL-112 | Good |
| Example 3-113 | UDL-113 | Good |
| Example 3-114 | UDL-114 | Good |
| Example 3-115 | UDL-115 | Good |
| Example 3-116 | UDL-116 | Good |
| Example 3-117 | UDL-117 | Good |
| Example 3-118 | UDL-118 | Good |
| Example 3-119 | UDL-119 | Good |
| Example 3-120 | UDL-120 | Good |
| Example 3-121 | UDL-121 | Good |
| Example 3-122 | UDL-122 | Good |
| Example 3-123 | UDL-123 | Good |
| Example 3-124 | UDL-124 | Good |
| Example 3-125 | UDL-125 | Good |
| Example 3-126 | UDL-126 | Good |
| Example 3-127 | UDL-127 | Good |
| Example 3-128 | UDL-128 | Good |
| Example 3-129 | UDL-129 | Good |
| Example 3-130 | UDL-130 | Good |
| Example 3-131 | UDL-131 | Good |
| Example 3-132 | UDL-132 | Good |
| Example 3-133 | UDL-133 | Good |
| Example 3-134 | UDL-134 | Good |
| Example 3-135 | UDL-135 | Good |
| Example 3-136 | UDL-136 | Good |
| Example 3-137 | UDL-137 | Good |
| Example 3-138 | UDL-138 | Good |
| Example 3-139 | UDL-139 | Good |
| Example 3-140 | UDL-140 | Good |
| Example 3-141 | UDL-141 | Good |
| Example 3-142 | UDL-142 | Good |
| Example 3-143 | UDL-143 | Good |
| Example 3-144 | UDL-144 | Good |

**[Table 30]**

| | Composition for forming organic film | Profile after etching for transferring to substrate |
|---|---|---|
| Example 3-145 | UDL-145 | Good |
| Example 3-146 | UDL-146 | Good |
| Example 3-147 | UDL-147 | Good |
| Example 3-148 | UDL-148 | Good |
| Example 3-149 | UDL-149 | Good |
| Example 3-150 | UDL-150 | Good |
| Example 3-151 | UDL-151 | Good |
| Example 3-152 | UDL-152 | Good |
| Example 3-153 | UDL-153 | Good |
| Example 3-154 | UDL-154 | Good |
| Example 3-155 | UDL-155 | Good |

As shown in Tables 26 to 30, in Examples 3-1 to 3-155, where the inventive compositions (UDL-1 to -155) for forming an organic film were used, the resist upper layer film pattern was successfully transferred to the SiO₂ wafer substrate in the end in every case. Thus, it was confirmed that the inventive composition for forming an organic film can be used suitably for fine processing using a multilayer resist method.

From the above, the inventive composition for forming an organic film has excellent film-formability, high filling property, high hump suppression property, and excellent silicon middle layer film-coatability, and therefore, is extremely useful as an organic film material used in a multilayer resist process. Furthermore, the inventive patterning processes, using the composition, make it possible to fill holes and trenches having very high aspect ratios without gaps, form a fine pattern with high precision, and form a hump-suppressed organic film, and therefore, make it possible to manufacture semiconductor devices and the like efficiently.

The present description includes the following embodiments.
[1]: A composition for forming an organic film, comprising: (A) a material for forming an organic film; (B) a polymer having a repeating unit represented by the following general formula (1); and (C) a solvent, 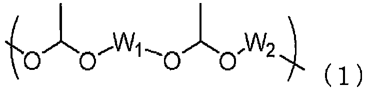 wherein W₁ represents a saturated or unsaturated divalent organic group having 2 to 50 carbon atoms, the divalent organic group containing one or more structures containing fluorine represented by the following formulae (2), and W₂ represents a saturated or unsaturated divalent organic group having 2 to 50 carbon atoms, 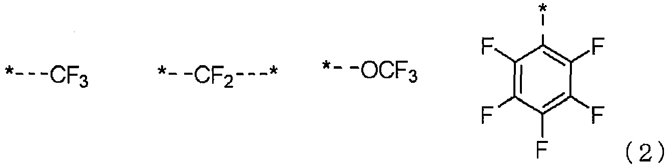 wherein "*" represents an attachment point in the organic group represented by the W₁, and the W₁ optionally contains two or more of the structures represented by the formulae (2) or two or more of one of the structures.
[2]: The composition for forming an organic film of [1], wherein the W₁ in the general formula (1) is a divalent organic group represented by the following general formula (3), 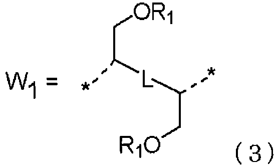 wherein "*" represents an attachment point to the oxygen atom; L represents a saturated or unsaturated divalent organic group having 1 to 30 carbon atoms; and R₁ represents a substituent having one or more of the structures represented by the formulae (2).
[3]: The composition for forming an organic film of [2], wherein the R₁ in the general formula (3) is a group represented by one of the following general formulae (4), 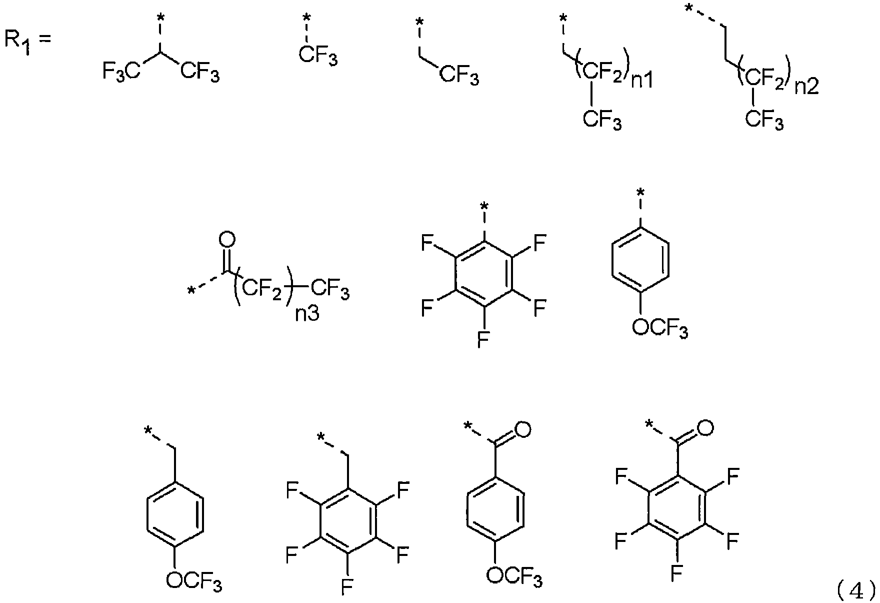 wherein "*" represents an attachment point to the oxygen atom; and "n1", "n2", and "n3" each represent an integer of 1 to 10.
[4]: The composition for forming an organic film of any one of [1] to [3], wherein the W₂ in the general formula (1) is represented by one of the following general formulae (5), 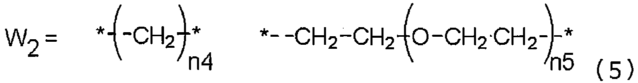 wherein "*" represents an attachment point to the oxygen atom; and "n4" and "n5" each represent an integer of 1 to 10.
[5]: The composition for forming an organic film of any one of [1] to [4], wherein the polymer (B) has a weight-average molecular weight of 1000 to 30000.
[6]: The composition for forming an organic film of any one of [1] to [5], wherein the polymer (B) is contained in an amount of 0.01 parts by mass to 5 parts by mass based on 100 parts by mass of the material (A) for forming an organic film contained.
[7]: A method for forming an organic film to be used in a manufacturing process of a semiconductor device, the method comprising: spin-coating a substrate to be processed with the composition for forming an organic film of any one of [1] to [6] to form a coating film; and forming an organic film by heating the coating film at a temperature of 100°C or higher and 600°C or lower for 10 to 600 seconds to cure the coating film.
[8]: A patterning process comprising:
   forming an organic film on a body to be processed by using the composition for forming an organic film of any one of [1] to [6];
   forming a silicon-containing resist middle layer film on the organic film by using a silicon-containing resist middle layer film material;
   forming a resist upper layer film on the silicon-containing resist middle layer film by using a resist upper layer film material comprising a photoresist composition;
   forming a circuit pattern in the resist upper layer film;
   transferring the pattern to the silicon-containing resist middle layer film by etching while using the resist upper layer film having the formed circuit pattern as a mask;
   transferring the pattern to the organic film by etching while using the silicon-containing resist middle layer film having the transferred pattern as a mask; and
   further transferring the pattern to the body to be processed by etching while using the organic film having the transferred pattern as a mask.
[9]: A patterning process comprising:
   forming an organic film on a body to be processed by using the composition for forming an organic film of any one of [1] to [6];
   forming a silicon-containing resist middle layer film on the organic film by using a silicon-containing resist middle layer film material;
   forming an organic antireflective film or an adhesive film on the silicon-containing resist middle layer film;
   forming a resist upper layer film on the organic antireflective film or the adhesive film by using a resist upper layer film material comprising a photoresist composition;
   forming a circuit pattern in the resist upper layer film;
   transferring the pattern to the organic antireflective film or the adhesive film and the silicon-containing resist middle layer film by etching while using the resist upper layer film having the formed circuit pattern as a mask;
   transferring the pattern to the organic film by etching while using the silicon-containing resist middle layer film having the transferred pattern as a mask; and
   further transferring the pattern to the body to be processed by etching while using the organic film having the transferred pattern as a mask.
[10]: A patterning process comprising:
   forming an organic film on a body to be processed by using the composition for forming an organic film of any one of [1] to [6];
   forming an inorganic hard mask selected from a silicon oxide film, a silicon nitride film, and a silicon oxynitride film on the organic film;
   forming a resist upper layer film on the inorganic hard mask by using a resist upper layer film material comprising a photoresist composition;
   forming a circuit pattern in the resist upper layer film;
   transferring the pattern to the inorganic hard mask by etching while using the resist upper layer film having the formed circuit pattern as a mask;
   transferring the pattern to the organic film by etching while using the inorganic hard mask having the transferred pattern as a mask; and
   further transferring the pattern to the body to be processed by etching while using the organic film having the transferred pattern as a mask.
[11]: A patterning process comprising:
   forming an organic film on a body to be processed by using the composition for forming an organic film of any one of [1] to [6];
   forming an inorganic hard mask selected from a silicon oxide film, a silicon nitride film, and a silicon oxynitride film on the organic film;
   forming an organic antireflective film or an adhesive film on the inorganic hard mask;
   forming a resist upper layer film on the organic antireflective film or the adhesive film by using a resist upper layer film material comprising a photoresist composition;
   forming a circuit pattern in the resist upper layer film;
   transferring the pattern to the organic antireflective film or the adhesive film and the inorganic hard mask by etching while using the resist upper layer film having the formed circuit pattern as a mask;
   transferring the pattern to the organic film by etching while using the inorganic hard mask having the transferred pattern as a mask; and
   further transferring the pattern to the body to be processed by etching while using the organic film having the transferred pattern as a mask.
[12]: The patterning process of [10] or [11], wherein the inorganic hard mask is formed by a CVD method or an ALD method.
[13]: The patterning process of any one of [8] to [12], wherein the circuit pattern is formed by a lithography using light having a wavelength of 10 nm or more and 300 nm or less, a direct writing with electron beam, nanoimprinting, or a combination thereof.
[14]: The patterning process of any one of [8] to [13], wherein the circuit pattern is developed with an alkaline development or an organic solvent.
[15]: The patterning process of any one of [8] to [14], wherein the body to be processed is a semiconductor device substrate or the semiconductor device substrate coated with any of a metal film, a metal carbide film, a metal oxide film, a metal nitride film, a metal oxycarbide film, and a metal oxynitride film.
[16]: The patterning process of [15], wherein the metal constituting the body to be processed is silicon, titanium, tungsten, hafnium, zirconium, chromium, germanium, copper, silver, gold, aluminum, indium, gallium, arsenic, palladium, iron, tantalum, iridium, molybdenum, or an alloy thereof.
[17]: A polymer having a repeating unit represented by the following general formula (1), 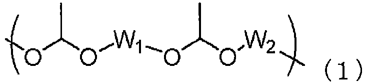 wherein W₁ represents a saturated or unsaturated divalent organic group having 2 to 50 carbon atoms, the divalent organic group containing one or more structures containing fluorine represented by the following formulae (2); and W₂ represents a saturated or unsaturated divalent organic group having 2 to 50 carbon atoms, 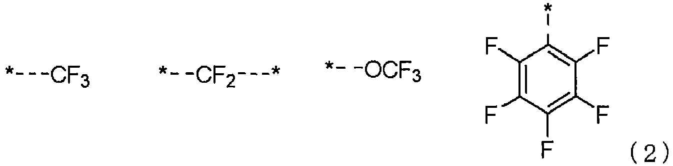 wherein "*" represents an attachment point in the organic group represented by the W₁, and the W₁ optionally contains two or more of the structures represented by the formulae (2) or two or more of one of the structures.
[18]: The polymer of [17], wherein the W₁ in the general formula (1) is a divalent organic group represented by the following formula (3), 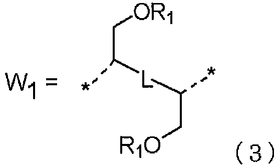 wherein "*" represents an attachment point to the oxygen atom; L represents a saturated or unsaturated divalent organic group having 1 to 30 carbon atoms; and R₁ represents a substituent having one or more of the structures represented by the formulae (2).
[19]: The polymer of [18], wherein the R₁ in the general formula (3) is a group represented by one of the following general formulae (4), 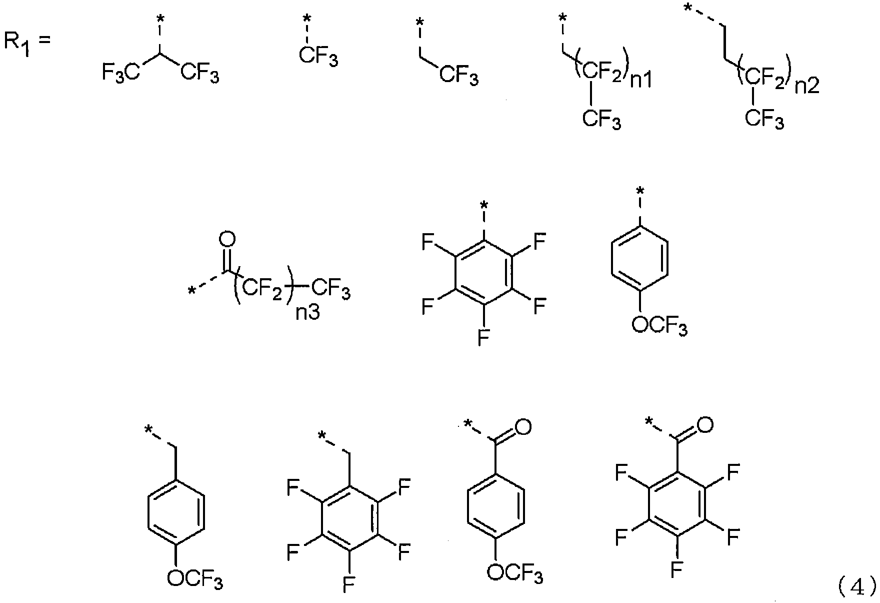 wherein "*" represents an attachment point to the oxygen atom; and "n1", "n2", and "n3" each represent an integer of 1 to 10.
[20]: The polymer of any one of [17] to [19], wherein the W₂ in the general formula (1) is represented by one of the following formulae (5), 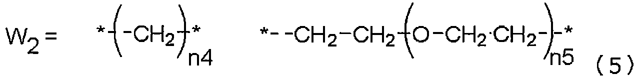 wherein "*" represents an attachment point to the oxygen atom; and "n4" and "n5" each represent an integer of 1 to 10.
[21]: The polymer of any one of [17] to [20], having a weight-average molecular weight of 1000 to 30000.

It should be noted that the present invention is not limited to the above-described embodiments. The embodiments are just examples, and any examples that have substantially the same feature and demonstrate the same functions and effects as those in the technical concept disclosed in claims of the present invention are included in the technical scope of the present invention.

## Claims

1. A composition for forming an organic film, comprising: (A) a material for forming an organic film; (B) a polymer having a repeating unit represented by the following general formula (1); and (C) a solvent, 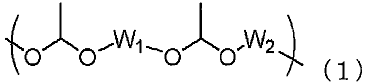
wherein W₁ represents a saturated or unsaturated divalent organic group having 2 to 50 carbon atoms, the divalent organic group containing one or more structures containing fluorine represented by the following formulae (2), and W₂ represents a saturated or unsaturated divalent organic group having 2 to 50 carbon atoms, 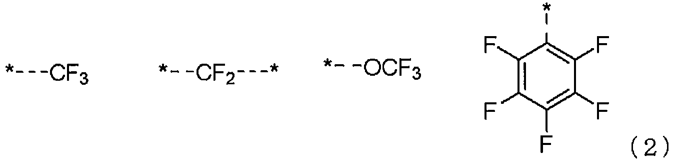
wherein "*" represents an attachment point in the organic group represented by the W₁, and the W₁ optionally contains two or more of the structures represented by the formulae (2) or two or more of one of the structures.

2. The composition for forming an organic film according to claim 1, wherein the W₁ in the general formula (1) is a divalent organic group represented by the following general formula (3), 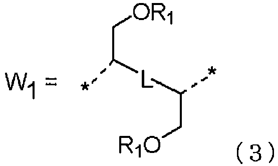 wherein "*" represents an attachment point to the oxygen atom; L represents a saturated or unsaturated divalent organic group having 1 to 30 carbon atoms; and R₁ represents a substituent having one or more of the structures represented by the formulae (2).

3. The composition for forming an organic film according to claim 2, wherein the R₁ in the general formula (3) is a group represented by one of the following general formulae (4), 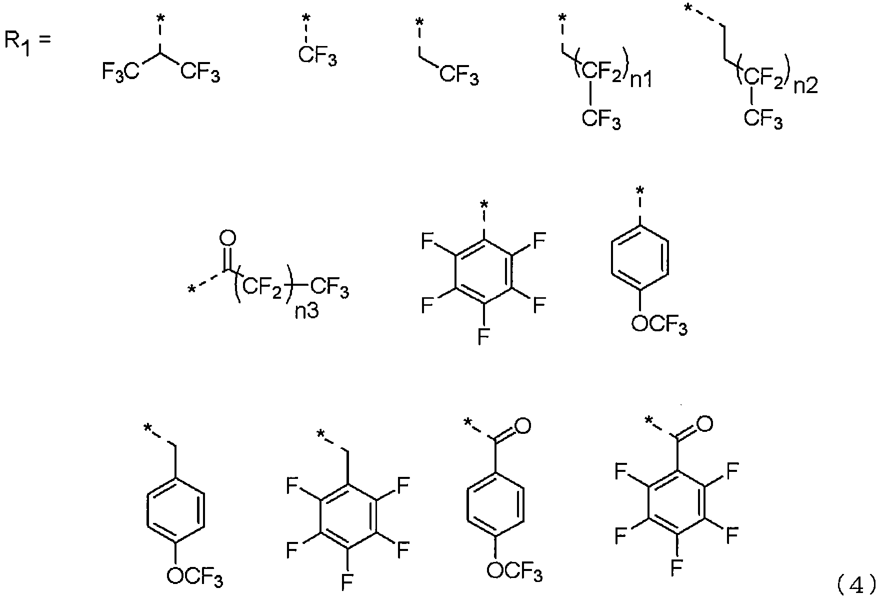 wherein "*" represents an attachment point to the oxygen atom; and "n1", "n2", and "n3" each represent an integer of 1 to 10.

4. The composition for forming an organic film according to any one of claims 1 to 3, wherein the W₂ in the general formula (1) is represented by one of the following general formulae (5), 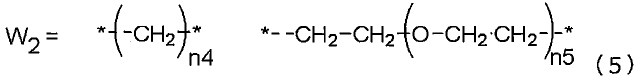 wherein "*" represents an attachment point to the oxygen atom; and "n4" and "n5" each represent an integer of 1 to 10.

5. The composition for forming an organic film according to any one of claims 1 to 4, wherein the polymer (B) has a weight-average molecular weight of 1000 to 30000.

6. The composition for forming an organic film according to any one of claims 1 to 5, wherein the polymer (B) is contained in an amount of 0.01 parts by mass to 5 parts by mass based on 100 parts by mass of the material (A) for forming an organic film contained.

7. A method for forming an organic film to be used in a manufacturing process of a semiconductor device, the method comprising: spin-coating a substrate to be processed with the composition for forming an organic film according to any one of claims 1 to 6 to form a coating film; and forming an organic film by heating the coating film at a temperature of 100°C or higher and 600°C or lower for 10 to 600 seconds to cure the coating film.

8. A patterning process comprising:
8A)
forming an organic film on a body to be processed by using the composition for forming an organic film according to any one of claims 1 to 6;
forming a silicon-containing resist middle layer film on the organic film by using a silicon-containing resist middle layer film material;
forming a resist upper layer film on the silicon-containing resist middle layer film by using a resist upper layer film material comprising a photoresist composition;
forming a circuit pattern in the resist upper layer film;
transferring the pattern to the silicon-containing resist middle layer film by etching while using the resist upper layer film having the formed circuit pattern as a mask;
transferring the pattern to the organic film by etching while using the silicon-containing resist middle layer film having the transferred pattern as a mask; and
further transferring the pattern to the body to be processed by etching while using the organic film having the transferred pattern as a mask; or
8B)
forming an organic film on a body to be processed by using the composition for forming an organic film according to any one of claims 1 to 6;
forming a silicon-containing resist middle layer film on the organic film by using a silicon-containing resist middle layer film material;
forming an organic antireflective film or an adhesive film on the silicon-containing resist middle layer film;
forming a resist upper layer film on the organic antireflective film or the adhesive film by using a resist upper layer film material comprising a photoresist composition;
forming a circuit pattern in the resist upper layer film;
transferring the pattern to the organic antireflective film or the adhesive film and the silicon-containing resist middle layer film by etching while using the resist upper layer film having the formed circuit pattern as a mask;
transferring the pattern to the organic film by etching while using the silicon-containing resist middle layer film having the transferred pattern as a mask; and
further transferring the pattern to the body to be processed by etching while using the organic film having the transferred pattern as a mask; or
8C)
forming an organic film on a body to be processed by using the composition for forming an organic film according to any one of claims 1 to 6;
forming an inorganic hard mask selected from a silicon oxide film, a silicon nitride film, and a silicon oxynitride film on the organic film, optionally the inorganic hard mask being formed by a CVD method or an ALD method;
forming a resist upper layer film on the inorganic hard mask by using a resist upper layer film material comprising a photoresist composition;
forming a circuit pattern in the resist upper layer film;
transferring the pattern to the inorganic hard mask by etching while using the resist upper layer film having the formed circuit pattern as a mask;
transferring the pattern to the organic film by etching while using the inorganic hard mask having the transferred pattern as a mask; and
further transferring the pattern to the body to be processed by etching while using the organic film having the transferred pattern as a mask; or
8D)
forming an organic film on a body to be processed by using the composition for forming an organic film according to any one of claims 1 to 6;
forming an inorganic hard mask selected from a silicon oxide film, a silicon nitride film, and a silicon oxynitride film on the organic film, optionally the inorganic hard mask being formed by a CVD method or an ALD method;
forming an organic antireflective film or an adhesive film on the inorganic hard mask;
forming a resist upper layer film on the organic antireflective film or the adhesive film by using a resist upper layer film material comprising a photoresist composition;
forming a circuit pattern in the resist upper layer film;
transferring the pattern to the organic antireflective film or the adhesive film and the inorganic hard mask by etching while using the resist upper layer film having the formed circuit pattern as a mask;
transferring the pattern to the organic film by etching while using the inorganic hard mask having the transferred pattern as a mask; and
further transferring the pattern to the body to be processed by etching while using the organic film having the transferred pattern as a mask.

9. The patterning process according to claim 8, wherein the circuit pattern is formed by a lithography using light having a wavelength of 10 nm or more and 300 nm or less, a direct writing with electron beam, nanoimprinting, or a combination thereof.

10. The patterning process according to claim 8 or claim 9, wherein the circuit pattern is developed with an alkaline development or an organic solvent.

11. The patterning process according to any one of claims 8 to 10, wherein the body to be processed is a semiconductor device substrate or the semiconductor device substrate coated with any of a metal film, a metal carbide film, a metal oxide film, a metal nitride film, a metal oxycarbide film, and a metal oxynitride film.

12. The patterning process according to claim 11, wherein the metal constituting the body to be processed is silicon, titanium, tungsten, hafnium, zirconium, chromium, germanium, copper, silver, gold, aluminum, indium, gallium, arsenic, palladium, iron, tantalum, iridium, molybdenum, or an alloy thereof.

13. A polymer having a repeating unit represented by the following general formula (1), 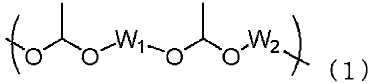
wherein W₁ represents a saturated or unsaturated divalent organic group having 2 to 50 carbon atoms, the divalent organic group containing one or more structures containing fluorine represented by the following formulae (2); and W₂ represents a saturated or unsaturated divalent organic group having 2 to 50 carbon atoms, 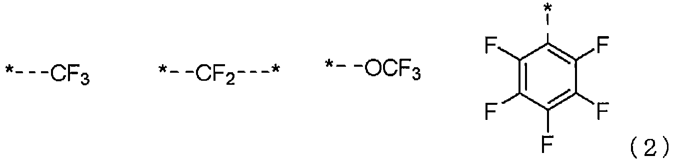
wherein "*" represents an attachment point in the organic group represented by the W₁, and the W₁ optionally contains two or more of the structures represented by the formulae (2) or two or more of one of the structures.

14. The polymer according to claim 13, wherein the W₁ in the general formula (1) is a divalent organic group represented by the following formula (3), 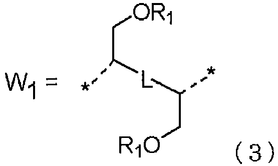
wherein "*" represents an attachment point to the oxygen atom; L represents a saturated or unsaturated divalent organic group having 1 to 30 carbon atoms; and R₁ represents a substituent having one or more of the structures represented by the formulae (2), optionally the R₁ in the general formula (3) being a group represented by one of the following general formulae (4), 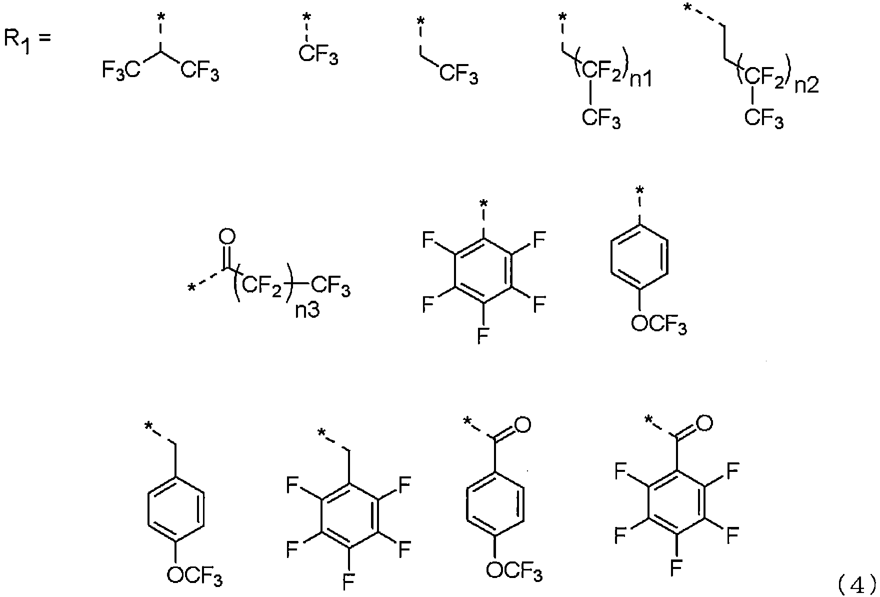
wherein "*" represents an attachment point to the oxygen atom; and "n1", "n2", and "n3" each represent an integer of 1 to 10.

15. The polymer according to claim 13 or claim 14,
15A)
the W₂ in the general formula (1) being represented by one of the following formulae (5), 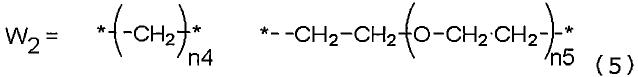
wherein "*" represents an attachment point to the oxygen atom; and "n4" and "n5" each represent an integer of 1 to 10; and/or
15B)
the polymer having a weight-average molecular weight of 1000 to 30000.
